# EUROPEAN PATENT SPECIFICATION

(11) **EP 1 764 650 B1**
(45) Date of publication and mention of the grant of the patent: **27.02.2013**
(21) Application number: 06019677.1
(22) Date of filing: 20.09.2006
(51) Int. Cl.: G03F 7/031, C08F 2/50, B41C 1/10

(54) **Photosensitive composition, and lithographic printing plate precursor and image-recording method using the same**
Fotoempfindliche Zusammensetzung, Flachdruckplatte-Vorläufer und Aufzeichnungsverfahren unter deren Verwendung
Composition photosensible, précurseur de plaque d'impression lithographique et procédé d'enregistrement d'images les utilisant

(30) Priority: 20.09.2005 JP 2005272072
(43) Date of publication of application: 21.03.2007
(73) Proprietor: FUJIFILM Corporation, Minato-ku Tokyo (JP)
(72) Inventor: Taguchi, Yoshinori Fuji Photo Film Co., Ltd., Haibara-gun Shizuoka (JP)
(74) Representative: HOFFMANN EITLE

(56) References cited:
- EP-A- 0 403 100
- EP-A- 1 564 589
- WO-A-2005/071488
- DATABASE WPI Week 200325 Derwent Publications Ltd., London, GB; AN 2003-250988 XP002415830 & JP 2002 287342 A (FUJI PHOTO FILM CO LTD) 3 October 2002 (2002-10-03) & JP 2002 287342 A (FUJI PHOTO FILM CO LTD) 3 October 2002 (2002-10-03)

## Description

### FIELD OF THE INVENTION

The present invention relates to a photosensitive composition capable of utilizing for image-forming materials, for example, three-dimensional photo-modeling, holography, lithographic printing plate precursors, color proofs, photoresists or color filters, and photo-curable resin materials, for example, ink, paint or adhesive. In particular, it relates to a photosensitive composition preferably used in a lithographic printing plate precursor that is capable of being subjected to a so-called direct plate-making, in which the plate-making is directly conducted based on digital signals, for example, from a computer using various kinds of lasers.

### BACKGROUND OF THE INVENTION

Hitherto, a PS plate having a construction such that a oleophilic photosensitive resin layer is provided on a hydrophilic support has been broadly used as a lithographic printing plate precursor. As for the plate-making method thereof, the PS plate is ordinarily subjected to mask exposure (open-frame-exposure) through a lith film and then dissolving and removing the non-image area to obtain a desired printing plate.

In recent years, digitization techniques of electronically processing, accumulating and outputting image information using a computer have been widespread and various new image output systems corresponding thereto have been put into practical use. As a result, a computer-to-plate (CTP) technique of directly producing a printing plate without using a lith film but by scanning highly directional light such as laser light based on the digitized image information is demanded and it is now an important technical subject to obtain a printing plate precursor suitable for such a technique.

As one system for obtaining such a lithographic printing plate precursor capable of conducting scanning exposure, a system of forming an ink-receptive resin layer region on a support having a hydrophilic surface is adopted. In the system, a material comprising a support provided thereon a negative-working photosensitive layer capable of being hardened by scanning exposure to form an ink-receptive region is used, and constructions using a photopolymerizable composition having excellent photosensitive speed have been heretofore proposed and some of the constructions are put into practical use. The lithographic printing plate precursor having such a construction is subjected to development processing in a simple manner and exhibits desirable printing plate performances and printing performances, for example, excellent resolution, ink-receptive property, printing durability and resistance to stain.

The photosensitive composition described above fundamentally comprises a polymerizable compound having an ethylenically unsaturated bond and a photo-initiation system and, if desired, a binder resin, and in the photopolymerizable composition, the photo-initiation system absorbs light by scanning exposure to generate an active species, for example, an active radical to induce and advance a polymerization reaction of the polymerizable compound, as a result, the exposed region is hardened, thereby forming an image.

As for the photosensitive composition capable of conducting the scanning exposure, various photo-initiation systems excellent in photosensitivity are described (see, for example, Bruce M. Monroe et al., Chemical Rev., Vol. 93, pages 435 to 448 (1993), and R. S. Davidson, Journal of Photochemistry and Biology, Vol. 73, pages 81 to 96 (1993)). When such photo-initiation systems are applied to a conventional CTP system using as a light source, a long wavelength visible light source, for example, an Ar laser (488 nm) or FD-YAG laser (532 nm), sufficient sensitivity can not be obtained under the present situation where output of the light source is not adequately large and thus, a photo-initiation system having high sensitivity capable of adapting exposure of higher speed has been desired.

On the other hand, a semiconductor laser capable of performing continuous oscillation in the region of 350 to 450 nm using, for example, an InGaN series material has been recently put into practical use. A scanning exposure system using such a short wavelength light source is advantageous in that an economical system can be constructed while maintaining sufficiently high output since the semiconductor laser can be produced at a low cost in view of its structure. Also, in comparison with a conventional system using an FD-YAG or Ar laser, a photosensitive material having photosensitivity in a short wavelength region which enables operation under brighter safe light can be employed. However, a photo-initiation system having sensitivity sufficient for the scanning exposure in the short wavelength region of 350 to 450 nm has not yet been known.

Further, as described, for example, in J. P. Faussier, Photoinitiated Polymerization-Theory and Applications: Rapra Review, Vol. 9, Report Rapra Technology (1998), and M. Tsunooka et al., Prog. Polym. Sci., Vol. 21, page 1 (1996), the technique for obtaining a photo-initiation system having a high sensitivity is still keenly demanded widely in the imaging field. A photo-initiation system comprising a sensitizing dye and an initiator compound can generate an acid or a base besides the active radical according to appropriate selection of the initiator compound and be also applied to image formation, for example, photo-modeling, holography and color hard copy, to a field of production of an electronic material, for example, photoresist, or to use as a photocurable resin material, for example, ink, paint or adhesive. It is highly desired in these industrial fields to find a sensitizing dye excellent in light-absorbing property and sensitizing ability for the purpose of effectively inducing decomposition of the initiator compound.

A subject common to all of image-forming materials containing these photosensitive materials is that how an ON-OFF of the image can be enlarged in the irradiated area and unirradiated area with laser beam. In other words, the subject is to satisfy both of high sensitivity and preservation stability of the image-forming material. A photo radical polymerization system is ordinarily highly sensitive but its sensitivity severely decreases due to polymerization inhibition caused by oxygen in the atmosphere. Thus, means of providing a layer for blocking oxygen on the image-forming layer is taken. However, the provision of layer for blocking oxygen may contrary cause the formation of fog due to polymerization in the dark or the like, resulting in degradation of the preservation stability. Also, decomposition or disappearance of materials of photo-initiation system in the photosensitive layer under conditions of preservation is one of the factors for the degradation of the preservation stability, because an amount of active radical generated by the light irradiation is decreased. As compositions intending to satisfy both the high sensitivity and the preservation stability, photosensitive compositions containing a highly sensitive sensitizing dye, a hexaarylbiimidazole compound and a mercapto compound are proposed (see, for example, JP-2004-191938 (the term "JP-A" as used herein means an "unexamined published Japanese patent application"), JP-2004-295058 and JP-2002-220409). However, a design intending to high sensitivity causes degradation of the preservation stability and it is still insufficient to satisfy both the high sensitivity and the preservation stability.

EP-A-0 403 100 teaches a photopolymerisable composition comprising a diaryl iodonium salt or a halogenated triazine as a photosensitive initiator, a spectral sensitizer, an ethylenically unsaturated polymerisable monomer and at least one of a mercaptothiadiazole and a mercapto-benzazole. Such compositions are useable in pre-sensitized printing plate systems.

JP-A-2002 287 342 discloses a photopolymerisable composition suitable for the photosensitive layer of a photopolymerisable lithographic printing plate. The composition comprises a hexaaryl biimidazole photoinitiator, a sensitizing dye, a polymerisable compound and a thiol compound having a nitrogen-containing heterocyclic ring.

### SUMMARY OF THE INVENTION

In consideration of the above problems, an object of the present invention is to provide a photosensitive composition which uses a novel photo-initiation system, which is highly sensitive to an oscillation wavelength from 350 to 450 nm of an inexpensive short wavelength semiconductor laser and excellent in preservation stability, workability, profitability and printing durability, and which is useful for a photosensitive layer of a lithographic printing plate precursor for scanning exposure adapting, for example, to the CTP system.

As a result of extensive investigations to achieve the above-described object, the inventors have found that a novel photo-initiation system comprising a mercapto compound having a specific structure, a hexaarylbiimidazole compound and a sensitizing dye provides high sensitivity, Particularly, in a wavelength range approximately from 350 to 450 nm, and is excellent in preservation stability to complete the invention.

Specifically, the present invention includes the following items.
(1) A photosensitive composition comprising (A) a compound having two or more mercapto groups directly connected to a hetero ring represented by the following formula (I):

   L-(A-(SH)_{q})ᵣ (I)

   wherein A represents a heterocyclic group which may have a substituent, r represents an integer of 2 or more, L represents an r-valent connecting group, and q represents an integer of 1 or more, (B) a hexaarylbiimidazole compound, (C) a sensitizing dye, and (D) a polymerizable compound having an ethylenically unsaturated double bond.
(2) A photosensitive composition as described in (1) above, wherein the compound (A) having two or more mercapto groups directly connected to a hetero ring and represented by formula (I) is a compound further represented by the following formula (II) or (II'): 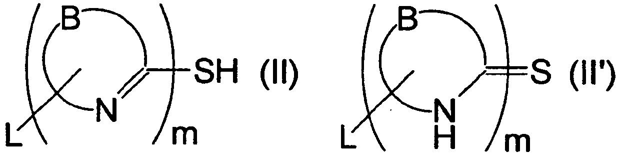 wherein B represents a group necessary for forming a hetero ring together with the nitrogen atom shown in formula (II) or (II'), m represents an integer of 2 or more, and L represents an m-valent connecting group.
(3) An image-recording method comprising conducting scanning exposure to an image-recording material having a photosensitive layer containing the photosensitive composition as described in any one of (1) or (2) above using a laser light source of 350 to 430 nm.
(4) A lithographic printing plate precursor comprising a support and a photosensitive layer containing the photosensitive composition as described in any one of (1) or (2) above.

Although the function according to the invention is not quite clear, it is believed to be as follows.

First, in the exposed area (image-forming area) a sensitizing dye forms the electron excited state in high sensitivity upon irradiation (exposure) of a specific wavelength, and electron transfer, energy transfer or heat generation relating to the electron excited state due to the light absorption acts on a coexistent hexaarylbiimidazole compound to cause chemical change in the hexaarylbiimidazole compound, thereby generating a radical. Then, the radical thus-generated withdraw hydrogen from a hydrogen donor, for example, a mercapto compound and an S radical generated reacts with a polymerizable compound to cause irreversible change, for example, color formation, decoloration or polymerization. When an addition polymerizable compound having an ethylenically unsaturated double bond that is preferable among these compounds is used, a hardening reaction initiates and proceeds to harden the exposed region. It is believed that the use of the compound having two or more mercapto groups in the molecule thereof according to the invention makes it possible to form three-dimensional crosslinkage with a monomer (in a preferable case, also together with an ethylenic double bond in the side chain of a binder) and can form state of hardened layer in a small exposure amount (specifically, even in a smaller reaction rate than a mono-functional mercapto compound) in comparison with the mono-functional mercapto compound, thereby achieving high sensitivity. It is also believed that decrease in penetration of a developer in the hardened layer due to the formation of three-dimensional crosslinkage by the use of the compound having two or more mercapto groups in the molecule thereof and increase in polarity due to the presence of two or more mercapto groups in comparison with the mono-functional mercapto compound may also be a factor contributing to the high sensitivity. Further, since the hardened layer is hardened more densely and penetration of dampening water decreases, increase in the printing durability is also attained.

Moreover, with respect to the factor for achieving both the high sensitivity and the preservation stability, since a compound having a mercapto group directly connected to a hetero ring has high stability in comparison with a compound having a mercapto group directly connected to a benzene ring or an alkyl group, it is believed that both the high sensitivity and the preservation stability are achieved even in the case of having two or more mercapto groups.
According to the present invention, a photosensitive composition which is highly sensitive to an oscillation wavelength from 350 to 450 nm of an inexpensive short wavelength semiconductor laser and excellent in preservation stability, workability, profitability and printing durability, and which is useful for a photosensitive layer of a lithographic printing plate precursor for scanning exposure adapting, for example, to the CTP system and an image-recording method using the photosensitive composition are provided.

### DETAILED DESCRIPTION OF THE INVENTION

The present invention will be described in more detail below.
The photosensitive composition according to the invention is characterizing by comprising (A) a compound having two or more mercapto groups directly connected to a hetero ring, (B) a hexaarylbiimidazole compound, (C) a sensitizing dye, and (D) a polymerizable compound having an ethylenically unsaturated double bond. Each of the compounds for use in the photosensitive composition according to the invention will be described below in order.
(A) Compound having two or more mercapto groups directly connected to a hetero ring represented by formula (I) as set out in present claim 1.

The compound (A) having two or more mercapto groups directly connected to a hetero ring (hereinafter also referred to as a mercapto compound (A)) is a compound which has two or more mercapto groups in its molecule and in which the mercapto groups are directly connected to a hetero ring which may have a substituent. A number of the mercapto group directly connected to a hetero ring contained in the mercapto compound (A) is 2 or more, preferably from 2 to 6.

A number of the hetero ring contained in the mercapto compound (A) is 2 or more, preferably from 2 to 6.

The term "hetero ring" as used herein means a ring having 5 or more members containing at least one of N, S and O, which may have a substituent and which may include a condensed ring.

The mercapto compound (A) is a compound having a structure represented by formula (I) shown below from the standpoint of sensitivity.

L-(A-(SH)_{q})ᵣ (I)

In formula (I), A represents a heterocyclic group which may have a substituent, r represents an integer of 2 or more, L represents an r-valent connecting group, and q represents an integer of 1 or more.

The heterocyclic group represented by A include, as described above, a heterocyclic group having 5 or more members containing at least one of N, S and O, preferably a 5-membered or 6-membered heterocyclic group. The heterocyclic group may include a condensed ring.

The r-valent connecting group represented by L is not particularly restricted and includes a group formed by appropriately eliminating r hydrogen, atoms from a hydrocarbon, for example, an alkane (which may include an ester group, a urethane group or the like in the chain) or an aromatic ring (e.g., a benzene ring or a naphthalene ring).

r preferably represents an integer of 2 to 6, more preferably an integer of 3 to 6.

The r-valent connecting group represented by L may have an appropriate substituent in addition to connecting to r heterocyclic groups represented by A.

Preferred examples of the hetero ring include thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine and furazane. These rings may be benzo-fused or may have a monovalent substituent.

Examples of the monovalent substituent include a halogen atom, an amino group, a substituted amino group, a substituted carbonyl group, a hydroxy group, a substituted oxy group, a silyl group, a nitro group, a cyano group, an alkyl group, an alkenyl group, an alkynyl group, an aryl group, a heterocyclic group, a sulfo group, a substituted sulfonyl group, a sulfonato group, a substituted sulfinyl group, a phosphono group, a substituted phosphono group, a phosphonato group and a substituted phosphonato group. These monovalent substituents may further have a substituent, if it is possible to introduce further substituent.

The alkyl group includes a straight-chain, branched or cyclic alkyl group having from 1 to 20 carbon atoms. Of the alkyl groups, a straight-chain alkyl group having from 1 to 20 carbon atoms, a branched alkyl group having from 3 to 20 carbon atoms and a cyclic alkyl group having from 5 to 20 carbon atoms are preferred. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbomyl group and an adamantyl group.

When the alkyl group has a substituent (that is, in case of a substituted alkyl group), an alkyl moiety in the substituted alkyl group includes a divalent organic residue obtained by eliminating any one of hydrogen atoms on the alkyl group having from 1 to 20 carbon atoms described above. Also, the range of preferable number of carbon atoms is same as that of the alkyl group described above.

Specific preferred examples of the substituted alkyl group include a chloromethyl group, a bromomethyl group, a 2-chloroethyl group, a trifluoromethyl group, a methoxymethyl group, a methoxycarbonylmethyl group, an isopropoxymethyl group, a butoxymethyl group, a sec-butoxybutyl group, a methoxyethoxyethyl group, an allyloxymethyl group, a phenoxymethyl group, an acetyloxymethyl group, a methyltiomethyl group, a tolylthiomethyl group, a pyridylmethyl group, a tetramethylpyridinylmethyl group, an N-acetyltetramethylpyridinylmethyl group, a trimethylsilylmethyl group, a methoxyethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl, a phosphonoxypropyl group, a phosphonatoxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group. Among them, a phenethyl group, a 1-methyl-1-phenylethyl group, a p-methylbenzyl group and a cinnamyl group are particularly preferable.

Examples of the substituent capable of being introduced into the alkyl group include a monovalent substituent constituted from a non-metallic atom illustrated below in addition to the substituents described in the substituted alkyl group. Preferred examples of the substituent for the alkyl group including the substituents described above include a halogen atom (e.g., -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acyloxy group, an acylthio group, an acylamino group, an N-alkylacylamino group, an N-arylacylamino group, a ureido group, an N'-alkylureido group, an N',N'-dialkylureido group, N'-arylureido group, an N',N'-diarylureido group, an N'-alkyl-N'-arylureido group, an N-alkylureido group, N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxy group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and a conjugate base group thereof (hereinafter, referred to as a sulfonato group), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and a conjugate base group thereof (hereinafter, referred to as a phosphonato group), a dialkylphosphono group (-PO₃(alkyl)₂) wherein "alkyl" means an alkyl group, hereinafter the same, a diarylphosphono group (-PO₃(aryl)₂) wherein "aryl" means an aryl group, hereinafter the same, an alkylarylphosphono group (-PO₃(alkyl)(aryl)), a monoalkylphosphono group (-PO₃H(alkyl)) and a conjugate base group thereof (hereinafter, referred to as an alkylphosphonato group), a monoarylphosphono group (-PO₃H(aryl)) and a conjugate base group thereof (hereinafter, referred to as an arylphosphonato group), a phosphonoxy group (-OPO₃H₂) and a conjugate base group thereof (hereinafter, referred to as a phosphonatoxy group), a dialkylphosphonoxy group (-OPO₃(alkyl)₂), a diarylphosphonoxy group (-OPO₃(aryl)₂), an alkylarylphosphonoxy group (-OPO₃(alkyl)(aryl)), a monoalkylphosphonoxy group (-OPO₃H(alkyl)) and a conjugate base group thereof (hereinafter, referred to as an alkylphosphonatoxy group), a monoarylphosphonoxy group (-OPO₃H(aryl)) and a conjugate base group thereof (hereinafter, referred to as an arylphosphonatoxy group), a cyano group, a nitro group, an aryl group, an alkenyl group, an alkynyl group, a heterocyclic group and a silyl group.

Specific examples of the alkyl moiety in the substituent capable of being introduced into the alkyl group are same as those described in the case where the monovalent substituent represents the substituted alkyl group. Also, the range of preferable number of carbon atoms is same as that of the alkyl group described above.

Specific examples of the aryl moiety in the substituent capable of being introduced into the alkyl group represented as the monovalent substituent include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxypnenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a cyanophenyl group, a sulfophenyl group, a sufonatophenyl group, a phosphonophenyl group and a phosphonatophenyl group.

The alkenyl group includes an alkenyl group having from 2 to 20 carbon atoms. Of the alkenyl groups, an alkenyl group having from 2 to 10 carbon atoms is preferable, and alkenyl group having from 2 to 8 carbon atoms is more referable. The alkenyl group may have a substituent. Examples of the substituent capable of being introduced include a halogen atom, an alkyl group, a substituted alkyl group, an aryl group and a substituted aryl group, and preferably a halogen atom and a straight-chain, branched or cyclic alkyl group having from 1 to 10 carbon atoms. Specific examples of the alkenyl group include a vinyl group, a 1-propenyl group, a 1-butenyl group, a cinnamyl group, a 1-pentenyl group, a 1-hexenyl group, a 1-octenyl group, a 1-methyl-1-propenyl group, a 2-methyl-1-propenyl group, 2-methyl-1-butenyl group, a 2-phenyl-1-ehtenyl group and a 2-chloro-1-ethenyl group.

The alkynyl group includes an alkynyl group having from 2 to 20 carbon atoms. Of the alkynyl groups, an alkynyl group having from 2 to 10 carbon atoms is preferable, and alkynyl group having from 2 to 8 carbon atoms is more referable. Specific examples of the alkynyl group include an ethynyl group, a 1-propynyl group, a 1-butynyl group, a phenylethynyl group and a trimethylsilylethynyl group.

The aryl group includes a benzene ring, a condensed ring of two to three benzene rings and a condensed ring of a benzene ring and a 5-membered unsaturated ring. Specific examples of the aryl group include a phenyl group, a naphthyl group, an anthryl group, a phenanthryl group, an indenyl group, an acenaphthenyl group and a fluorenyl group. Among them, a phenyl group and a naphthyl group are preferable.

When the aryl group has a substituent (that is, in case of a substituted aryl group), the substituted aryl group includes aryl groups having a monovalent substituent constituting from non-metallic atom, as a substituent, on the ring-forming carbon atom. Preferable examples of the substituent capable of being introduced include the above-described alkyl and substituted alkyl group and the substituents for the substituted alkyl group.

Specific preferred examples of the substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propynylphenyl group, a 2-butynylphenyl group and a 3-butynylphenyl group. Among them, a biphenyl group, a tolyl group, a xylyl group, a mesityl group and a chlorophenyl group are preferable.

As the heterocyclic group, a 3-membered to 8-membered heterocyclic group is preferable, a 3-membered to 6-membered heterocyclic group containing a nitrogen atom, an oxygen atom or a sulfur atom is more preferable, and a 5-membered to 6-membered heterocyclic group containing a nitrogen atom, an oxygen atom or a sulfur atom is still more preferable. Specific examples of the heterocyclic group include a pyridyl group and a piperizinyl group.

The silyl group may have a substituent, and a silyl group having from 0 to 30 carbon atoms is preferable, a silyl group having from 3 to 20 carbon atoms is more preferable, and a silyl group having from 3 to 10 carbon atoms is still more preferable. Specific examples of the silyl group include a trimethylsilyl group, a triethylsilyl group, a tripropylsilyl group, a triisopropylsilyl group, cyclohexyldimethylsilyl group and a dimethylvinylsilyl group.

The halogen atom includes a fluorine atom, a bromine atom, a chlorine atom and an iodine atom. Among them, a chlorine atom and a bromine atom are preferable.

As the substituted oxy group (R⁰⁶O-), a substituted oxy group wherein R⁰⁶ represents a monovalent non-metallic atomic group exclusive of a hydrogen atom can be used. Preferred examples of the substituted oxy group include an alkoxy group, an aryloxy group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, a phosphonoxy group and a phosphonatoxy group. The alkyl group and aryl group in the above-described substituted oxy group include those described for the alkyl group, substituted alkyl group, aryl group and substituted aryl group above. As an acyl group (R⁰⁷CO-) in the acyloxy group, an acyl group wherein R⁰⁷ represents the alkyl group, substituted alkyl group, aryl group or substituted aryl group described above is exemplified. Of the substituted oxy groups, an alkoxy group, an aryloxy group, an acyloxy group and an arylsulfoxy group are more preferable. Specific preferred examples of the substituted oxy group include a methoxy group, an ethoxy group, a propyloxy group, an isopropyloxy group, a butyloxy group, a pentyloxy group, a hexyloxy group, a dodecyloxy group, a benzyloxy group, an allyloxy group, a phenethyloxy group, a carboxyethyloxy group, a methoxycarbonylethyloxy group, an ethoxycarbonylethyloxy group, a methoxyethoxy group, a phenoxyethoxy group, a methoxyethoxyethoxy group, an ethoxyethoxyethoxy group, a morpholinoethoxy group, a morpholinopropyloxy group, an allyloxyethoxyethoxy group, a phenoxy group, a tolyloxy group, a xylyloxy group, a mesityloxy group, a cumenyloxy group, a methoxyphenyloxy group, an ethoxyphenyloxy group, a chlorophenyloxy group, a bromophenyloxy group, an acetyloxy group, a benzoyloxy group, a naphthyloxy group, a phenylsulfonyloxy group, a phosphonoxy group and a phosphonatoxy group.

The amino group may be a substituted amino group including an amido group. As the substituted amino group including an amido group (R⁰⁸NH- or (R⁰⁹)(R⁰¹⁰)N-), a substituted amino group wherein R⁰⁸, R⁰⁹ and R⁰¹⁰ each represents a monovalent non-metallic atomic group exclusive of a hydrogen atom can be used. R⁰⁹ and R⁰¹⁰ may be connected with each other to form a ring. Preferred examples of the substituted amino group include an N-alkylamino group, an N,N-dialkylamino group, an N-arylamino group, an N,N-diarylamino group, an N-alkyl-N-arylamino group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N'-alkyl-N'-arylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N- alkoxycarbonylamino group and an N-aryl-N-aryloxycarbonylamino group. The alkyl group and aryl group in the above-described substituted amino group include those described for the alkyl group, substituted alkyl group, aryl group and substituted aryl group above. In the acyl group (R⁰⁷CO-) of the acylamino group, N-alkylacylamino group or N-arylacylamino group described above, R⁰⁷ has the same meaning as described above. Of the substituted amino groups, an N-alkylamino group, an N,N-dialkylamino group, an N-arylamino group and an acylamino group are more preferable. Specific preferred examples of the substituted amino group include a methylamino group, an ethylamino group, a diethylamino group, a morpholino group, a piperidino group, a pyrrolidino group, a phenylamino group, a benzoylamino group and an acetylamino group.

As the substituted sulfonyl group (R⁰¹¹-SO₂-), a substituted sulfonyl group wherein R⁰¹¹ represents a monovalent non-metallic atomic group can be used. Preferred examples of the substituted sulfonyl group include an alkylsulfonyl group, an arylsulfonyl group and a substituted or unsubstituted sulfamoyl group. The alkyl group and aryl group in the above-described substituted sulfonyl group include those described for the alkyl group, substituted alkyl group, aryl group and substituted aryl group above. Specific examples of the substituted sulfonyl group include a butylsulfonyl group, a phenylsulfonyl group, a chlorophenylsulfonyl group, a sulfamoyl group, an N-alkylsulfamoyl group, an N,N-dialkylsulfamoyl group, an N-arylsulfamoyl group and an N-alkyl-N-arylsulfamoyl group.

The sulfonato group (-SO₃⁻) means a conjugate base anionic group of a sulfo group (-SO₃H) as described above. Ordinarily, it is preferred to use together with a counter cation. Examples of the counter cation include those conventionally known, for example, various oniums (e.g., an ammonium, a sulfonium, a phosphonium, an iodonium or an azinium) and metal ions (e.g., Na⁺, K⁺, Ca²⁺ or Zn²⁺).

As the substituted carbonyl group (R⁰¹³-CO-), a substituted carbonyl group wherein R⁰¹³ represents a hydrogen atom or a monovalent non-metallic atomic group can be used. Preferred examples of the substituted carbonyl group include a formyl group, an acyl group, a carboxy group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group and an N-alkyl-N-arylcarbamoyl group. The alkyl group and aryl group in the above-described substituted carbonyl group include those described for the alkyl group, substituted alkyl group, aryl group and substituted aryl group above. Of the substituted carbonyl groups, a formyl group, an acyl group, a carboxy group, an alkoxycarbonyl group, an aryloxycarbonyl group, a carbamoyl group, an N-alkylcarbamoyl group, an N,N-dialkylcarbamoyl group and an N-arylcarbamoyl group are more preferable, and a formyl group, an acyl group, an alkoxycarbonyl group and an aryloxycarbonyl group are still more preferable. Specific preferred examples of the substituted carbonyl group include a formyl group, an acetyl group, a benzoyl group, a carboxy group, a methoxycarbonyl group, an ethoxycarbonyl group, an allyloxycarbonyl group, a dimethylaminophenylethenylcarbonyl group, a methoxycarbonylmethoxycarbonyl group, an N-methylcarbamoyl group, an N-phenylcarbamoyl group, an N,N-diethylcarbamoyl group and a morpholinocarbonyl group.

As the substituted sulfinyl group (R⁰¹⁴-SO-), a substituted sulfinyl group wherein R⁰¹⁴ represents a monovalent non-metallic atomic group. Preferred examples of the substituted sulfinyl group include an alkylsulfinyl group, an arylsulfinyl group, a sulfinamoyl group, an N-alkylsulfinamoyl group, an N,N-dialkylsulfinamoyl group, an N-arylsulfinamoyl group, an N,N-diarylsulfinamoyl group and an N-alkyl-N-arylsulfinamoyl group. The alkyl group and aryl group in the above-described substituted sulfinyl group include those described for the alkyl group, substituted alkyl group, aryl group and substituted aryl group above. Of the substituted sulfinyl groups, an alkylsulfinyl group and an arylsulfinyl group are more preferred. Specific examples of the substituted sulfinyl group include a hexylsulfinyl group, a benzylsulfinyl group and a tolylsulfinyl group.

The substituted phosphono group means a group formed by substituting one or two hydroxy groups of a phosphono group with one or two other organic oxy groups. Preferred examples of the substituted phosphono group include a dialkylphosphono group, a diarylphosphono group, an alkylarylphosphono group, a monoalkylphosphono group and a monoarylphosphono group as described above. Of the substituted phosphono groups, a dialkylphosphono group and a diarylphosphono group are more preferred. Specific examples of the substituted phosphono group include a diethylphosphono group, a dibutylphosphono group and a diphenylphosphono group.

The phosphonato group (-PO₃²⁻ or -PO₃H⁻) means a conjugate base anionic group of a phosphono group (-PO₃H₂) resulting from primary acid dissociation or secondary acid dissociation. Ordinarily, it is preferred to use together with a counter cation. Examples of the counter cation include those conventionally known, for example, various oniums (e.g., an ammonium, a sulfonium, a phosphonium, an iodonium or an azinium) and metal ions (e.g., Na⁺, K⁺, Ca²⁺ or Zn²⁺).

The substituted phosphonato group means a conjugate base anionic group of a group formed by substituting one hydroxy group with another organic oxy group among the substituted phosphono groups described above. Specific examples of the substituted phosphonato group include a conjugate base group of a monoalkylphosphono group (-PO₃H(alkyl)) and a conjugate base group of a monoarylphosphono group (-PO₃H(aryl)).

In view of the sensitivity and preservation stability, the mercapto compound (A) is more preferably a compound having a structure represented by at least any one of formulae (II) and (II') shown below.

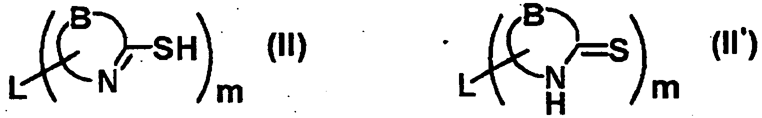

In formulae (II) and (II'), B represents a group necessary for forming a hetero ring together with the nitrogen atom shown in formula (II) or (II'). The hetero ring may be a single ring or a multiple ring (a condensed ring) and maybe an alicyclic ring or an aromatic ring.

m represents an integer of 2 or more, and L represents an m-valent connecting group.

The compound represented by formula (II) has a tautomeric relationship with the compound represented by formula (II').

According to a more preferable embodiment, the ring formed by B in formula (II) or (II') is a triazole ring, an oxadiazole ring, a thiadiazole ring, a benzimidazole ring, a benzoxazole ring, a benzthiazole ring or a tetrazole ring.

A preferable embodiment of L includes those described above.

Specific examples (A-14) to (A-84) of the mercapto compound (A) as set out in the present claims, are set forth below, but the invention should not be construed as being limited thereto.

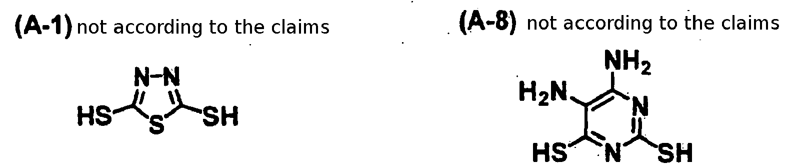

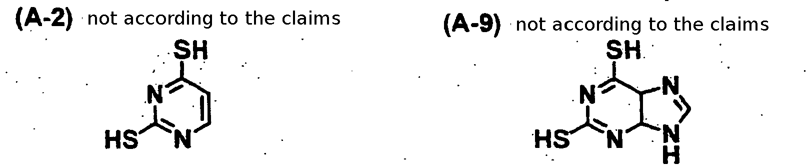

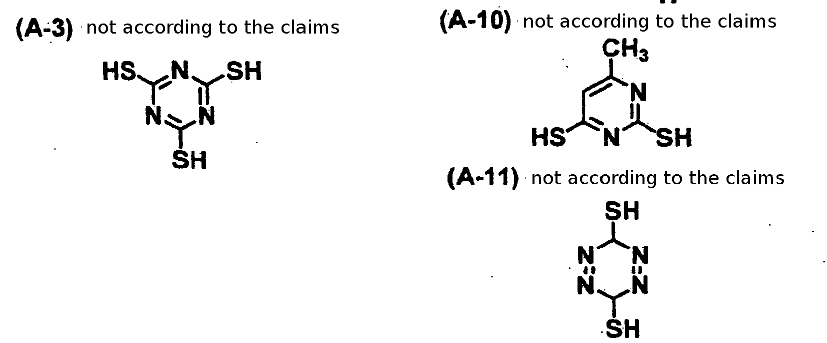

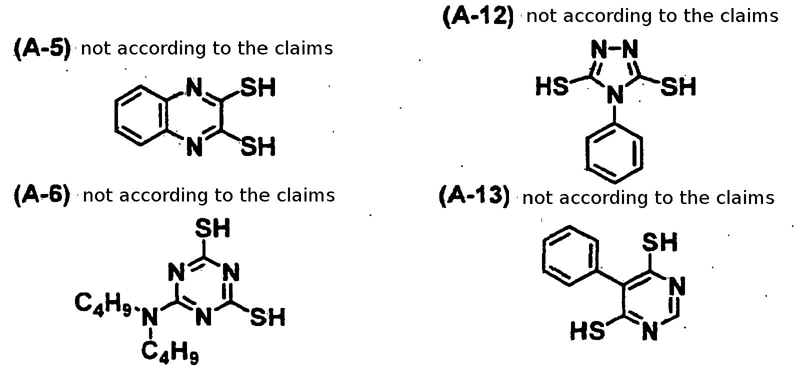

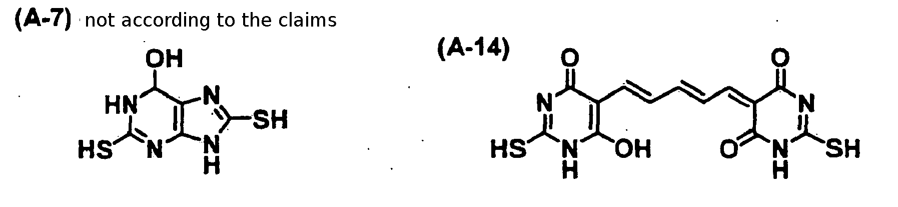

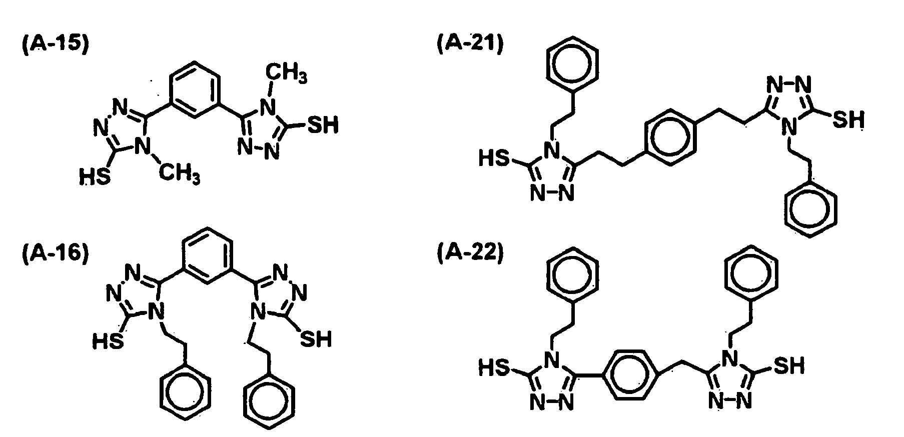

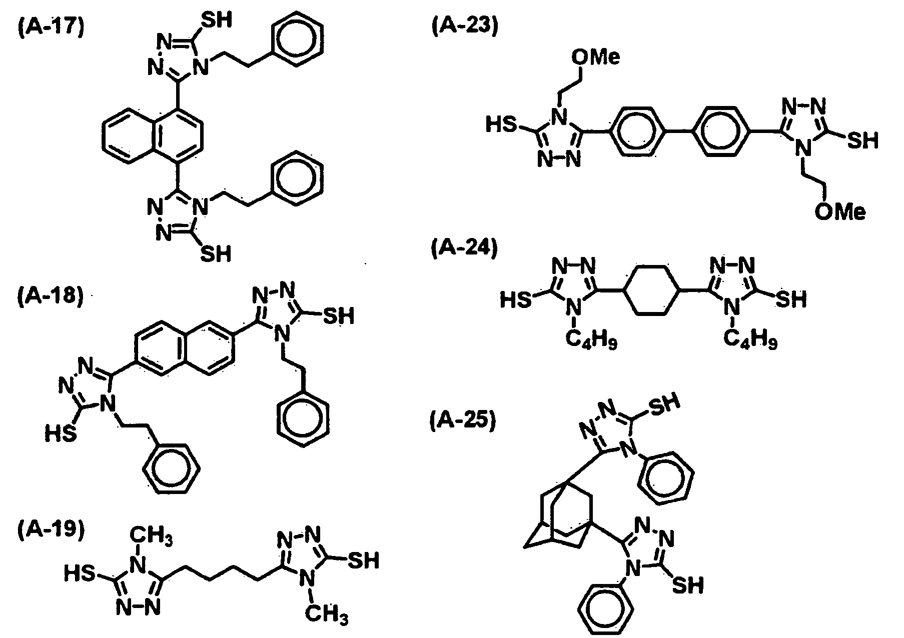

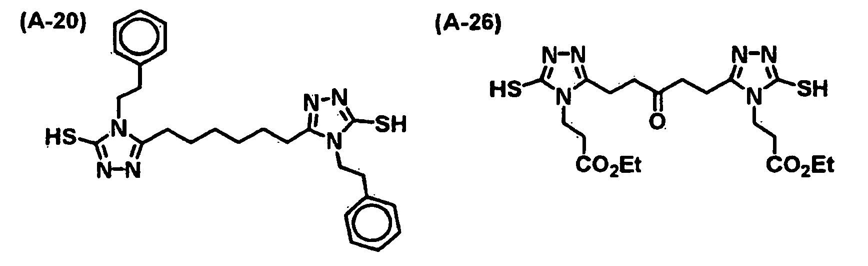

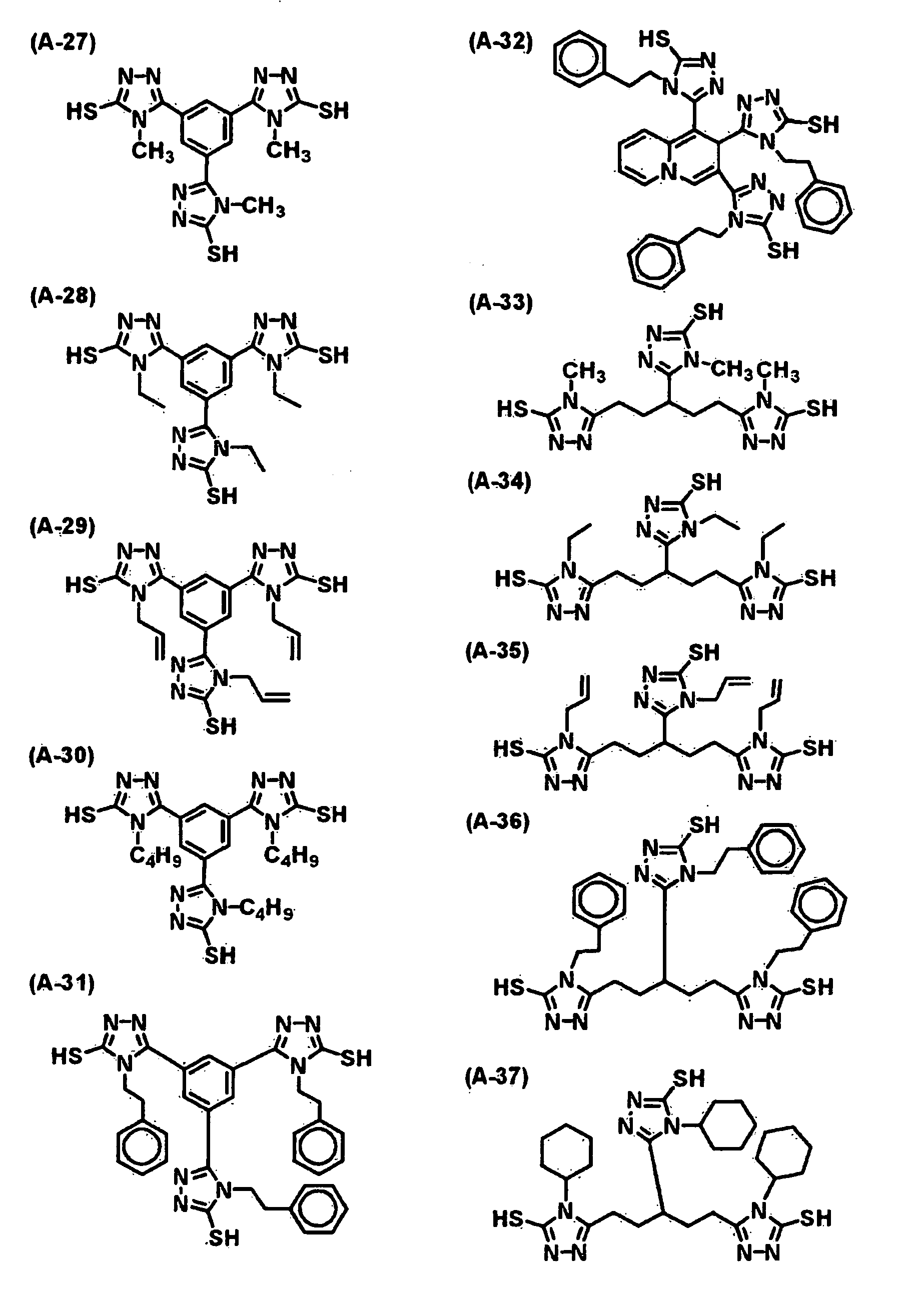

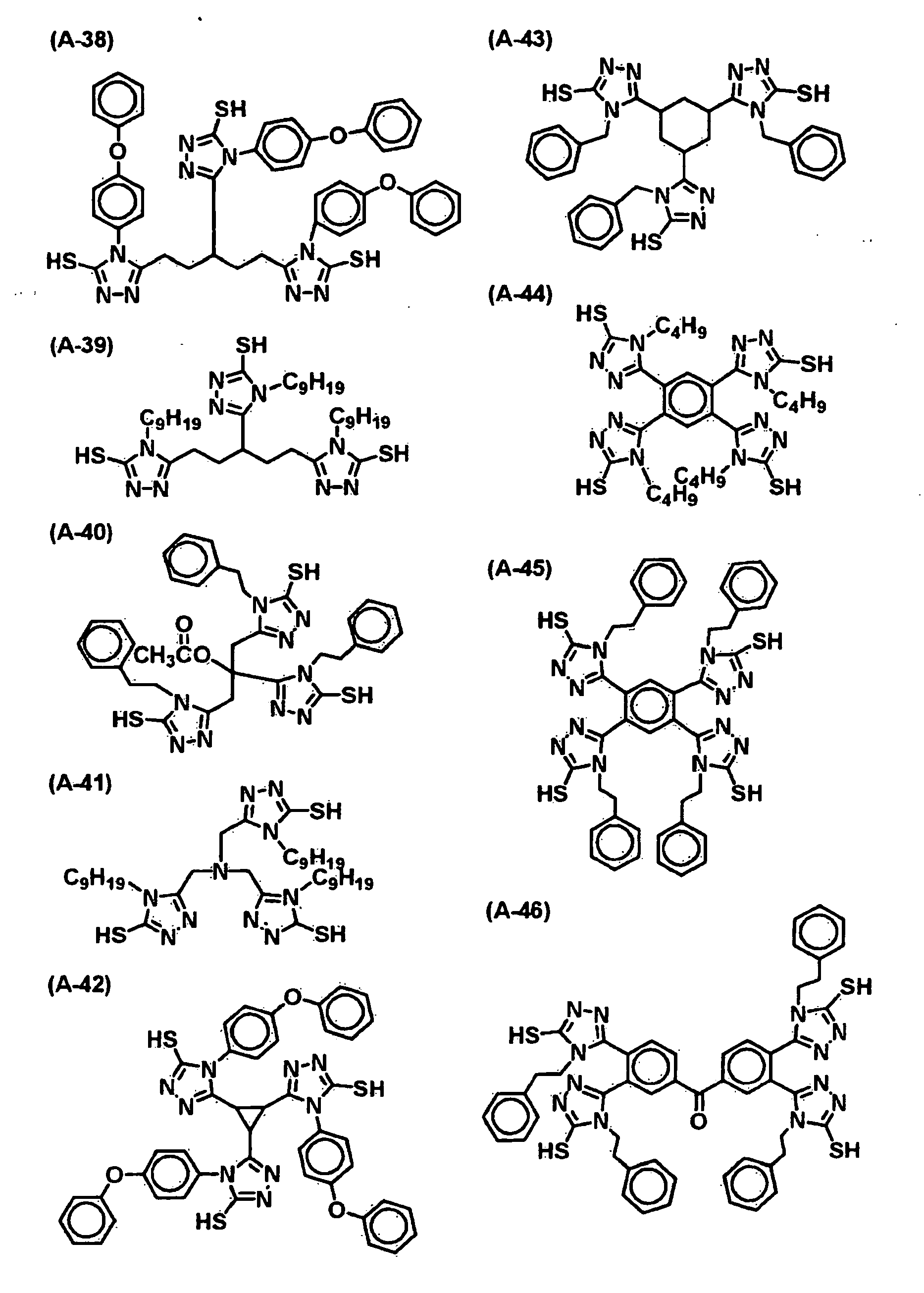

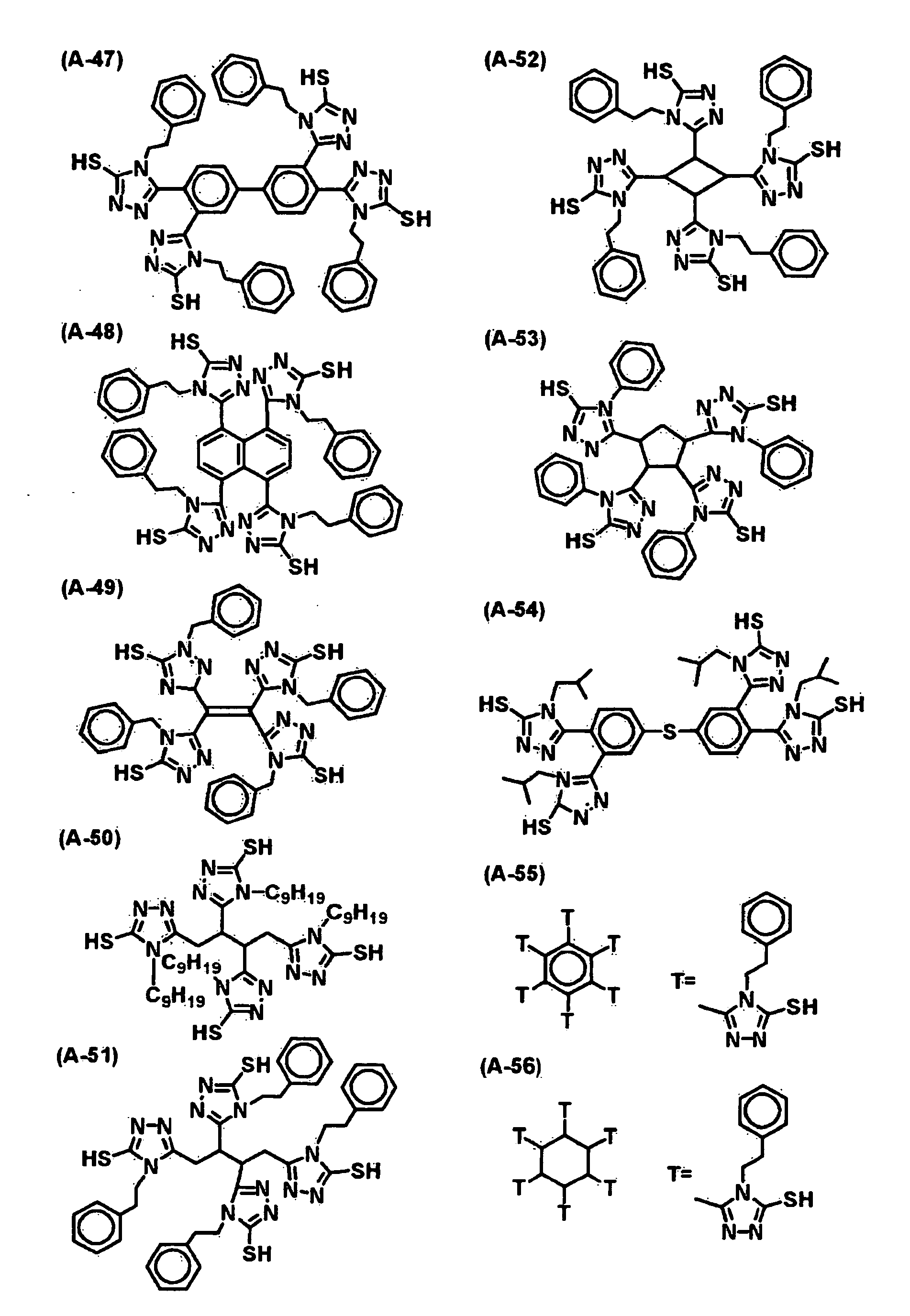

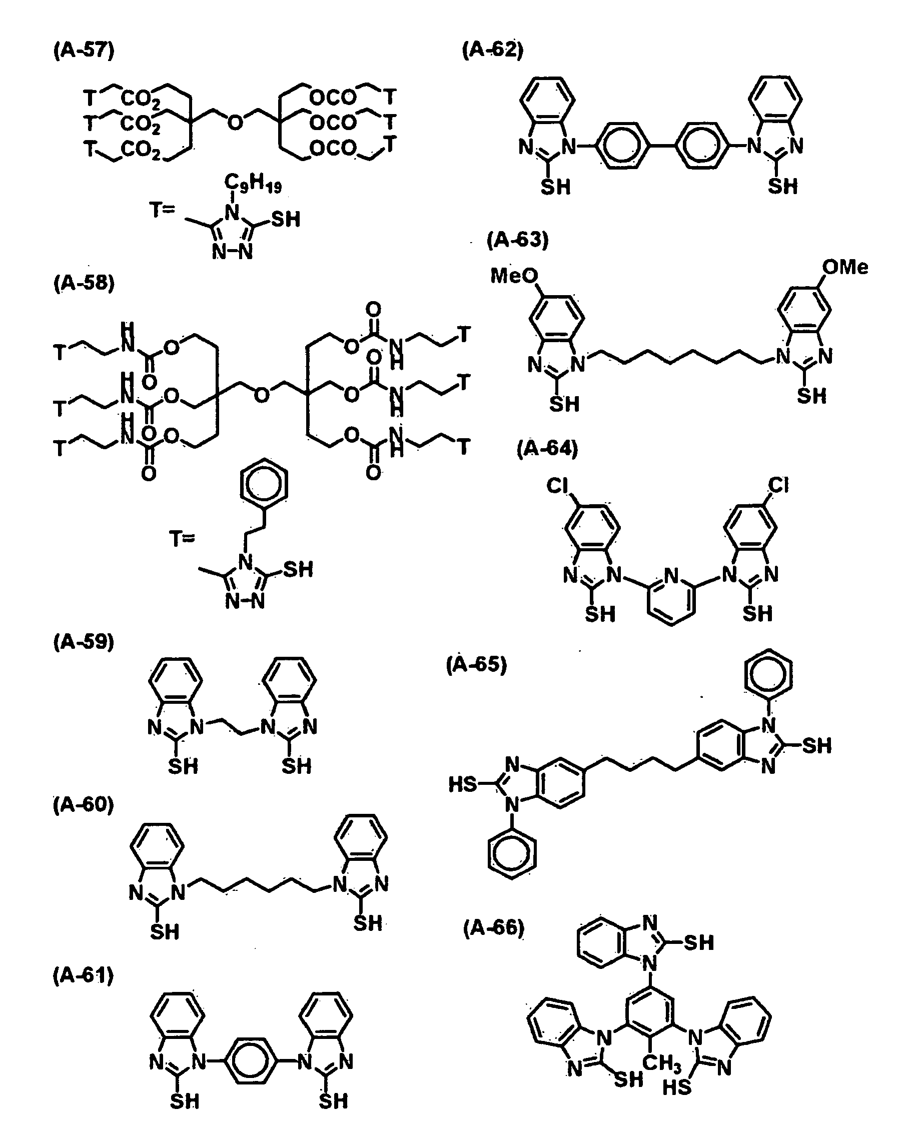

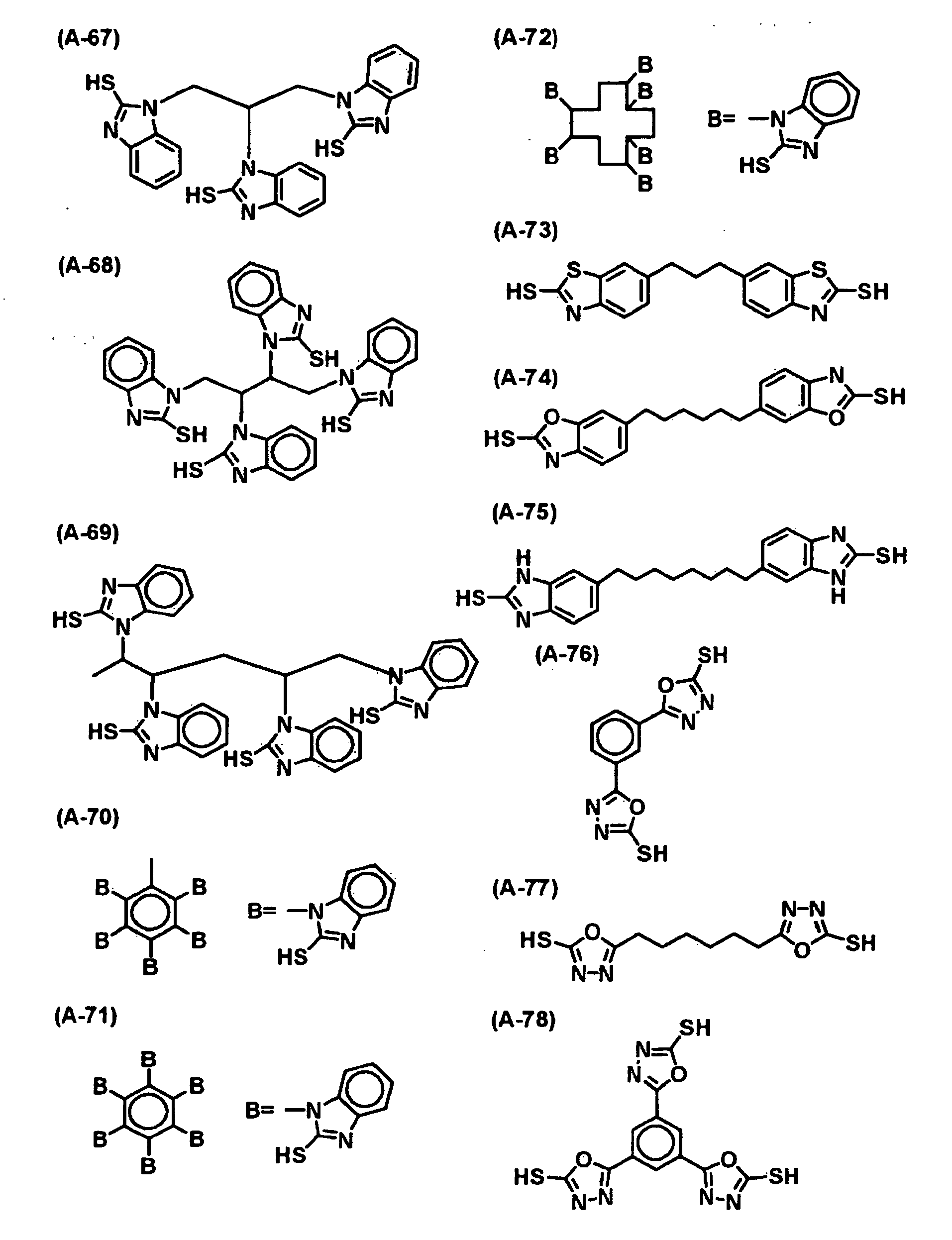

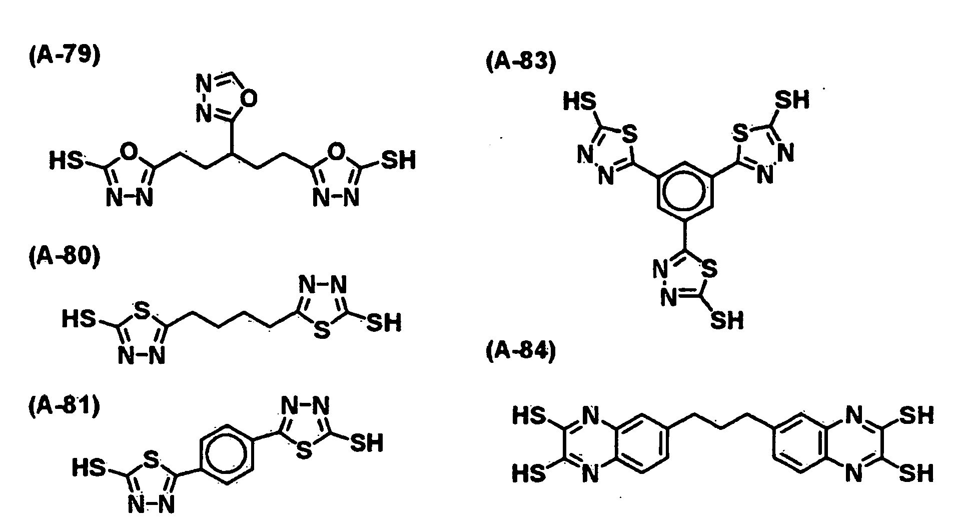

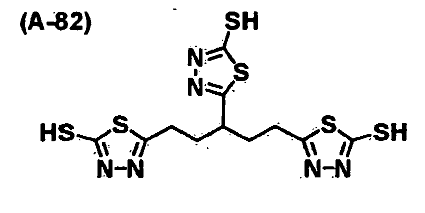

Synthesis of Compound (A-36) illustrated above is described below as a representative synthesis example of the mercapto compound (A), but the invention should not be construed as being limited thereto. Other compounds illustrated above can also be synthesized in a similar manner.

### <Synthesis Example of Compound (A-36)>

### (Synthesis of Precursor C of A-36)

Into a 500-ml round-bottom flask were put 200 ml of ethanol, 20.0 g of 1,3,5-pentanetricarboxylic acid and 5 ml of concentrated sulfuric acid and the mixture was stirred at 80°C for 5 hours. The reaction solution was cooled, poured into 500 ml of water and extracted 3 times with each 200 ml of ethyl acetate. After the extraction, the organic layer was washed with a saturated aqueous potassium carbonate solution and then with a saturated aqueous sodium chloride solution, dried on anhydrous magnesium sulfate and concentrated to obtain 24.0 g of Precursor C of A-36. It was confirmed that the product was the desired compound by an NMR spectrum, an IR spectrum and a mass spectrum.

### (Synthesis of Precursor B of A-36)

Into a 200-ml round-bottom flask were put 30 ml of ethanol, 25.2 g of hydrazine monohydrate and 9.6 g of Precursor C of A-36 and the mixture was stirred at 80°C for 2 hours. The reaction solution was cooled, the white solid thus-deposited was collected by filtration and washed by showering 300 ml of ethanol to obtain 8.5 g of Precursor B of A-36. It was confirmed that the product was the desired compound by an NMR spectrum, an IR spectrum and a mass spectrum.

### (Synthesis of Precursor A of A-36)

Into a 200-ml round-bottom flask were put 30 ml of dimethylsolfoxide, 2.5 g of Precursor B of A-36 and 5. 0 g of phenethyl isothiocyanate and the mixture was stirred at 60°C for 2 hours. The reaction solution was cooled and poured into 300 ml of water, the white solid thus-deposited was collected by filtration and washed by showering 300 ml of water to obtain 6.0 g of Precursor A of A-36. It was confirmed that the product was the desired compound by an NMR spectrum, an IR spectrum and a mass spectrum.

### (Synthesis of Compound (A-36))

Into a 100-ml round-bottom flask were put 20 ml of water, 1.0 g of sodium hydroxide and 6.0 g of Precursor A of A-36 and the mixture was stirred at 100°C for 2 hours. After cooling the reaction solution, concentrated hydrochloric acid was added thereto so that pH of the solution was decreased to about 3, the white solid thus-deposited was collected by filtration to obtain 4.9 g of Compound (A-36). It was confirmed that the product was the desired compound by an NMR spectrum, an IR spectrum and a mass spectrum.

A molecular weight of the mercapto compound (A) is ordinarily from 400 to 2,000, preferably from 400 to 1,000.

A content of the mercapto compound (A) according to the invention is preferably from 0.01 to 50% by weight, more preferably from 0.01 to 30% by weight, still more preferably from 0.1 to 20% by weight, based on the total solid content of the photosensitive composition. The content is the same when the mercapto compound
(A) is applied to an image-recording layer of an image-recording material, for example, a lithographic printing plate precursor.
(B) Hexaarylbiimidazole compound

The hexaarylbiimidazole compound for use in the invention is excellent in stability and capable of generating a radical in high sensitivity.

As the hexaarylbiimidazole compound, various compounds described, for example, in European Patents 24,629 and 107,792, U.S. Patent 4,410,621, European Patent 215,453 and German Patent 3,211,312 can be used.

Preferable specific examples of the hexaarylbiimidazole compound include 2,2'-bis(o-chlorophenyl)-4, 4' 5, 5'-tetraphenylbiimidazole, 2,2'-bis(o-bromophenyl)-4, 4' 5, 5'-tetraphenylbiimidazole,
2,2'-bis(o,p-dichlorophenyl)-4,4',5,5'-tetraphenylbiimidazole,
2,2'-bis(o-chlorophenyl)-4, 4' 5, 5'-tetra(m-methoxyphenyl)biimidazole,
2,2'-bis(o,o'-dichlorophenyl)-4, 4', 5,5'-tetraphenylbiimidazole,
2,2'-bis(o-nitrophenyl)-4, 4', 5,5'-tetraphenylbiimidazole, 2,2'-bis(o-methylphenyl)-4,
4', 5,5'-tetraphenylbiimidazole and 2,2'-bis(o-trifluoromethylphenyl)-4, 4',
5,5'-tetraphenylbiimidazole.

The hexaarylbiimidazole compound can be added in an amount from 0.1 to 50% by weight, preferably from 0.5 to 30% by weight, particularly preferably from 1 to 20% by weight, based on the total solid content of the photosensitive composition. In the above-described range, sufficiently high sensitivity is obtained and when the photosensitive composition is used as a photosensitive layer of a lithographic printing plate precursor, preservation stability is improved. The hexaarylbiimidazole compounds may be used individually or in combination of two or more thereof. The hexaarylbiimidazole compound may be added to a layer together with other components or may be added to a different layer separately provided.

### (C) Sensitizing dye

According to the invention, a sensitizing dye absorbing light of a prescribed wavelength is preferably used. By exposure to the light of wavelength which the sensitizing dye can absorb, a radical-generating reaction of the component (B) described above and a polymerization reaction of the component (D) described hereinafter based on the radical are accelerated. As the sensitizing dye (C), known spectral sensitizing dyes or dyes, or dyes or pigments which absorb light to conduct interaction with a photopolymerization initiator are exemplified. Depending on the wavelength of light which the sensitizing dye absorbs, the photosensitive composition according to the invention can be sensitive to light of various wavelengths from ultraviolet ray, visible light to infrared ray. For instance, in the case of using an infrared absorbing agent as the sensitizing dye (c), the photosensitive composition becomes sensitive to infrared ray having a wavelength of 760 to 1,200 nm. Also, in the case of using the sensitizing dye having a maximum absorption wavelength in a range form 350 to 450 nm, the photosensitive composition becomes sensitive to visible light from blue to violet color.

### (Spectral sensitizing dye or dye)

The spectral sensitizing dye or dye preferable for the sensitizing dye (C) used in the invention includes polynuclear aromatic compounds (for example, pyrene, perylene or triphenylene), xanthenes (for example, fluorescein, Eosine, Erythrosine, Rhodamine B or Rose Bengale), cyanines (for example, thiacarbocyanine or oxacarbocyanine), merocyanines (for example, merocyanine or carbomerocyanine), thiazines (for example, Thionine, Methylene Blue or Toluidine Blue), acridines (for example, Acridine Orange, chloroflavine or acriflavine), phthalocyanines (for example, phthalocyanine or metal phthalocyanine), porphyrins (for example, tetraphenylporphyrin or center metal-substituted porphyrin), chlorophylls (for example, chlorophyll, chlorophyllin or center metal-substituted chlorophyll), metal complexes (for example, compound shown below), anthraquinones (for example, anthraquinone) and squaliums (for example, squalium).

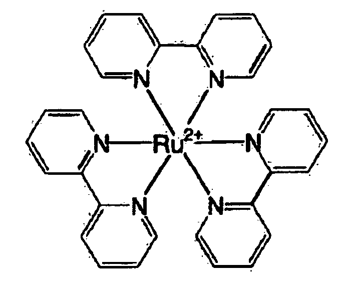

More preferable examples of the spectral sensitizing dye or dye include styryl dyes as described in JP-B-37-13034 (the term "JP-B" as used herein means an "examined Japanese patent publication"), cationic dyes as described in JP-A-62-143044, quinoxalinium salts as described in JP-B-59-24147, new Methylene Blue compounds as described in JP-A-64-33104, anthraquinones as described in JP-A-64-56767, benzoxanthene dyes as described in JP-A-2-1714, acridines as described in JP-A-2-226148 and JP-A-2-226149, pyrylium salts as described in JP-B-40-28499, cyanines as described in JP-B-46-42363, benzofuran dyes as described in JP-A-2-63053, conjugated ketone dyes as described in JP-A-2-85858 and JP-A-2-216154, dyes as described in JP-A-57-10605, azocinnamylidene derivatives as described in JP-B-2-30321, cyanine dyes as described in JP-A-1-287105, xanthene dyes as described in JP-A-62-31844, JP-A-62-31848 and JP-A-62-143043, aminostyryl ketones as described in JP-B-59-28325, merocycnine dyes as described in JP-B-61-9621, dyes as described in JP-A-2-179643, merocycnine dyes as described in JP-A-2-244050, merocycnine dyes as described in JP-B-59-28326, merocycnine dyes as described in JP-A-59-89803, merocycnine dyes as described in JP-A-8-129257, and benzopyran dyes as described in JP-A-8-334897.

### (Infrared absorbing agent)

Infrared absorbing agents (dyes and pigments) described below are also particularly preferably used as the sensitizing dye (C).

As the dyes, commercially available dyes and known dyes described in literature, for example, Senryo Binran (Dye Handbook) compiled by The Society of Synthetic Organic Chemistry, Japan (1970) are utilized. Specifically, the dyes include azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Preferable examples of the dye include cyanine dyes described, for example, in JP-A-58-125246, JP-A-59-84356, JP-A-59-202829 and JP-A-60-78787; methine dyes described, for example, in JP-A-58-173696, JP-A-58-181690 and JP-A-58-194595; naphthoquinone dyes described, for example, in JP-A-58-112793, JP-A-58-224793, JP-A-59-48187, JP-A-59-73996, JP-A-60-52940 and JP-A-60-63744; squarylium dyes described, for example, in JP-A-58-112792; and cyanine dyes described, for example, in British Patent 434,875.

Also, near infrared absorbing sensitizers described in U.S. Patent 5,156,938 are preferably used. Further, substituted arylbenzo(thio)pyrylium salts described in U.S. Patent 3,881,924, trimethinethiapyrylium salts described in JP-A-57-142645 (corresponding to U.S. Patent 4,327,169), pyrylium compounds described in JP-A-58-181051, JP-A-58-220143, JP-A-59-41363, JP-A-59-84248, JP-A-59-84249, JP-A-59-146063 and JP-A-59-146061, cyanine dyes described in JP-A-59-216146, pentamethinethiopyrylium salts described in U.S. Patent 4,283,475, and pyrylium compounds described in JP-B-5-13514 and JP-B-5-19702 are also preferably used. Other preferred examples of the dye include near infrared absorbing dyes represented by formulae (I) and (II) in U.S. Patent 4,756,993.

Other preferred examples of the infrared absorbing dye according to the invention include specific indolenine cyanine dyes described in Japanese Patent Application No. 2001-6326 and JP-A-2002-278057 as illustrated below.

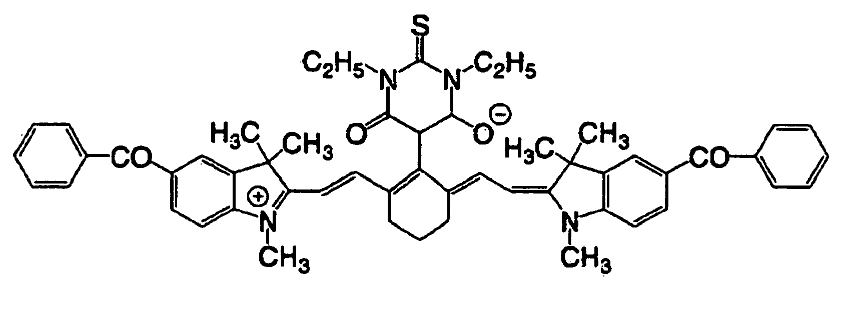

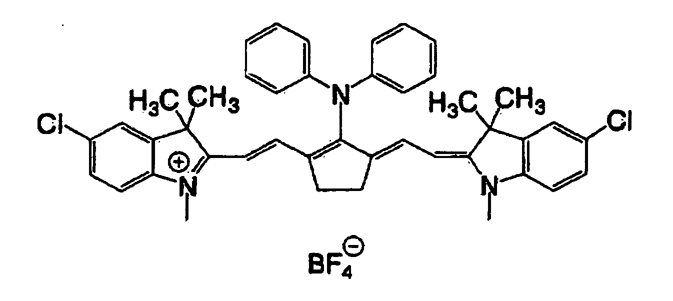

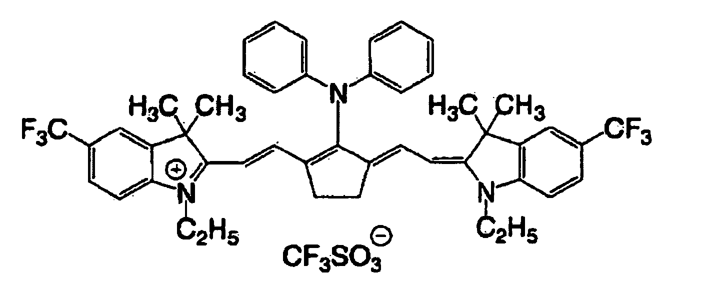

Of the dyes, cyanine dyes, squarylium dyes, pyrylium dyes, nickel thiolate complexes and indolenine cyanine dyes are particularly preferred. Cyanine dyes and indolenine cyanine dyes are more preferred. As one particularly preferable example of the dye, a cyanine dye represented by formula (a) shown below is exemplified.

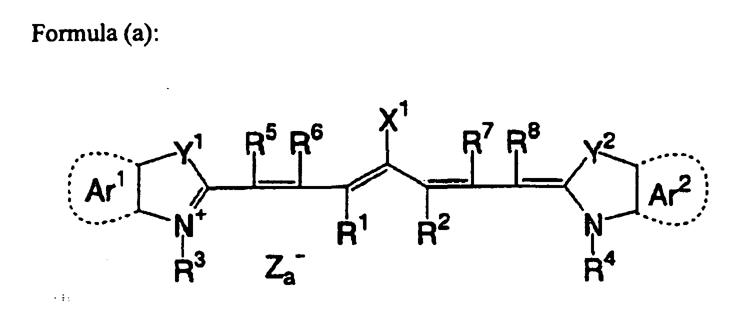

In formula (a), X¹ represents a hydrogen atom, a halogen atom, -NPh₂, X²-L¹ or a group represented by formula (z) shown below, X² represents an oxygen atom, a nitrogen atom or a sulfur atom, and L¹ represents a hydrocarbon group having from 1 to 12 carbon atoms, an aromatic ring containing a hetero atom or a hydrocarbon group having from 1 to 12 carbon atoms and including a hetero atom. The hetero atom indicates a nitrogen atom, a sulfur atom, an oxygen atom, a halogen atom or a selenium atom. 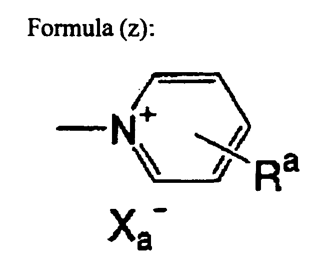 wherein Xa⁻ has the same meaning as Za⁻ defined hereinafter, and R^{a} represents a hydrogen atom or a substituent selected from an alkyl group, an aryl group, a substituted or unsubstituted amino group and a halogen atom.

R¹ and R² each independently represents a hydrocarbon group having from 1 to 12 carbon atoms. In view of the preservation stability of a coating solution for photosensitive layer, it is preferred that R¹ and R² each represents a hydrocarbon group having two or more carbon atoms, and particularly preferably, R¹ and R² are combined with each other to form a 5-membered or 6-membered ring.

Ar¹ and Ar², which may be the same or different, each represents an aromatic hydrocarbon group which may have a substituent. Preferred examples of the aromatic hydrocarbon group include a benzene ring and a naphthalene ring. Also, preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferred examples of the substituent include an alkoxy group having 12 or less carbon atoms, a carboxy group and a sulfo group. R⁵, R⁶, R⁷ and R⁸, which may be the same or different, each represents a hydrogen atom or a hydrocarbon group having 12 or less carbon atoms. From the standpoint of the availability of raw materials, a hydrogen atom is preferred. Za⁻ represents a counter anion. However, Za⁻ is not necessary when the cyanine dye represented by formula (a) has an anionic substituent in the structure thereof so that neutralization of the charge is not needed. Preferable examples of the counter ion for Za⁻ include a halogen ion, a perchlorate ion, a tetrafluoroborate ion, a hexafluorophosphate ion and a sulfonate ion, and particularly preferred examples thereof include a perchlorate ion, a hexafluorophosphate ion and an arylsulfonate ion in view of preservation stability of a coating solution for photosensitive layer.

Specific examples of the cyanine dye represented by formula (a) which can be preferably used in the invention include those described in paragraphs [0017] to [0019] of JP-A-2001-133969, paragraphs [0012] to [0038] of JP-A-2002-40638 and paragraphs [0012] to [0023] of JP-A-2002-23360.

### (Dye having a maximum absorption wavelength in a range of 350 to 450 nm)

According to other preferable embodiment of the sensitizing dye, dyes which belong to a group of compounds described below and have a maximum absorption wavelength in a range of 350 to 450 nm are exemplified.

The group of compounds includes, for instance, polynuclear aromatic compounds (for example, pyrene, perylene or triphenylene), xanthenes (for example, fluorescein, Eosine, Erythrosine, Rhodamine B or Rose Bengale), cyanines (for example, thiacarbocyanine or oxacarbocyanine), merocyanines (for example, merocyanine or carbomerocyanine), thiazines (for example, Thionine, Methylene Blue or Toluidine Blue), acridines (for example, Acridine Orange, chloroflavine or acriflavine), anthraquinones (for example, anthraquinone) and squaliums (for example, squalium).

More preferable examples of the sensitizing dye include compounds represented by the following formulae (XIV) to (XVIII):

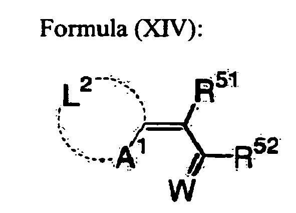

In formula (XIV), A¹ represents a sulfur atom or -N(R⁵⁰)-, R⁵⁰ represents an alkyl group or an aryl group, L² represents a non-metallic atomic group necessary for forming a basic nucleus of the dye together with the adjacent A¹ and the adjacent carbon atom, R⁵¹ and R⁵² each independently represents a hydrogen atom or a monovalent non-metallic atomic group, or R⁵¹ and R⁵² may be combined with each other to form an acidic nucleus of the dye, and W represents an oxygen atom or a sulfur atom.

Preferable specific examples [(C-1) to (C-5)] of the compound represented by formula (XIV) are set forth below.

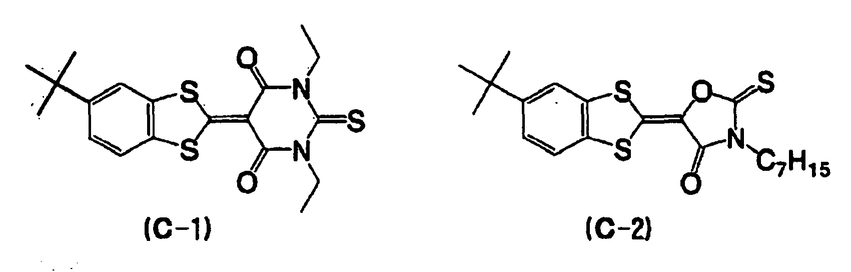

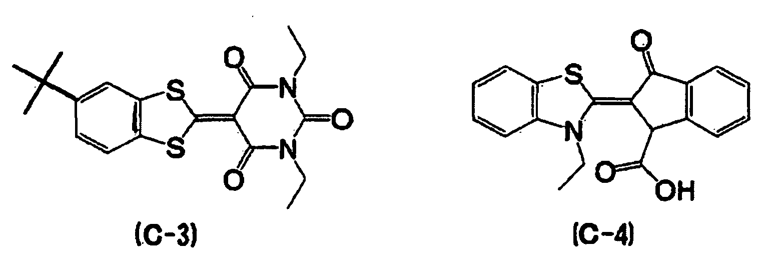

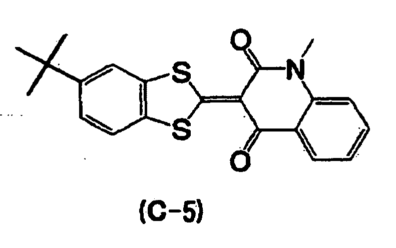

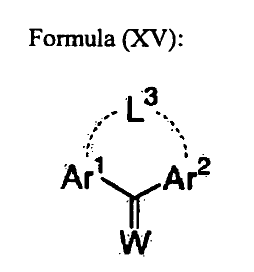

In formula (XV), Ar¹ and Ar² each independently represents an aryl group and Ar¹ and Ar² are connected with each other through -L³-, L³ represents -O- or -S-, and W has the same meaning as W in formula (XIV).

Preferable specific examples [(C-6) to (C-8)] of the compound represented by formula (XV) are set forth below.

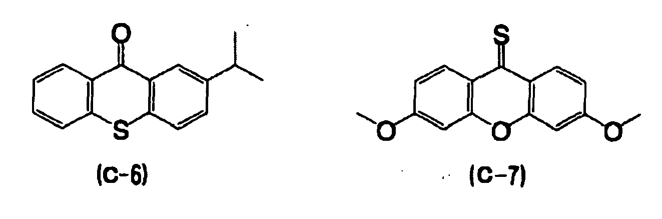

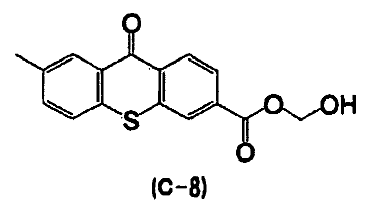

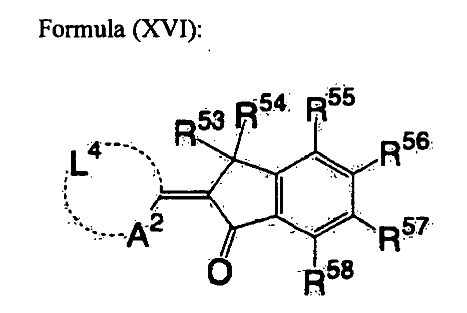

In formula (XVI), A² represents a sulfur atom or -N(R⁵⁹)-, L⁴ represents a non-metallic atomic group necessary for forming a basic nucleus of the dye together with the adjacent A² and the adjacent carbon atom, R⁵³, R⁵⁴, R⁵⁵, R⁵⁶, R⁵⁷ and R⁵⁸ each independently represents a hydrogen atom or a monovalent non-metallic atomic group, and R⁵⁹ represents an alkyl group or an aryl group.

Preferable specific examples [(C-9) to (C-11)] of the compound represented by formula (XVI) are set forth below.

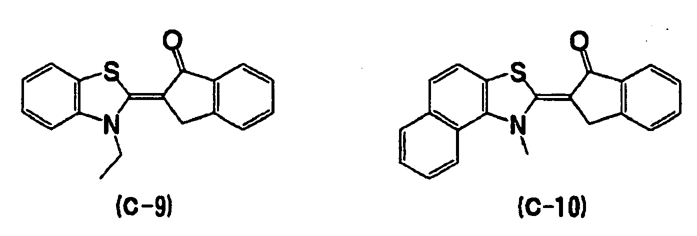

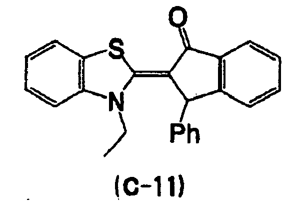

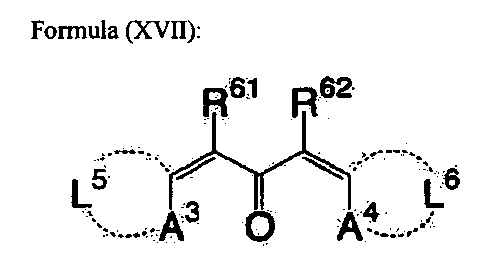

In formula (XVII), A³ and A⁴ each independently represents -S- or -N(R⁶³)-or -N(R⁶³)-, R⁶³ and R⁶⁴ each independently represents a substituted or unsubstituted alkyl group or a substituted or unsubstituted aryl group, L⁵ and L⁶ each independently represents a non-metallic atomic group necessary for forming a basic nucleus of the dye together with the adjacent A³ or A⁴ and the adjacent carbon atom, R⁶¹ and R⁶² each independently represents a hydrogen atom or a monovalent non-metallic atomic group, or R⁶¹ and R⁶² may be combined with each other to form an aliphatic or aromatic ring.

Preferable specific examples [(C-12) to (C-15)] of the compound represented by formula (XVII) are set forth below.

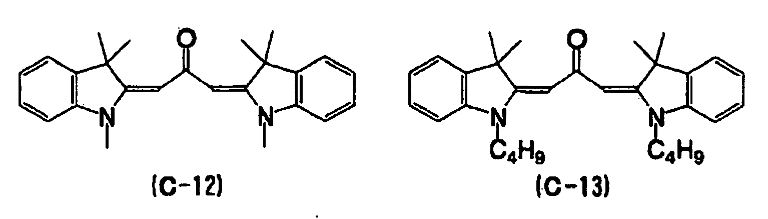

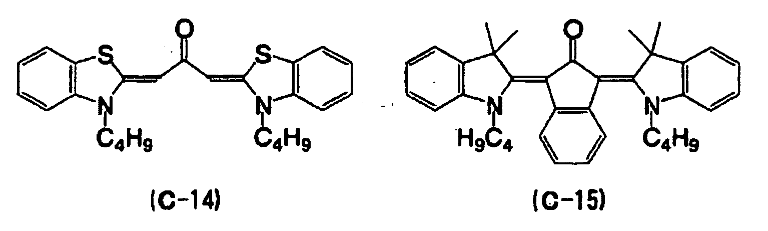

As other preferable examples of the sensitizing dye for use in the invention, compounds represented by formula (XVIII) shown below are exemplified.

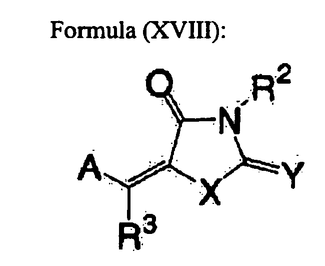

In formula (XVIII), A represents an aromatic group which may have a substituent or a heterocyclic group which may have a substituent, X represents an oxygen atom, a sulfur atom or -N(R¹)-, Y represents an oxygen atom or -N(R¹)-, R¹, R² and R³ each independently represents a hydrogen atom or a monovalent nonmetallic atomic group, or A and R¹, A and R² or A and R³ may be combined with each other to form an aliphatic or aromatic ring.

The monovalent nonmetallic atomic group represented by any one of R₁, R₂ and R₃ preferably includes a substituted or unsubstituted alkyl group or a substituted or unsubstituted aryl group.

Now, preferable examples for any one of R₁, R₂ and R₃ are specifically described below. Preferable examples of the alkyl group include a straight-chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbomyl group. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group, a monovalent non-metallic atomic group exclusive of a hydrogen atom is used. Preferred examples thereof include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acyloxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugate base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugate base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugate base group (hereinafter referred to as an "alkylphosphonato group"), a monoarylphosphono group (-PO₃H(aryl)) and its conjugate base group (hereinafter referred to as an "arylphosphonato group"), a phosphonooxy group (-OPO₃H₂) and its conjugate base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugate base group (hereinafter referred to as an "alkylphosphonatooxy group"), a monoarylphosphonooxy group (-OPO₃H(aryl)) and its conjugate base group (hereinafter referred to as an "arylphosphonatooxy group"), a cyano group, a nitro group, an aryl group, a heteroaryl group, an alkenyl group, an alkynyl group and a silyl group.

In the substituents, specific examples of the alkyl group include those described for the alkyl group above. The alkyl group may further have a substituent.

Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group and a phosphonatophenyl group.

As the heteroaryl group, a group derived from a monocyclic or polycyclic aromatic ring containing at least one of a nitrogen atom, an oxygen atom and a sulfur atom is used. Examples of heteroaryl ring in the especially preferable heteroaryl group include thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane and phenoxazine. These groups may be benzo-fused or may have a substituent.

Also, examples of the alkenyl group include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl group and a trimethylsilylethynyl group. Examples of G₁ in the acyl group (G₁CO-) include a hydrogen atom and the above-described alkyl group and aryl group. Of the substituents for the alkyl group, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxy group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonooxy group, a phosphonatooxy group, an aryl group, an alkenyl group and an alkylidene group (for example, a methylene group) are more preferable.

On the other hand, as an alkylene group in the substituted alkyl group, a divalent organic residue resulting from elimination of any one of hydrogen atoms on the above-described alkyl group having from 1 to 20 carbon atoms can be enumerated. Examples of the preferable alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferable substituted alkyl group represented by any one of R¹, R², and R³, which is obtained by combining the above-described substituent with the alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatopropyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Preferable examples of the aryl group represented by any one of R₁, R₂ and R₃ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among them, a phenyl group and a naphthyl group are more preferable.

Preferable examples of the substituted aryl group represented by any one of R₁, R₂ and R₃ include aryl groups having a monovalent non-metallic atomic group (exclusive of a hydrogen atom) as a substituent on the ring-forming carbon atom of the above-described aryl group. Preferred examples of the substituent include the above-described alkyl groups and substituted alkyl groups, and the substituents described for the above-described substituted alkyl group. Specific examples of the preferable substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propynylphenyl group, a 2-butynylphenyl group and a 3-butynylphenyl group.

More preferable examples of any one of R² and R³ include a substituted or unsubstituted alkyl group, and more preferable examples of R¹ include a substituted or unsubstituted aryl group. The reason why these substituents are preferable is not quite clear. However, it is believed that interaction of the sensitizing dye in the electron excited state caused by light absorption with the initiator compound becomes especially large by means of having such a substituent to increase efficiency of the initiator compound for generating a radical, an acid or a base.

Now, A in formula (XVIII) will be described below. A represents an aromatic group which may have a substituent or heterocyclic group which may have a substituent. Specific examples of the aromatic group which may have a substituent and heterocyclic group which may have a substituent include those described for the aryl group and the heteroaryl group with respect to any one of R₁, R₂ and R₃ in formula (XVIII), respectively.

Among them, A is preferably an aryl group having an alkoxy group, a thioalkyl group or an amino group, and more preferably an aryl group having an amino group.

Now, Y in formula (XVIII) will be described below. Y represents a non-metallic atomic group necessary for forming a heterocyclic ring together with the above-described A and the adjacent carbon atom. The heterocyclic ring includes a 5-membered, 6-membered or 7-membered, nitrogen-containing or sulfur-containing heterocyclic ring which may have a fused ring, and it is preferably a 5-membered or 6-membered heterocyclic ring.

As the nitrogen-containing heterocyclic ring, those which are known to constitute basic nuclei in merocyanine dyes described in L.G. Brooker et al., J. Am. Chem. Soc., Vol. 73, pages 5326 to 5358 (1951) and references cited therein can be preferably used.

Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenylthiazole), 4-(2-thienyl)thiazole or 4,5-di(2-furyl)thiazole); benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole or 5-ethoxycarbonylbenzothiazole); naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole or 7-methoxynaphtho[1,2]thiazole); thianaphtheno-7',6',4,5-thiazoles (for example, 4'-methoxythianaphtheno-7',6',4,5-thiazole); oxazoles (for example, 4-methyloxazole, 5-methyloxazole, 4-phenyloxazole, 4,5-diphenyloxazole, 4-ethyloxazole, 4,5-dimethyloxazole or 5-phenyloxazole); benzoxazoles (for example, benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole or 6-hydroxybenzoxazole);
naphthoxazoles (for example, naphth[1,2]oxazole or naphth[2,1]oxazole); selenazoles (for example, 4-methylselenazole or 4-phenylselenazole); benzoselenazoles (for example, benzoselenazole, 5-chlorobenzoselenazole, 5-methoxybenzoselenazole, 5-hydroxybenzoselenazole or tetrahydrobenzoselenazole); naphthoselenazoles (for example, naphtho[1,2]selenazole or naphtho[2,1]selenazole); thiazolines (for example, thiazoline, 4-methylthiazoline, 4,5-dimethylthiazoline, 4-phenylthiazoline, 4,5-di(2-furyl)thiazoline, 4,5-diphenylthiazoline or 4,5-di(p-methoxyphenyl)thiazoline); 2-quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline or 8-hydroxyquinoline); 4-quinolines (for example, quinoline, 6-methoxyquinoline, 7-methylquinoline or 8-methylquinoline); 1-isoquinolines (for example, isoquinoline or 3,4-dihydroisoquinoline); 3-isoquinolines (for example, isoquinoline); benzimidazoles (for example, 1,3-dimethylbenzimidazole, 1,3-diethylbenzimidazole or 1-ethyl-3-phenylbenzimidazole); 3,3-dialkylindolenines (for example, 3,3-dimethylindolenine, 3,3,5-trimethylindolenine or 3,3,7-trimethylindolenine); 2-pyridines (for example, pyridine or 5-methylpyridine); and 4-pyridines (for example, pyridine). Further, the substituents on the heterocyclic ring may be combined with each other to from a ring.

Examples of the sulfur-containing heterocyclic ring include dithiol partial structures in dyes described in JP-A-3-296759.

Specific examples thereof include benzodithiols (for example, benzodithiol, 5-tert-butylbenzodithiol or 5-methylbenzodithiol); naphthodithiols (for example, naphtho[1,2]dithiol or naphtho[2,1]dithiol); and dithiols (for example, 4,5-dimethyldithiol, 4-phenyldithiol, 4-methoxycarbonyldithiol, 4,5-dimethoxycarbonyldithiol, 4,5-ditrifluoromethyldithiol, 4,5-dicyanodithiol, 4-methoxycarbonylmethyldithiol or 4-carboxymethyldithiol).

Among the nitrogen-containing or sulfur-containing heterocyclic rings formed by Y together with the above-described A and the adjacent carbon atom in formula (XVIII) described above, dyes having a partial structure represented by formula (XVIII-2) shown below are particularly preferable, because the dyes provide a photosensitive composition having both a high sensitizing ability and an exceptional preservation stability. The dyes having the structure represented by formula (XVIII-2) are described in more detail in JP-A-2004-318049 as novel compounds by the present applicant.

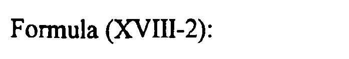

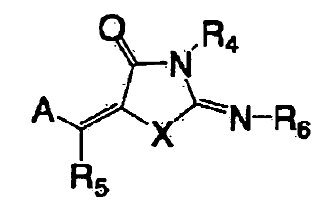

In formula (XVIII-2), A represents an aromatic group which may have a substituent or a heterocyclic group which may have a substituent, X represents an oxygen atom, a sulfur atom or -N(R¹)-, R¹, R⁴, R⁵ and R⁶ each independently represents a hydrogen atom or a monovalent nonmetallic atomic group, or A and R¹, A and R⁴, A and R⁵ or A and R⁶ may be combined with each other to form an aliphatic or aromatic ring.

In formula (XVIII-2), A and R¹ have the same meanings as A and R¹ in formula (XVIII) respectively, and R⁴, R⁵ and R⁶ have the same meanings as R², R³ and R' in formula (XVIII) respectively.

Compounds represented by formula (XVIII-3) shown below which are preferable embodiments of the compound represented by formula (XVIII) for use in the invention are described below.

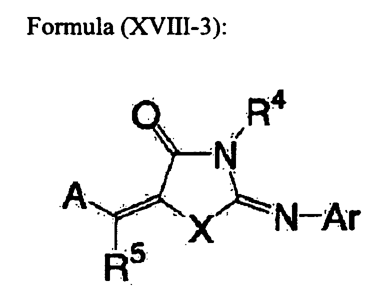

In formula (XVIII-3), A represents an aromatic group which may have a substituent or a heterocyclic group which may have a substituent, X represents an oxygen atom, a sulfur atom or -N(R¹)-, R¹, R⁴ and R⁵ each independently represents a hydrogen atom or a monovalent nonmetallic atomic group, or A and R¹, A and R⁴ or A and R⁵ may be combined with each other to form an aliphatic or aromatic ring. Ar represents an aromatic group which have a substituent or a heterocyclic group which have a substituent, provided that the substituent(s) present on the Ar skeleton must have the sum of Hammett values of 0 or larger. The terminology "the sum of Hammett values of 0 or larger" as used herein means that one substituent is present on the Ar skeleton and the Hammett value of the substituent is larger than 0 or plural substituents are present on the Ar skeleton and the sum of the Hammett values of the substituents is larger than 0.

In formula (XVIII-3), A and R¹ have the same meanings as A and R¹ in formula (XVIII) respectively, and R⁴ and R⁵ have the same meanings as R² and R³ in formula (XVIII) respectively. Ar represents an aromatic group which have a substituent or a heterocyclic group which have a substituent. Specific examples thereof include the specific examples of the aromatic group which have a substituent or heterocyclic group which have a substituent among those described with respect to A in formula (XVIII). However, it is essential for the substituent introduced into Ar in formula (XVIII-3) that the sum of Hammett values thereof is 0 or larger. Examples of the substituent include a trifluoromethyl group, a carbonyl group, an ester group, a halogen atom, a nitro group, a cyano group, a sulfoxido group, an amido group and a carboxyl group. The Hammett values of the substituents are shown below. Trifluoromethyl group (-CF₃ m: 0.43, p: 0.54), Carbonyl group (for example, -COH m: 0.36, p: 0.43), Ester group (for example, -COOCH₃ m: 0.37, p: 0.45), Halogen atom (for example, Cl m: 0.37, p: 0.23), Cyano group (-CN m: 0.56, p: 0.66), Sulfoxido group (for example, -SOCH₃ m: 0.52, p: 0.45), Amido group (for example, -HNCOCH₃ m: 0.21, p: 0.00),and Carboxyl group (-COOH 0.37, p: 0.45). In each parenthesis, an introduction position of the substituent on the aryl skeleton and the Hammett value thereof are described. For instance, (m: 0.50) means that when the substituent is introduced into a metha position, the Hammett value thereof is 0.50. In the above, a preferable example of Ar is a phenyl group having a substituent. Preferable examples of the substituent on the Ar skeleton include an ester group and a cyano group. With respect to the position of the substituent, an ortho position of the Ar skeleton is particularly preferable.

Preferable specific examples (Compound D1 to Compound D56) of the sensitizing dye represented by formula (XVIII) according to the invention are set for the below, but the invention should not be construed as being limited thereto.

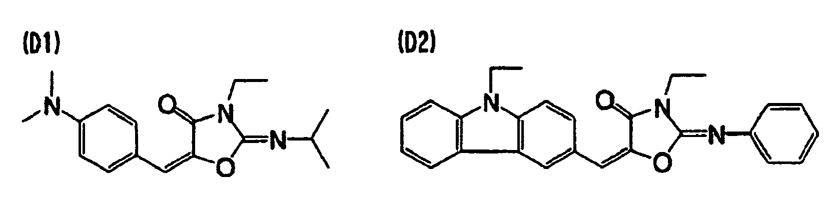

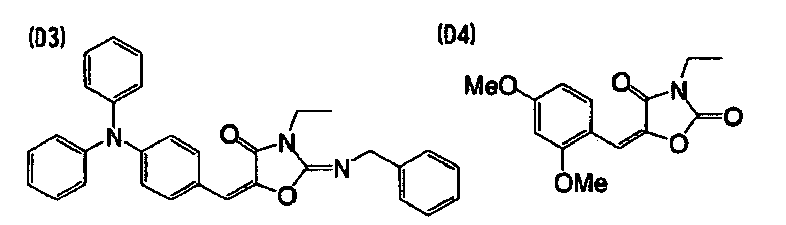

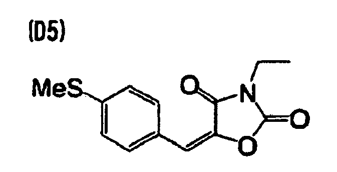

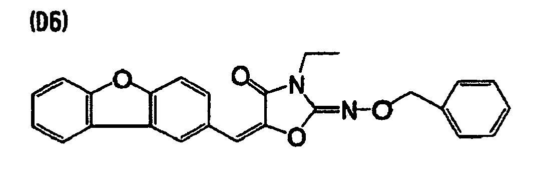

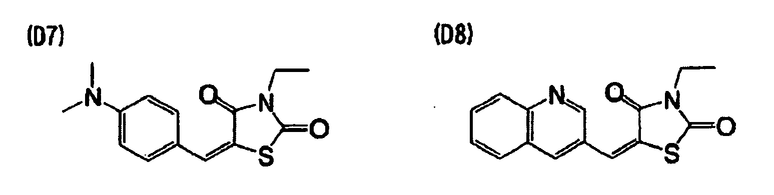

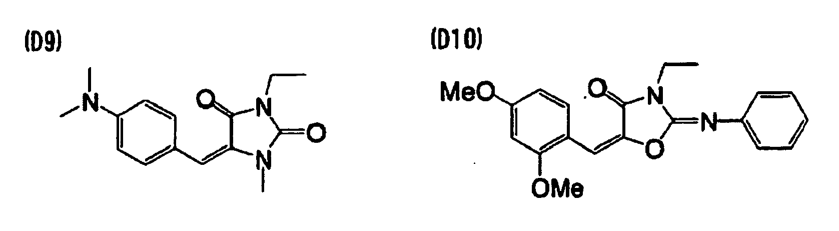

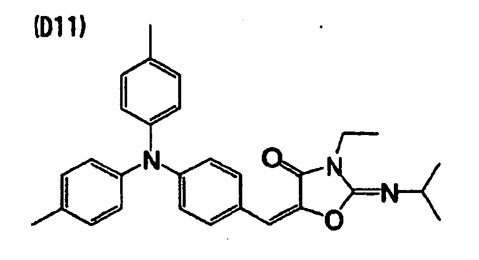

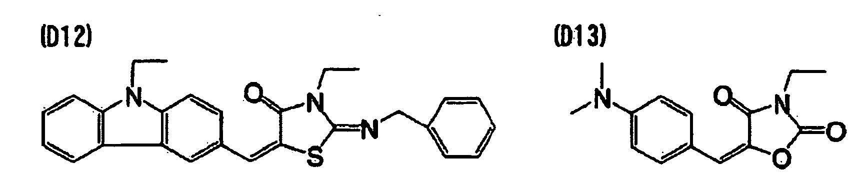

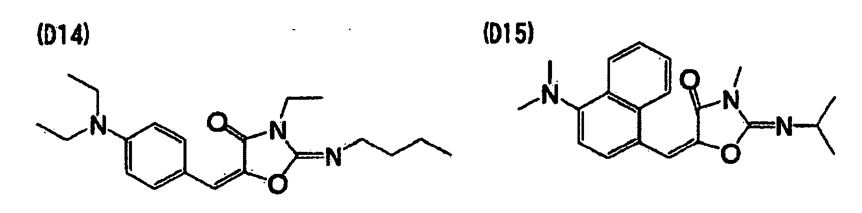

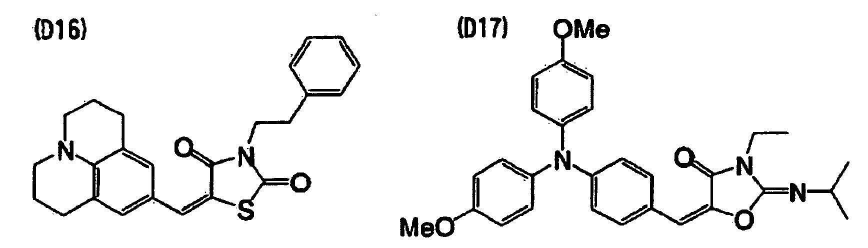

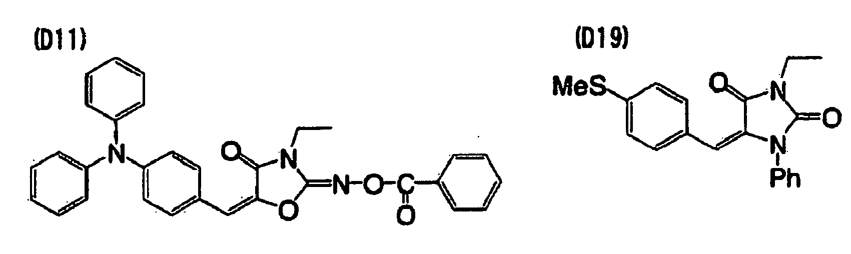

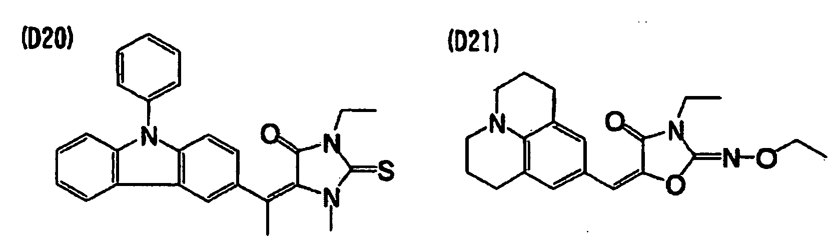

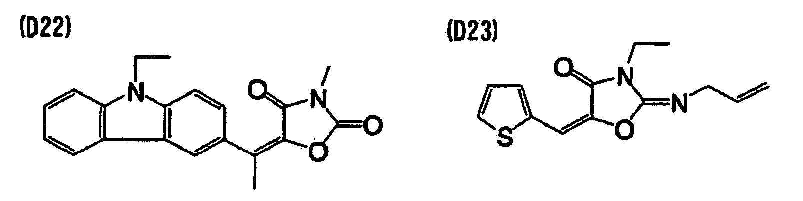

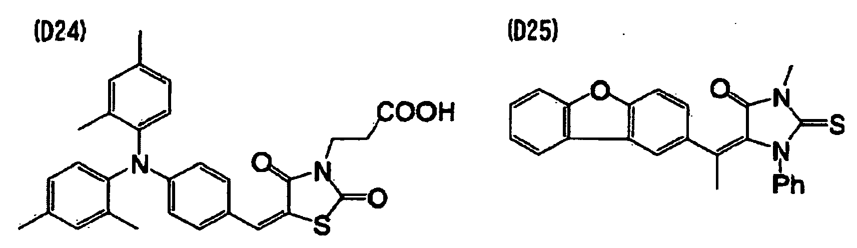

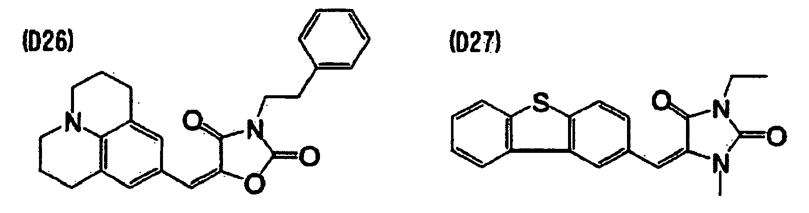

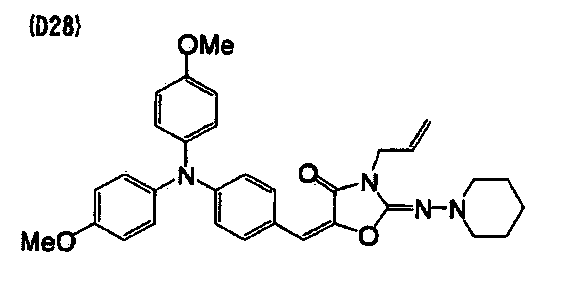

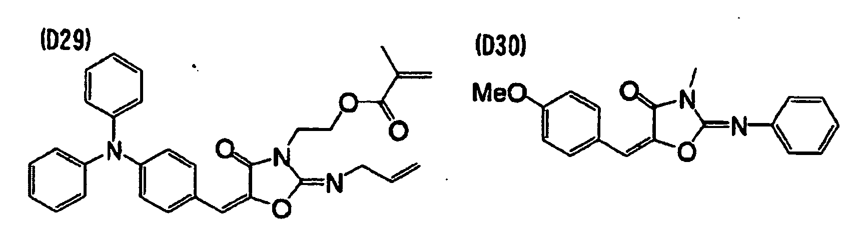

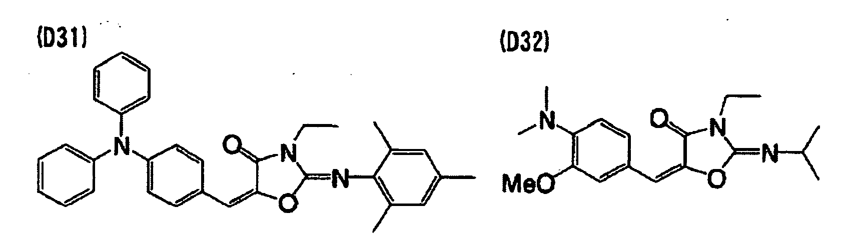

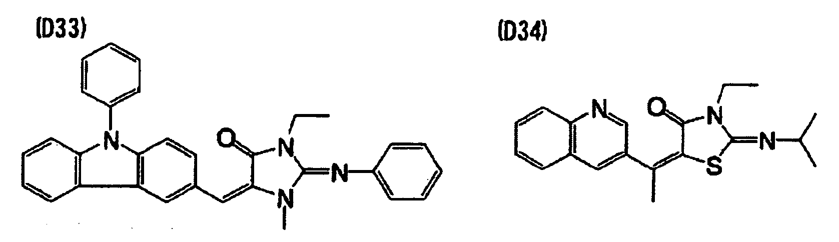

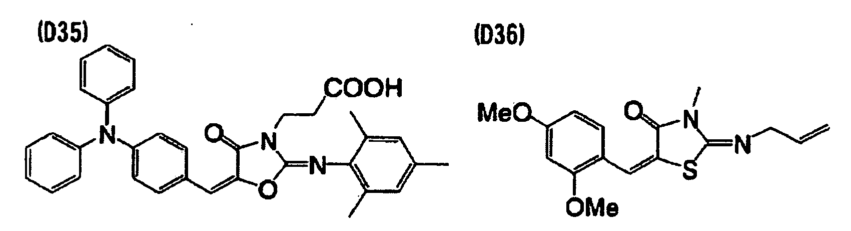

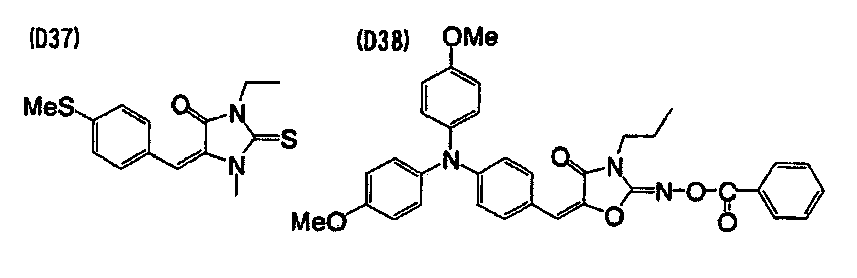

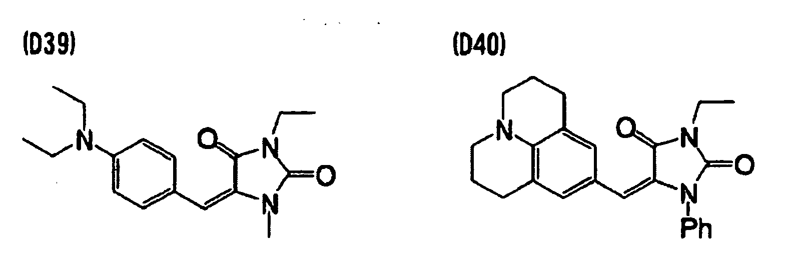

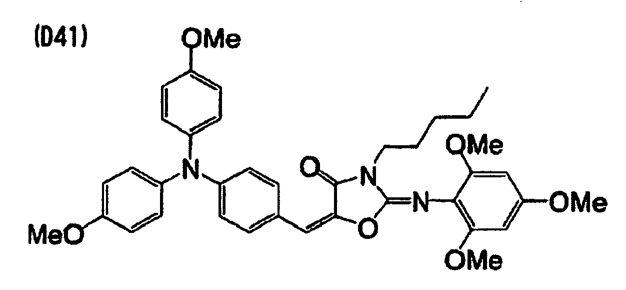

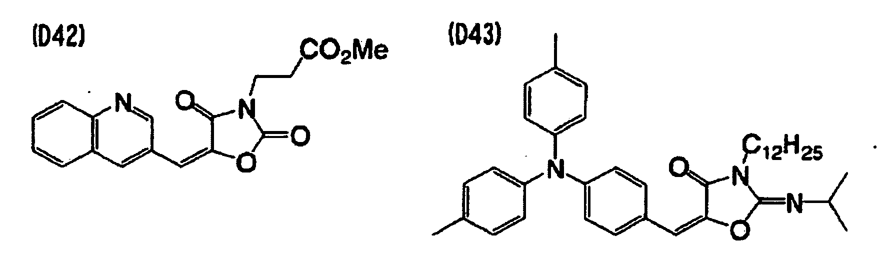

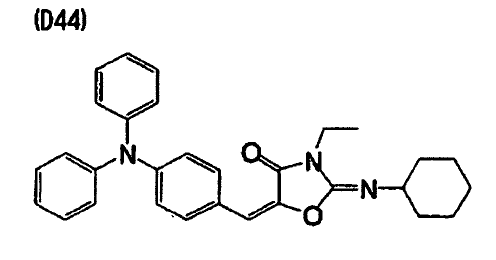

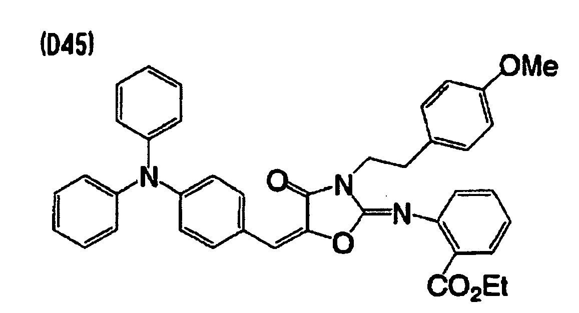

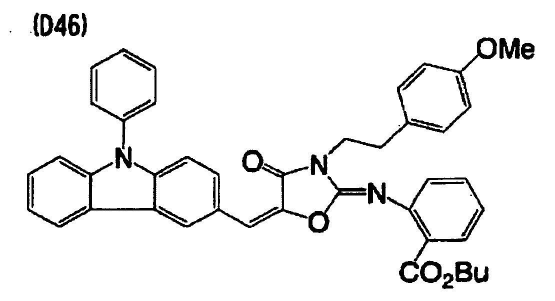

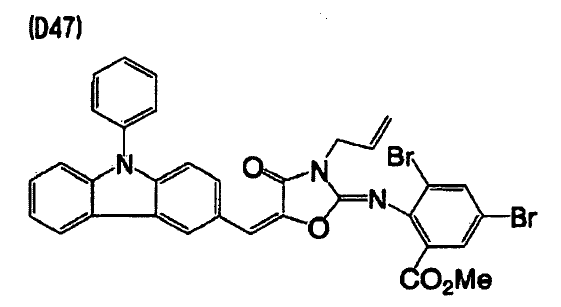

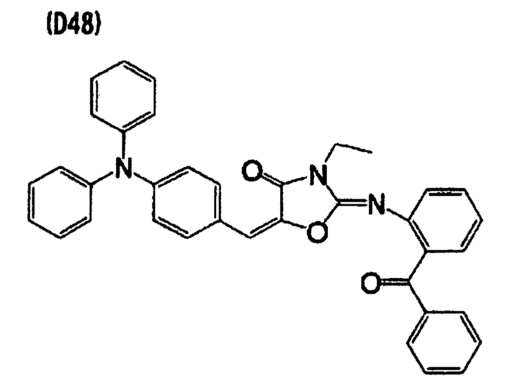

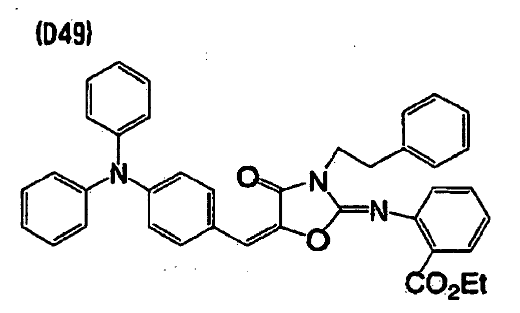

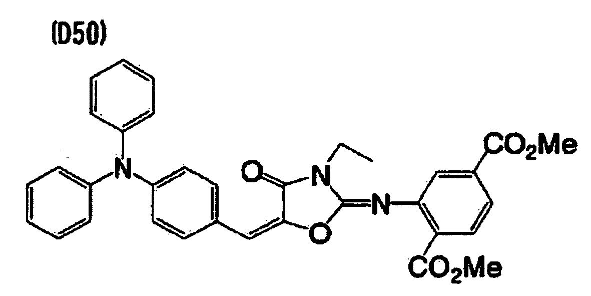

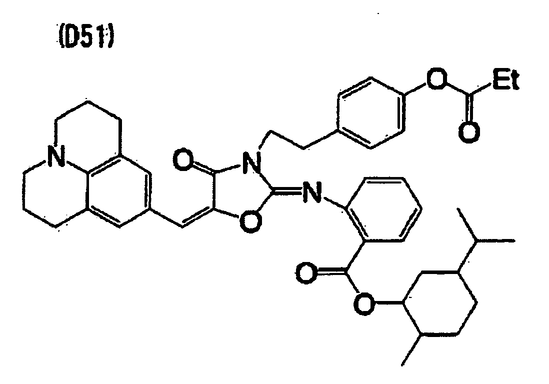

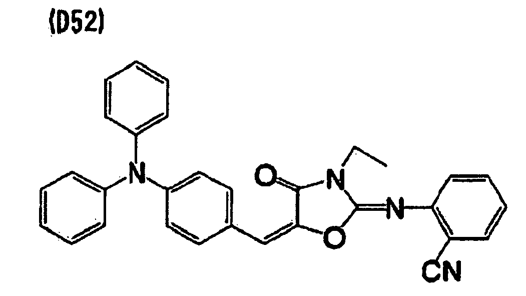

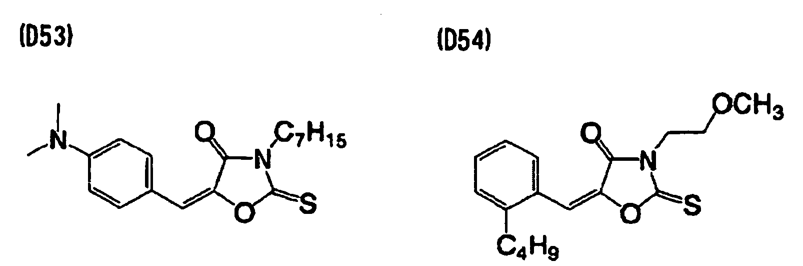

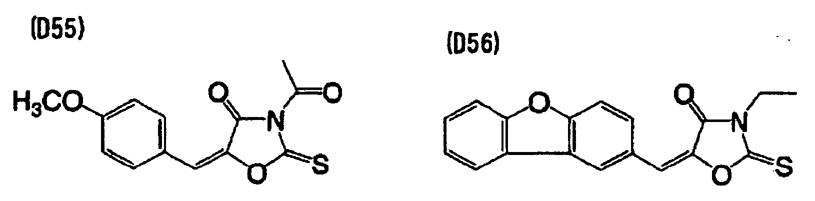

Of the above-described sensitizing dyes applicable to the invention, the compounds represented by formula (XVIII) are preferable from the standpoint of sensitivity.

The sensitizing dye may be subjected to various chemical modifications described below for the purpose of improving characteristics of the photosensitive composition according to the invention. For instance, the sensitizing dye may be connected to an addition-polymerizable compound structure (for example, an acryloyl group or a methacryloyl group) by a covalent bond, ionic bond, hydrogen bond or the like, whereby increase in strength of the crosslinked hardened layer and improvement in effect for preventing undesirable deposition of the dye in the crosslinked hardened layer can be achieved.

Examples of the pigment used as the sensitizing dye in the invention include commercially available pigments and pigments described in Colour Index (C.I.), Saishin Ganryo Binran (Handbook of Newest Pigments) compiled by Pigment Technology Society of Japan (1977), Saishin Ganryo Oyou Gijutsu (Newest Application Technologies of Pigments), CMC Publishing Co., Ltd. (1986) and Insatsu Ink Giiutsu (Printing Ink Technology), CMC Publishing Co., Ltd. (1984).

Examples of the pigment include black pigments, yellow pigments, orange pigments, brown pigments, red pigments, purple pigments, blue pigments, green pigments, fluorescent pigments, metal powder pigments and polymer-bonded dyes. Specific examples of usable pigments include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black. Of the pigments, carbon black is preferred.

The pigment may be used without undergoing surface treatment or may be used after the surface treatment. For the surface treatment, a method of coating a resin or wax on the surface, a method of attaching a surfactant and a method of bonding a reactive substance (for example, a silane coupling agent, an epoxy compound or polyisocyanate) to the pigment surface. The surface treatment methods are described in Kinzoku Sekken no Seishitsu to Oyo (Properties and Applications of Metal Soap), Saiwai Shobo, Insatsu Ink Giiutsu (Printing Ink Technology), CMC Publishing Co., Ltd. (1984), and Saishin Ganryo Oyo Gijutsu (Newest Application Technologies of Pigments), CMC Publishing Co., Ltd. (1986).

A particle size of the pigment is preferably in a range from 0.01 to 10 µm, more preferably in a range from 0.05 to 1 µm, and particularly preferably in a range from 0.1 to 1 µm, from the standpoint of dispersibility of the pigment in a coating solution and uniformity of the photosensitive layer.

As a dispersing method of the pigment, a known dispersion technique for use in the production of ink or toner may be used. Examples of the dispersing machine include an ultrasonic dispersing machine, a sand mill, an attritor, a pearl mill, a super-mill, a ball mill, an impeller, a disperser, a KD mill, a colloid mill, a dynatron, a three roll mill and a pressure kneader. The dispersing machines are described in detail in Saishin Ganryo Oyo Gijutsu (Newest Application Technologies of Pigments), CMC Publishing Co., Ltd. (1986).

In the case wherein the photosensitive composition according to the invention is applied to a lithographic printing plate precursor, the same result can be obtained by adding the sensitizing dye (C) together with other components to one layer or by added it to a different layer separately provided. With respect to an amount of the sensitizing dye added, in the case of preparing a negative-working lithographic printing plate precursor, the amount is so controlled that optical density of the photosensitive layer at the maximum absorption in the wavelength region from 300 to 1,200 nm is preferably in a range from 0.1 to 3.0. When the amount extends beyond the range, the sensitivity may tend to decrease. Since the optical density is determined according to the amount of the sensitizing dye added and thickness of the photosensitive layer, the desired optical density can be obtained by controlling the condition of both factors.

The optical density of the photosensitive layer can be measured in a conventional manner. The method for measurement includes, for example, a method of forming a photosensitive layer having a thickness as a coating amount after drying determined appropriately in the range necessary for the lithographic printing plate precursor on a transparent or white support and measuring optical density of the photosensitive layer by a transmission optical densitometer or a method of forming the photosensitive layer on a reflective support, for example, an aluminum plate, and measuring reflection density of the photosensitive layer by an optical densitometer.

The content of the sensitizing dye (C) included in the photosensitive composition according to the invention is preferably in a range from 0.01 to 50% by weight, more preferably in a range from 0.1 to 30% by weight, most preferably in a range from 0.5 to 10% by weight, based on the total solid content of the photosensitive composition in view of uniformity of the sensitizing dye dispersed in the photosensitive composition and durability of the layer formed.

### (D) Polymerizable compound having an ethylenically unsaturated double bond

The polymerizable compound (D) having an ethylenically unsaturated double bond according to the invention is an addition-polymerizable compound having at least one ethylenically unsaturated double bond and is selected from compounds having at least one, preferably two or more, ethylenically unsaturated double bonds. Such compounds are broadly known in the art and they can be used in the invention without any particular limitation. The compound has a chemical form, for example, a monomer, a prepolymer, specifically, a dimer, a trimer or an oligomer, or a copolymer thereof, or a mixture thereof. Examples of the monomer and copolymer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with an aliphatic polyhydric alcohol compound and amides of an unsaturated carboxylic acid with an aliphatic polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanato group or an epoxy group with a monofunctional or polyfunctional alcohol, amine or thiol, or a substitution reaction product of an unsaturated carboxylic acid ester or amide having a releasable substituent, for example, a halogen group or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of an aliphatic polyhydric alcohol compound with an unsaturated carboxylic acid, include acrylic acid esters, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate or polyester acrylate oligomer;
methacrylic acid esters, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane or bis[p-(methacryloxyethoxy)phenyl]dimethylmethane;
itaconic acid esters, for example, ethylene glycol diitaconate, propylene glycol diitaconate, 1,3-butanediol diitaconate, 1,4-butanediol diitaconate, tetramethylene glycol diitaconate, pentaerythritol diitaconate or sorbitol tetraitaconate;
crotonic acid esters, for example, ethylene glycol dicrotonate, tetramethylene glycol dicrotonate, pentaerythritol dicrotonate or sorbitol tetradicrotonate;
isocrotonic acid esters, for example, ethylene glycol diisocrotonate, pentaerythritol diisocrotonate or sorbitol tetraisocrotonate;
and maleic acid esters, for example, ethylene glycol dimaleate, triethylene glycol dimaleate, pentaerythritol dimaleate and sorbitol tetramaleate.
Other examples of the ester, which can be preferably used, include aliphatic alcohol esters described in JP-B-46-27926, JP-B-51-47334 and JP-A-57-196231, esters having an aromatic skeleton described in JP-A-59-5240, JP-A-59-5241 and JP-A-2-226149, and esters containing an amino group described in JP-A-1-165613.

The above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferred examples of the amide monomer include amides having a cyclohexylene structure described in JP-B-54-21726.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (1) shown below to a polyisocyanate compound having two or more isocyanate groups per molecule, described in JP-B-48-41708.

CH₂=C(R⁴)COOCH₂CH(R⁵)OH (1)

wherein R⁴ and R⁵ each independently represents H or CH₃.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Further, a photosensitive composition having remarkably excellent photo-speed can be obtained by using an addition polymerizable compound having an amino structure or a sulfide structure in its molecule, described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used.

Details of the method of using the polymerizable compound (D), for example, selection of the structure, individual or combination use or an amount added, can be appropriately arranged depending on the characteristic design of the final photosensitive composition. For instance, the compound is selected from the following standpoints. In view of the photo-speed, a structure having a large content of unsaturated groups per molecule is preferred and in many cases, a difunctional or more functional compound is preferred. Also, in order to increase the strength of image area, that is, hardened layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength. The polymerizable compound having a large molecular weight or the polymerizable compound of high hydrophobicity is excellent in the photo-speed and layer strength but it may not be preferable in some cases from the standpoint of the development speed and deposition in a developer. The selection and use method of the polymerizable compound as the component (D) are also important factors for the compatibility and dispersibility with other components (for example, the component (A), the component (B), the sensitizing dye (C), a polymerization inhibitor or a coloring agent) in the photosensitive layer. For instance, the compatibility may be improved in some cases by using the compound of low purity or using two or more kinds of the compounds in combination.

Further, when the photosensitive composition according to the invention is applied to a photosensitive layer of a lithographic printing plate precursor, a specific structure may be selected for the purpose of improving an adhesion property to a support or an overcoat layer described hereinafter of the lithographic printing plate precursor. With respect to a ratio of the polymerizable compound used in the photosensitive layer, a larger ratio is advantageous in view of the sensitivity but when the ratio is too large, undesirable phase separation may occur, a problem may arise in the production step due to tackiness of the photosensitive layer (for example, production failure due to transfer or adhesion of the components of photosensitive layer), and a problem of the deposition in the developer may occur. In view of these points, the polymerizable compound (D) is used preferably from 5 to 80% by weight, more preferably from 25 to 75% by weight, based on the nonvolatile component of the photosensitive layer. The polymerizable compounds may be used individually or in combination of two or more thereof.

Moreover, when the photosensitive composition according to the invention is applied to a lithographic printing plate precursor, in the method of using the polymerizable compound (D), the structure, blend and amount added can be appropriately selected by taking account of the degree of polymerization inhibition due to oxygen, resolution, fogging property, change in refractive index, surface tackiness and the like. Further, depending on the case, a layer construction, for example, an undercoat layer or an overcoat layer, and a coating method, may also be considered.

### (E) Other components

To the photosensitive composition according to the invention, other components suitable for the use, production method or the like thereof can further be appropriately added in addition to the above-described components. Preferable additives are illustrated below.

### (E-1) Binder polymer

In the application of the photosensitive composition according to the invention to a photosensitive layer of a lithographic printing plate precursor as a preferred embodiment of the invention, it is preferred to further use a binder polymer in the photosensitive composition in view of improvement in the film property or the like.

The binder polymer is preferably a linear organic high molecular polymer. The "linear organic high molecular polymer" may be any linear organic high molecular polymer. Preferably, a linear organic high molecular polymer soluble or swellable in water or alkalescent water, which enables water development or alkalescent water development, is selected. The linear organic high molecular polymer is selected not only as a film forming agent of the photosensitive composition but also in consideration of the use of water, alkalescent water or organic solvent as a developer. For instance, when a water-soluble organic high molecular polymer is used, water development can be performed. Examples of the linear organic high molecular polymer include addition polymers having a carboxylic acid group in the side chain thereof, for example, methacrylic acid copolymers, acrylic acid copolymers, itaconic acid copolymers, crotonic acid copolymers, maleic acid copolymers and partially esterified maleic acid copolymers described in JP-A-59-44615, JP-B-54-34327, JP-B-58-12577, JP-B-54-25957, JP-A-54-92723, JP-A-59-53836 and JP-A-59-71048. Further, acidic cellulose derivatives having a carboxylic acid group in the side chain thereof may also be used. In addition, polymers obtained by adding a cyclic acid anhydride to addition polymers having a hydroxy group are also useful.

Among them, [benzyl (meth)acrylate/(meth)acrylic acid/if desired, other addition-polymerizable vinyl monomer] copolymers and [allyl (meth)acrylate/(meth)acrylic acid/if desired, other addition-polymerizable vinyl monomer] copolymers are preferred because of their excellent balance in the film strength, sensitivity and developing property.

Also, acid group-containing urethane binder polymers described in JP-B-7-120040, JP-B-7-120041, JP-B-7-120042, JP-B-8-12424, JP-A-63-287944, JP-A-63-287947, JP-A-1-271741 and Japanese Patent Application No. 10-116232 are advantageous in view of printing durability and low exposure aptitude because of their very excellent strength.

Moreover, a binder having an amido group described in JP-A-11-171909 is preferable because of both of the excellent developing property and the film strength.

Furthermore, polyvinyl pyrrolidone, polyethylene oxide and the like are useful as the water-soluble linear organic polymer. Also, an alcohol-soluble nylon and a polyether of 2,2-bis-(4-hydroxyphenyl)propane with epichlorohydrin are useful for the purpose of increasing the strength of hardened layer. The linear organic high molecular polymer can be mixed in an appropriate amount to the photosensitive composition. However, when the amount exceeds 90% by weight, the preferable results are not obtained in view of the strength of image formed or the like. The amount added is preferably from 30 to 85% by weight. Also, the polymerizable compound having an ethylenically unsaturated double bond and the linear organic high molecular polymer are preferably used in a weight ratio of 1/9 to 7/3. According to a preferred embodiment, the binder polymer is substantially insoluble in water and soluble in alkali. By using such a binder polymer, an organic solvent which is not preferable in view of the environmental concern can be avoided or limited to a very small amount. In such a case, an acid value (acid content per g of polymer, indicated by the chemical equivalent number) and molecular weight of the binder polymer are appropriately selected by taking account of the image strength and the developing property. The acid value is preferably in a range from 0.4 to 3.0 meq/g, more preferably from 0.6 to 2.0 meq/g, and the molecular weight is preferably in a range from 3,000 to 500,000, more preferably from 10,000 to 300,000.

### (E-2) Co-initiator

The photosensitive composition according to the invention may contain a co-initiator from the standpoint of increase in sensitivity.

Preferable examples of the co-initiator for use in the invention include, (a) an aromatic ketone, (b) an onium salt compound, (c) an organic peroxide, (d) a thio compound, (e) a ketoxime ester compound, (f) a borate compound, (g) an azinium compound, (h) a metallocene compound, (i) an active ester compound, (j) a compound having a carbon-halogen bond, and (k) an azo compound. Specific examples of the compounds (a) to (k) are set forth below, but the invention should not be construed as being limited thereto.

### (a) Aromatic ketone

The aromatic ketone (a) preferably used as the radical initiator in the invention includes compounds having a benzophenone skeleton or a thioxantone skeleton described in J. P. Fouassier and J. F. Rabek, Radiation Curing in Polymer Science and Technology, pages 77 to 117 (1993). For example, the following compounds are exemplified.

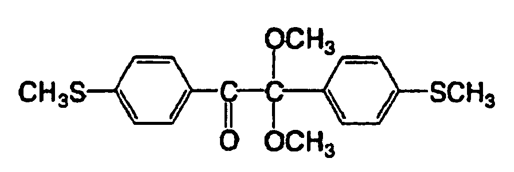

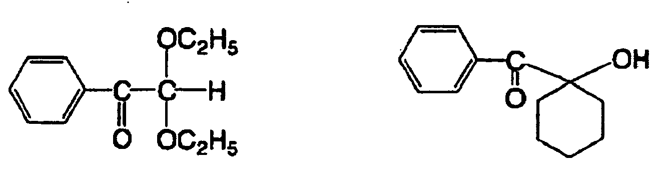

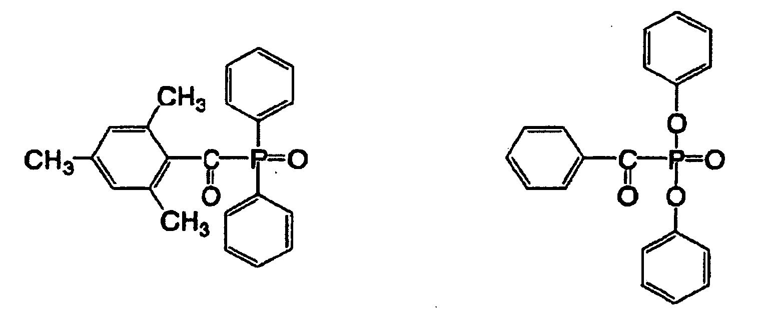

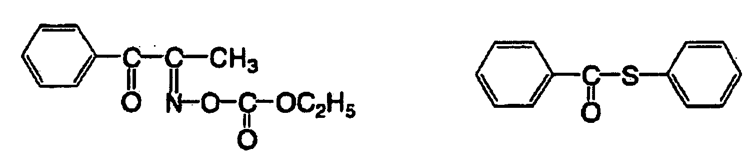

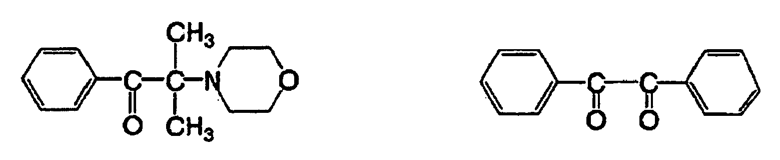

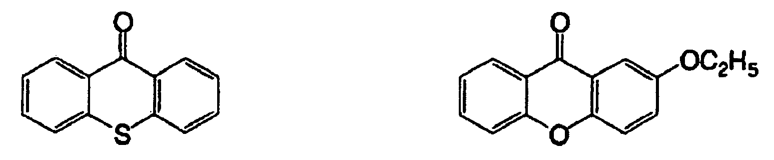

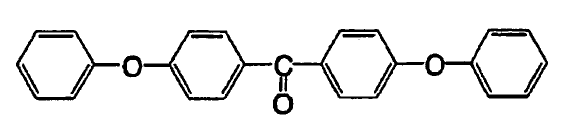

Among them, particularly preferable examples of the aromatic ketone (a) include α-thiobenzophenone compounds described in JP-B-47-6416, and benzoin ether compounds described in JP-B-47-3981, specifically, for example, the following compound: 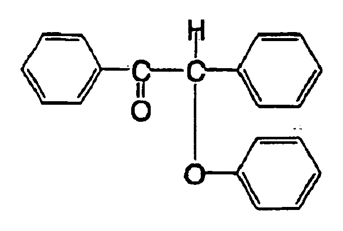 α -substituted benzoin compounds described in JP-B-47-22326, specifically, for example, the following compound: 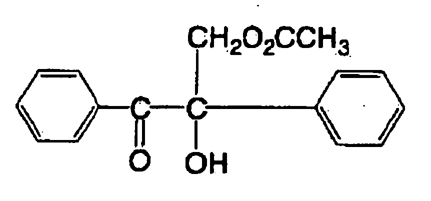 benzoin derivatives described in JP-B-47-23664, aroylphophonic esters described in JP-A-57-30704, and dialkoxybenzophenones described in JP-B-60-26483, specifically, for example, the following compound: 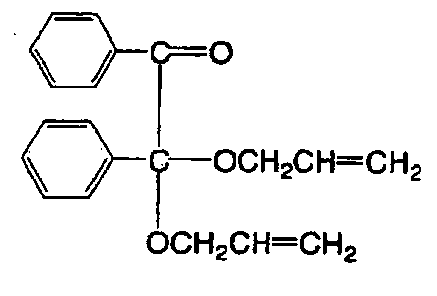 benzoin ethers described in JP-B-60-26403 and JP-A-62-81345, specifically, for example, the following compound: 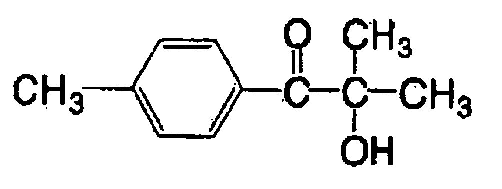 α -aminobenzophenones described in JP-B-1-34242, U.S. Patent 4,318,791 and European Patent 284,561A1, specifically, for example, the following compound: 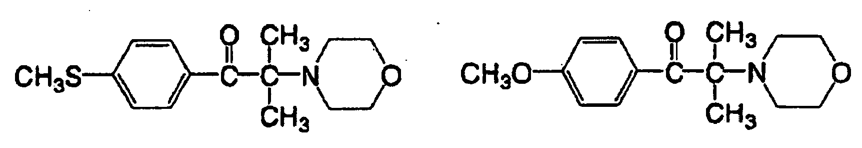 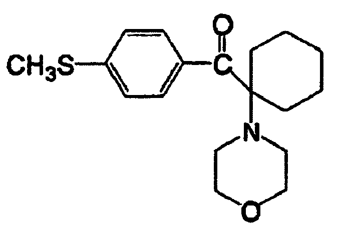 p-di(dimethylaminobenzoyl)benzene described in JP-A-2-211452, specifically, for example, the following compound: 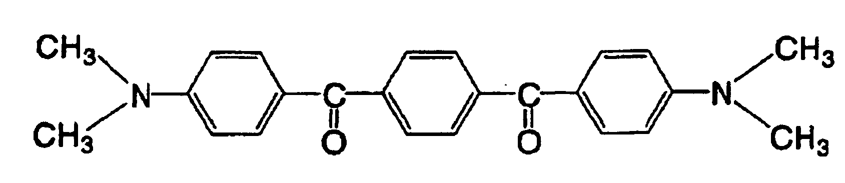 thio-substituted aromatic ketones described in JP-A-61-194062, specifically, for example, the following compound: 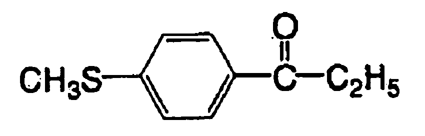 acylphosphinesulfides described in JP-B-2-9597, specifically, for example, the following compound: 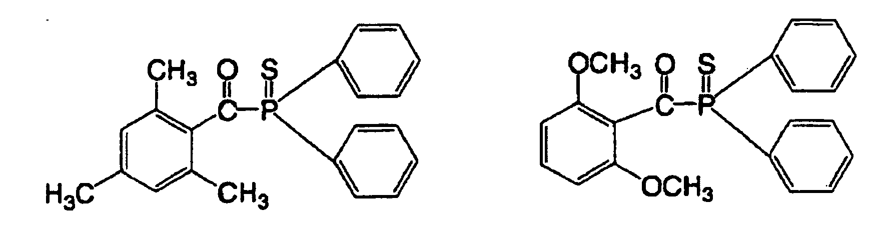 acylphosphines described in JP-B-2-9596, specifically, for example, the following compound:

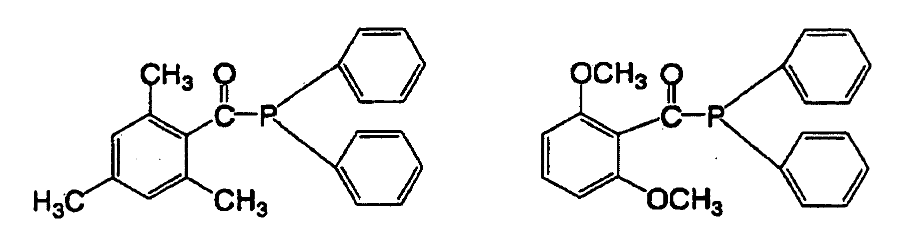

Also, thioxantones described in JP-B-63-61950, and coumarins described in JP-B-59-42864 are exemplified.

### (b) Onium salt compound

The onium salt compound (b) preferably used as the radical initiator in the invention includes compounds represented by the following formulae (1) to (3):

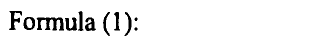

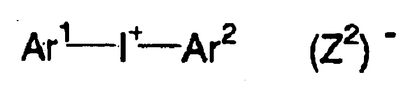

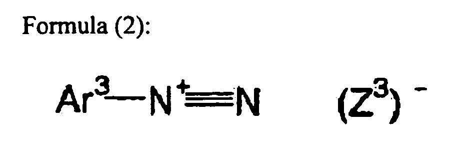

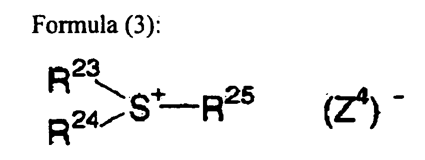

In formula (1), Ar¹ and Ar² each independently represent an aryl group having not more than 20 carbon atoms, which may have a substituent. When the aryl group has a substituent, preferred example of the substituent include a halogen atom, a nitro group, an alkyl group having not more than 12 carbon atoms, an alkoxy group having not more than 12 carbon atoms and an aryloxy group having not more than 12 carbon atoms. (Z²)⁻ represents a counter ion selected from the group consisting of a halogen ion, a perchlorate ion, a tetrafluoroborate ion, a hexafluorophosphate ion and a sulfonate ion, and is preferably a perchlorate ion, a hexafluorophosphate ion and an arylsulfonate ion.

In formula (2), Ar³ represents an aryl group having not more than 20 carbon atoms, which may have a substituent. Preferred example of the substituent include a halogen atom, a nitro group, an alkyl group having not more than 12 carbon atoms, an alkoxy group having not more than 12 carbon atoms, an aryloxy group having not more than 12 carbon atoms, an alkylamino group having not more than 12 carbon atoms, a dialkylamino group having not more than 12 carbon atoms, an arylamino group having not more than 12 carbon atoms or a diarylamino group having not more than 12 carbon atoms. (Z³)⁻ represents a counter ion having the same meaning as defined for (Z²)⁻.

In formula (3), R²³, R²⁴ and R²⁵, which may be the same or different, each independently represent a hydrocarbon group having not more than 20 carbon atoms, which may have a substituent. Preferred example of the substituent include a halogen atom, a nitro group, an alkyl group having not more than 12 carbon atoms, an alkoxy group having not more than 12 carbon atoms and an aryloxy group having not more than 12 carbon atoms. (Z⁴)⁻ represents a counter ion having the same meaning as defined for (Z²)⁻.

Specific examples of the onium salt preferably used in the invention include those described in paragraphs [0030] to [0033] of JP-A-2001-133969 and paragraphs [0015] to [0046] of JP-A-2001-343742 proposed by the applicant and specific aromatic sulfonium salt compounds described in Japanese Patent Application No. 2000-266797, JP-A-2002-148790, JP-A-2001-343742, JP-A-2002-6482, JP-A-2002-116539, JP-A-2004-102031 and Japanese Patent Application No. 2002-366539 proposed by the applicant.

The onium salt used in the invention has the maximum absorption wavelength preferably not longer than 400 nm, and more preferably not longer than 360 nm. By specifying the absorption wavelength in the ultraviolet region as described above, the lithographic printing plate precursor can be handled under white light.

### (c) Organic peroxide

The organic peroxide (c) preferably used as the radical initiator in the invention includes almost all organic compounds having at least one oxygen-oxygen bond in the molecules thereof. Specific examples of the organic peroxide include methyl ethyl ketone peroxide, cyclohexanone peroxide, 3,3,5-trimethylcyclohexanone peroxide, methylcyclohexanone peroxide, acetylacetone peroxide, 1,1-bis(tert-butylperoxy)-3,3,5-trimethylcyclohexane, 1, 1-bis(tert-butylperoxy)cyclohexane, 2,2-bis(tert-butylperoxy)butane, tert-butylhydroperoxide, cumene hydroperoxide, diisopropylbenzene hydroperoxide, paramethane hydroperoxide, 2,5-dimethylhexane-2,5-dihydroperoxide, 1,1,3,3-tetramethylbutyl hydroperoxide, di-tert-butyl peroxide, tert-butylcumyl peroxide, dicumyl peroxide, bis(tert-butylperoxyisopropyl)benzene, 2,5-dimethyl-2,5-di(tert-butylperoxy)hexane, 2,5-xanoyl peroxide, succinic peroxide, benzoyl peroxide, 2,4-dichlorobenzoyl peroxide, methatoluoyl peroxide, diisopropylperoxy dicarbonate, di-2-ethylhexylperoxy dicarbonate, di-2-ethoxyethylperoxy dicarbonate, dimethoxyisopropylperoxy dicarbonate, di(3-methyl-3-methoxybutyl)peroxy dicarbonate, tert-butylperoxy acetate, tert-butylperoxy pivalate, tert-butylperoxy neodecanoate, tert-butylperoxy octanoate, tert-butylperoxy-3,5,5-trimethyl hexanoate, tert-butylperoxy laurate, tertiary carbonate, 3,3',4,4'-tetra(tert-butylperoxycarbonyl)benzophenone, 3,3',4,4'-tetra(tert-amylperoxycarbonyl)benzophenone, 3,3',4,4'-tetra(tert-hexylperoxycarbonyl)benzophenone, 3,3',4,4'-tetra(tert-octylperoxycarbonyl)benzophenone, 3,3',4,4'-tetra(cumylperoxycarbonyl)benzophenone, 3,3',4,4'-tetra(p-isopropylcumylperoxycarbonyl)benzophenone, carbonyl di(tert-butylperoxydihydrogen diphthalate) and carbonyl di(tert-hexylperoxydihydrogen diphthalate).

Of the organic peroxides, ester peroxides, for example, 3,3',4,4'-tetra(tert-butylperoxycarbonyl)benzophenone, 3,3',4,4'-tetra(tert-amylperoxycarbonyl)benzophenone, 3,3',4,4'-tetra(tert-hexylperoxycarbonyl)benzophenone, 3,3',4,4'-tetra(tert-octylperoxycarbonyl)benzophenone, 3,3',4,4'-tetra(cumylperoxycarbonyl)benzophenone, 3,3',4,4'-tetra(p-isopropylcumylperoxycarbonyl)benzophenone and di-tert-butyldiperoxy isophthalate are preferred.

### (d) Thio compound

The thio compound (d) preferably used as the radical initiator in the invention includes compounds represented by the following formula (4): 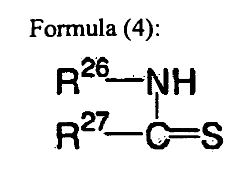 or

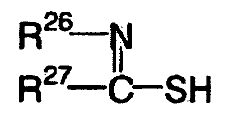

In formula (4), R²⁶ represents an alkyl group, an aryl group or a substituted aryl group. R²⁷ represents a hydrogen atom or an alkyl group. Alternatively, R²⁶ and R²⁷ combine with each other and together represent a non-metallic atomic group necessary for forming a 5-membered, 6-membered or 7-membered ring, which may contain a hetero atom selected from an oxygen atom, a sulfur atom and a nitrogen atom.

The alkyl group in formula (4) is preferably that having from 1 to 4 carbon atoms. The aryl group in formula (4) is preferably that having from 6 to 10 carbon atoms, for example, a phenyl group or a naphthyl group. The substituted aryl group includes the above-described aryl group substituted with, for example, a halogen atom, e.g., a chlorine atom, and an alkyl group, e.g., a methyl group, or an alkoxy group, e.g., a methoxy group or an ethoxy group. R²⁷ preferably represents an alkyl group having from 1 to 4 carbon atoms. Specific examples of the thio compound represented by formula (4) include the following compounds:

| **No.** | **R²⁶** | **R²⁷** |
|---|---|---|
| 1 | -H | -H |
| 2 | -H | -CH₃ |
| 3 | -CH₃ | -H |
| 4 | -CH₃ | -CH₃ |
| 5 | -C₆H₅ | -C₂H₅ |
| 6 | -C₆H₅ | -C₄H₉ |
| 7 | -C₆H₄Cl | -CH₃ |
| 8 | -C₆H₄Cl | -C₄H₉ |
| 9 | -C₆H₄-CH₃ | -C₄H₉ |
| 10 | -C₆H₄-OCH₃ | -CH₃ |
| 11 | -C₆H₄-OCH₃ | -C₂H₅ |
| 12 | -C₆H₄-OC₂H₅ | -CH₃ |
| 13 | -C₆H₄-OC₂H₅ | -C₂H₅ |
| 14 | -C₆H₄-OCH₃ | -C₄H₉ |
| 15 | -(CH₂)₂- | |
| 16 | -(CH₂)₂-S- | |
| 17 | -CH(CH₃)-CH₂-S- | |
| 18 | -CH₂-CH(CH₃)-S- | |
| 19 | -C(CH₃)₂-CH₂-S- | |
| 20 | -CH₂-C(CH₃)₂-S- | |
| 21 | -(CH₂)₂-O- | |
| 22 | -CH(CH₃)-CH₂-O- | |
| 23 | -C(CH₃)₂-CH₂-O- | |
| 24 | -CH=CH-N(CH₃)- | |
| 25 | -(CH₂)₃-S- | |
| 26 | -(CH₂)₂-CH(CH₃)-S- | |
| 27 | -(CH₂)₃-O- | |
| 28 | - (CH₂)₅- | |
| 29 | -C₆H₄-O- | |
| 30 | -N=C(SCH₃)-S- | |
| 31 | -C₆H₄-NH- | |
| 32 | 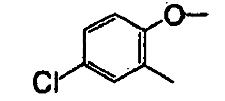 | |

### (e) Ketoxime ester compound

The ketoxime ester compound (e) preferably used as the radical initiator in the invention includes, for example, 3-benzoyloxyiminobutan-2-one, 3-acetoxyiminobutan-2-one, 3-propyonyloxyiminobutan-2-one, 2-acetoxyiminopentan-3-one, 2-acetoxyimino-1-phenylpropan-1-one, 2-benzoyloxyimino-1-phenylpropan-1-one, 3-p-toluenesulfonyloxyiminobutan-2-one and 2-ethoxycarbonyloxyimino-1-phenylpropan-1-one.

### (f) Borate compound

The borate compound (f) preferably used as the radical initiator in the invention includes compounds represented by the following formula (5):

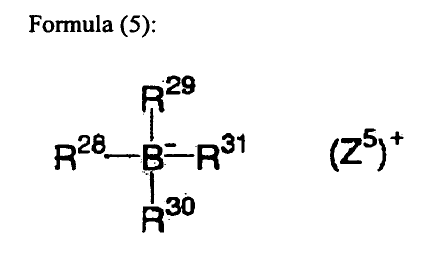

In formula (5), R²⁸, R²⁹, R³⁰ and R³¹, which may be the same or different, each represent a substituted or unsubstituted alkyl group, a substituted or unsubstituted aryl group, a substituted or unsubstituted alkenyl group, a substituted or unsubstituted alkynyl group or a substituted or unsubstituted heterocyclic group, or at least two of R²⁸, R²⁹, R³⁰ and R³¹ may be combined with each other to form a cyclic structure, provided that at least one of R²⁸, R²⁹, R³⁰ and R³¹ represents a substituted or unsubstituted alkyl group. (Z⁵)⁺ represents an alkali metal cation or a quaternary ammonium cation.

The alkyl group represented by any one of R²⁸ to R³¹ includes a straight-chain, branched or cyclic alkyl group, and preferably has from 1 to 18 carbon atoms. Specific examples thereof include a methyl group, an ethyl group, a propyl group, an isopropyl group, a butyl group, a pentyl group, a hexyl group, an octyl group, a stearyl group, a cyclobutyl group, a cyclopentyl group and a cyclohexyl group. The substituted alkyl group represented by any one of R²⁸ to R³¹ includes the above-described alkyl group substituted with a halogen atom (e.g., a chlorine atom or a bromine atom), a cyano group, a nitro group, an aryl group (e.g., a phenyl group), a hydroxy group, -COOR³² (wherein R³² represents a hydrogen atom, an alkyl group having from 1 to 14 carbon atoms or an aryl group) -OCOR³³ (wherein R³³ represents an alkyl group having from 1 to 14 carbon atoms or an aryl group), -OR³⁴ (wherein R³⁴ represents an alkyl group having from 1 to 14 carbon atoms or an aryl group) or a group represented by the following formula: 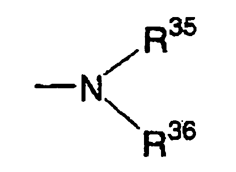 wherein R³⁵ and R³⁶ each represents a hydrogen atom, an alkyl group having from 1 to 14 carbon atoms or an aryl group.

The aryl group represented by any one of R²⁸ to R³¹ includes an aryl group having from one to three rings, for example, a phenyl group or a naphthyl group. The substituted aryl group represented by any one of R²⁸ to R³¹ includes the above-described aryl group substituted with the substituent described for the substituted alkyl group above or an alkyl group having from 1 to 14 carbon atoms. The alkenyl group represented by any one of R²⁸ to R³¹ includes a straight-chain, branched or cyclic alkenyl group having from 2 to 18 carbon atoms. In the substituted alkenyl group, the substituent includes the substituents described for the substituted alkyl group above. The alkynyl group represented by any one of R²⁸ to R³¹ includes a straight-chain, branched or cyclic alkynyl group having from 2 to 28 carbon atoms. In the substituted alkynyl group, the substituent includes the substituents described for the substituted alkyl group above. The heterocyclic group represented by any one of R²⁸ to R³¹ includes a 5-membered or more heterocyclic group, preferably a 5-membered, 6-membered or 7-membered heterocyclic group, containing at least one hetero atom selected from a nitrogen atom, a sulfur atom and an oxygen atom. The heterocyclic group may have a condensed ring. In the substituted heterocyclic group, the substituent includes the substituents described for the substituted aryl group above. Specific examples of the compound represented by formula (5) include compounds described in U.S. Patents 3,567,453 and 4,343,891, European Patents 109,772 and 109,773, and the following compounds:

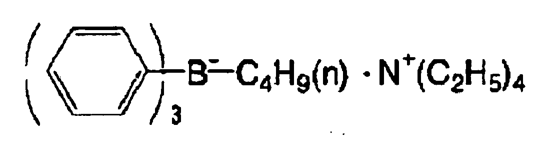

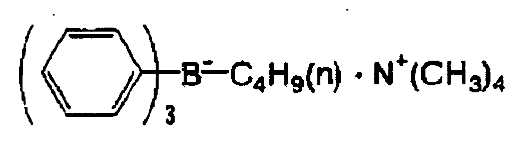

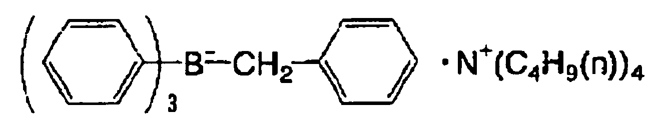

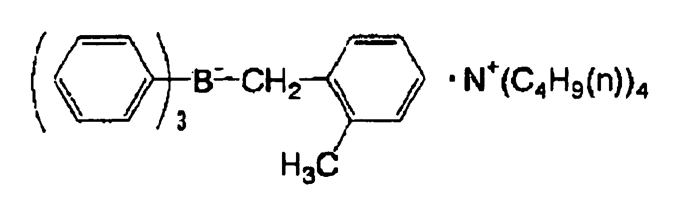

### (g) Azinium compound

The azinium compound (g) preferably used as the radical initiator in the invention includes compounds having an N-O bond described in JP-A-63-138345, JP-A-63-142345, JP-A-63-142346, JP-A-63-143537 and JP-B-46-42363.

### (h) Metallocene compound

The metallocene compound (h) preferably used as the radical initiator in the invention includes titanocene compounds described in JP-A-59-152396, JP-A-61-151197, JP-A-63-41484, JP-A-2-249 and JP-A-2-4705, and iron-arene complexes described in JP-A-1-304453 and JP-A-1-152109.

Specific examples of the titanocene compound include dicyclopentadienyl-Ti-dichloride, dicyclopentadienyl-Ti-biphenyl, dicyclopentadienyl-Ti-bis-2,3,4,5,6-pentafluorophen-1-yl, dicyclopentadienyl-Ti-bis-2,3,5,6-tetrafluorophen-1-yl, dicyclopentadienyl-Ti-bis-2,4,6-trifluorophen-1-yl, dicyclopentadienyl-Ti-bis-2,6-difluorophen-1-yl, dicyclopentadienyl-Ti-bis-2,4-difluorophen-1-yl, dimethylcyclopentadienyl-Ti-bis-2,3,4,5,6-pentafluorophen-1-yl, dimethylcyclopentadienyl- Ti-bis-2,3,5,6-tetrafluorophen-1-yl, dimethylcyclopentadienyl-Ti-bis-2,4-difluorophen-1-yl, bis(cyclopentadienyl)bis[2,6-difluoro-3-(pyr-1-yl)phenyl]titanium, bis(cyclopentadienyl)bis[2,6-difluoro-3-(methylsulfonamido)phenyl]titanium, bis(cyclopentadienyl)bis[2,6-difluoro-3-(N-butylpivaloylamino)phenyl]titanium, bis(cyclopentadienyl)bis[2,6-difluoro-3-(N-butyl-(4-chlorobenzoyl)amino)phenyl]titan ium,
bis(cyclopentadienyl)bis[2,6-difluoro-3-(N-benzyl-2,2-dimethylpentanoylamino)pheny 1]titanium, bis(cyclopentadienyl)bis[2,6-difluoro-3-(N-(2-ethylhexyl)-4-tolylsulfonylamino)pheny l]titanium, bis(cyclopentadienyl)bis[2,6-difluoro-3-(N-(3-oxaheptyl)benzoylamino)phenyl]titaniu m, bis(cyclopentadienyl)bis[2,6-difluoro-3-(N-(3,6-dioxadecyl)benzoylamino)phenyl]tita nium, bis(cyclopentadienyl)bis[2,6-difluoro-3-(trifluoromethylsulfonylamino)phenyl]titaniu m, bis(cyclopentadienyl)bis[2,6-difluoro-3-(trifluoroacetylamino)phenyl]titanium, bis(cyclopentadienyl)bis[2,6-difluoro-3-(2-chlorobenzoylamino)phenyl]titaniurn, bis(cyclopentadienyl)bis[2,6-difluoro-3-(4-chlorobenzoylamino)phenyl]titanium, bis(cyclopentadienyl)bis[2,6-difluoro-3-(N-(3,6-dioxadecyl)-2,2-dimethylpentanoylam ino)phenyl]titanium, bis(cyclopentadienyl)bis[2,6-difluoro-3-(N-(3,7-dimethyl-7-methoxyoctyl)benzoylami no)phenyl]titanium and bis(cyclopentadienyl)bis[2,6-difluoro-3-(N-cyclohexylbenzoylamino)phenyl]titanium.

### (i) Active ester compound

The active ester compound (i) preferably used as the radical initiator in the invention includes imidosulfonate compounds described in JP-B-62-6223, and active sulfonates described in JP-B-63-14340 and JP-A-59-174831.

### (j) Compound having a carbon-halogen bond

The compound having a carbon-halogen bond (j) preferably used as the radical initiator in the invention includes the compounds represented by the following formulae (6) to (12):

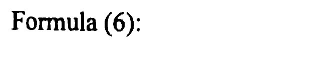

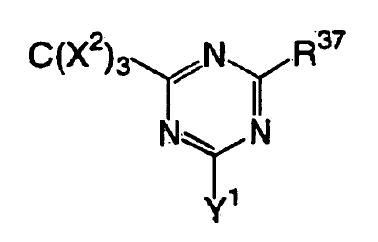

In formula (6), X² represents a halogen atom; Y' represents -C(X²)₃, -NH₂, -NHR³⁸, -N(R³⁸)₂ or -OR³⁸; R³⁸ represents an alkyl group, a substituted alkyl group, an aryl group or a substituted aryl group; and R³⁷ represents -C(X²)₃, an alkyl group, a substituted alkyl group, an aryl group, a substituted aryl group, an alkenyl group or a substituted alkenyl group.

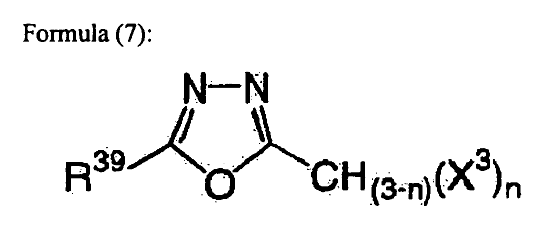

In formula (7), R³⁹ represents an alkyl group, a substituted alkyl group, an alkenyl group, a substituted alkenyl group, an aryl group, a substituted aryl group, a halogen atom, an alkoxy group, a substituted alkoxy group, a nitro group or a cyano group; X³ represents a halogen atom; and n represents an integer of from 1 to 3.

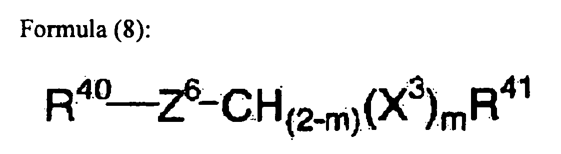

In formula (8), R⁴⁰ represents an aryl group or a substituted aryl group; R⁴¹ represents a group shown below or a halogen atom; Z⁶ represents -C(=O)-, -C(=S)- or -SO₂-; X³ represents a halogen atom; and m represents 1 or 2. 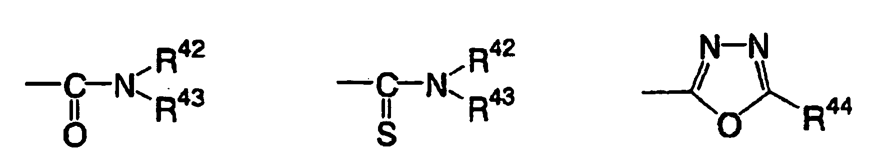 wherein R⁴² and R⁴³ each represent an alkyl group, a substituted alkyl group, an alkenyl group, a substituted alkenyl group, an aryl group or a substituted aryl group; and R⁴⁴ has the same meaning as defined for R³⁸ in formula (6).

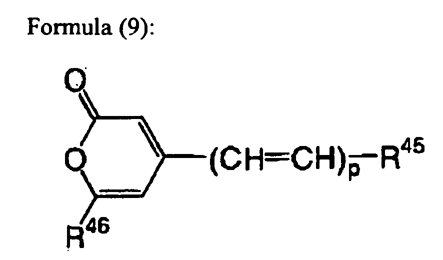

In formula (9), R⁴⁵ represents an aryl group which may be substituted or a heterocyclic group which may be substituted; R⁴⁶ represents a trihaloalkyl group or trihaloalkenyl group each having from 1 to 3 carbon atoms; and p represents 1, 2 or 3.

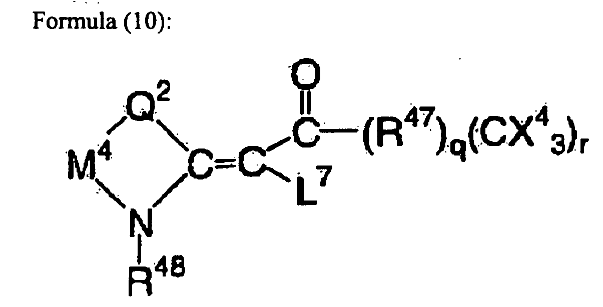

In formula (10), which represents a carbonylmethylene heterocyclic compound having a trihalogenomethyl group, L⁷ represents a hydrogen atom or a group represented by formula -CO-(R⁴⁷)_{q}(C(X⁴)₃)ᵣ; Q represents a sulfur atom, a selenium atom, an oxygen atom, a dialkylmethylene group, an alken-1,2-ylene group, a 1,2-phenylene group or -N(-R⁴⁸)-; M⁴ represents a substituted or unsubstituted alkylene group, a substituted or unsubstituted alkenylene group or a 1,2-arylene group; R⁴⁸ represents an alkyl group, an aralkyl group or an alkoxyalkyl group; R⁴⁷ represents a divalent carbocyclic or heterocyclic aromatic group; X⁴ represents a chlorine atom, a bromine atom or an iodine atom; q represents 0 or 1; and r represents 1 or 2, provided that when q represents 0, r represents 1, and when q represents 1, r represents 1 or 2.

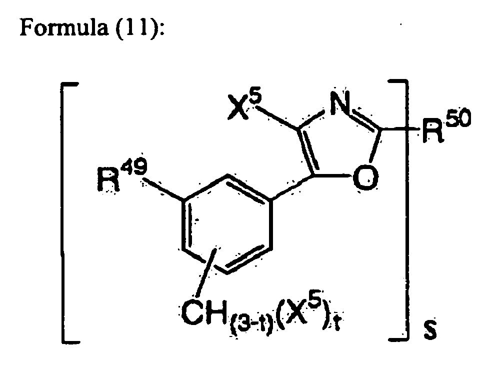

In formula (11), which represents a 4-halogeno-5-(halogenomethylphenyl)oxazole derivative, X⁵ represents a halogen atom, t represents an integer of from 1 to 3; s represents an integer of from 1 to 4; R⁴⁹ represents a hydrogen atom or -CH₃₋ₜX⁵ₜ; and R⁵⁰ represents an s-valent unsaturated organic residue, which may be substituted.

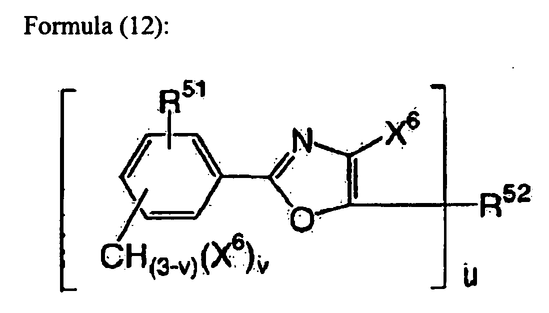

In formula (12), which represents a 2-(halogenomethylphenyl)-4-halogenooxazole derivative, X⁶ represents a halogen atom, v represents an integer of from 1 to 3; u represents an integer of from 1 to 4; R⁵¹ represents a hydrogen atom or -CH₃₋ᵥX⁶ᵥ; and R⁵² represents an u-valent unsaturated organic residue, which may be substituted.

Specific examples of the compound having a carbon-halogen bond include compounds described in Wakabayashi et al., Bull. Chem. Soc. Japan, Vol. 42, page 2924 (1969), for example, 2-phenyl-4,6-bis(trichloromethyl)-S-triazine, 2-(p-chlorophenyl)-4,6-bis(trichloromethyl)-S-triazine, 2-(p-tolyl)-4,6-bis(trichloromethyl)-S-triazine, 2-(p-methoxyphenyl)-4,6-bis(trichloromethyl)-S-triazine, 2-(2',4'-dichlorophenyl)-4,6-bis(trichloromethyl)-S-triazine, 2,4,6-tris(trichloromethyl)-S-triazine, 2-methyl-4,6-bis(trichloromethyl)-S-triazine, 2-n-nonyl-4,6-bis(trichloromethyl)-S-triazine and 2-(α,α,β-trichloroethyl)-4,6-bis(trichloromethyl)-S-triazine; compounds described in British Patent 1,388,492, for example, 2-styryl-4,6-bis(trichloromethyl)-S-triazine, 2-(p-methylstyryl)-4,6-bis(trichloromethyl)-S-triazine, 2-(p-methoxylstyryl)-4,6-bis(trichloromethyl)-S-triazine and 2-(p-methoxylstyryl)-4-amino-6-trichloromethyl-S-triazine; and compounds described in JP-A-53-133428, for example, 2-(4-methoxynaphth-1-yl)-4,6-bis(trichloromethyl)-S-triazine, 2-(4-ethoxynaphth-1-yl)-4,6-bis(trichloromethyl)-S-triazine, 2-[4-(2-ethoxyethyl)naphth-1-yl]-4,6-bis(trichloromethyl)-S-triazine, 2-(4,7-dimethoxynaphth-1-yl)-4,6-bis(trichloromethyl)-S-triazine and 2-(acenaphth-5-yl)-4,6-bis(trichloromethyl)-S-triazine; compounds described in German Patent 3,337,024, for example, the following compounds:

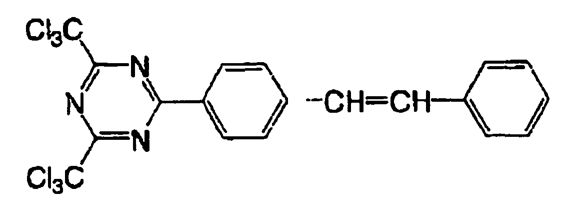

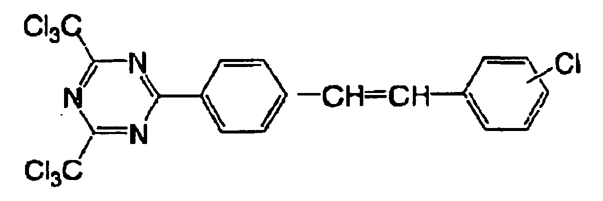

Specific examples of the compound having a carbon-halogen bond also include compounds described in F. C. Schaefer et al., J. Org. Chem., Vol. 29, page 1527 (1964), for example, 2-methyl-4,6-bis(tribromomethyl)-S-triazine, 2,4,6-tris(tribromomethyl)-S-triazine, 2,4,6-tris(dibromomethyl)-S-triazine, 2-amino-4-methyl-6-tribromomethyl-S-triazine and 2-methoxy-4-methyl-6-tribromomethyl-S-triazine; compounds described in JP-A-62-58241, for example, the following compounds:

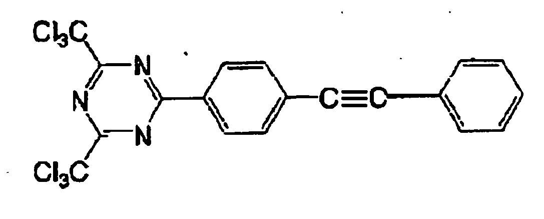

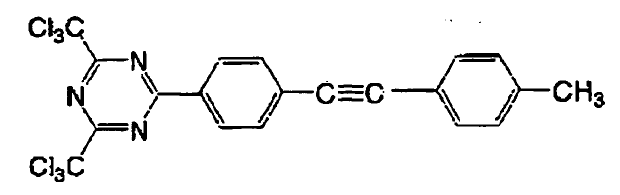

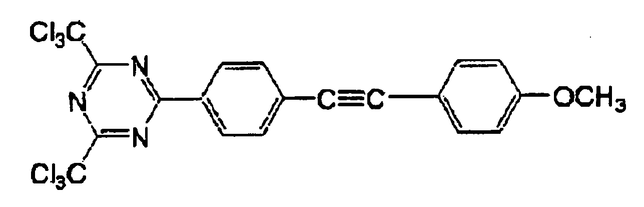

Further, they include compounds described in JP-A-5-281728, for example, the following compounds:

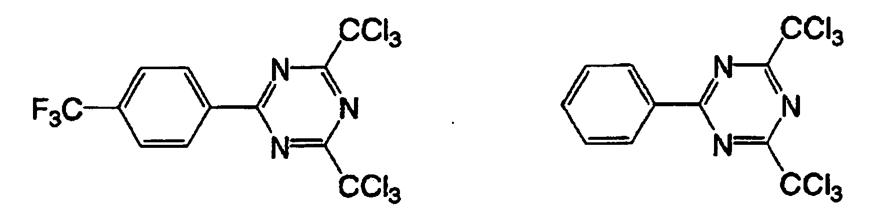

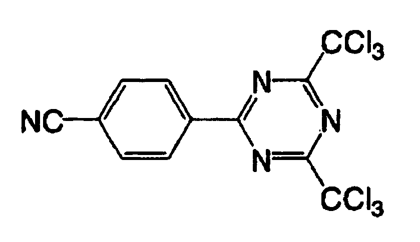

Moreover, they include compounds, which can be easily synthesized by one skilled in the art according to synthesis methods described in M. P. Hutt, E. F. Elslager and L. M. Herbel, Journal of Heterocyclic Chemistry, Vol. 7, No. 3, page 511 et seq. (1970), for example, the following compounds:

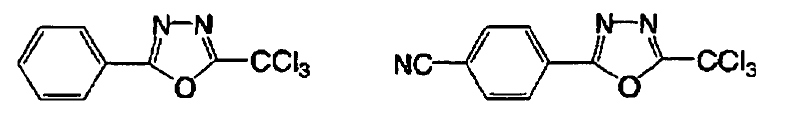

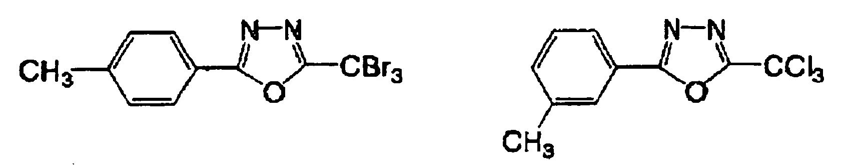

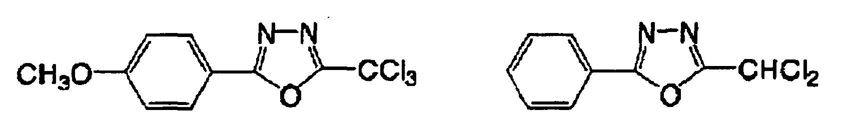

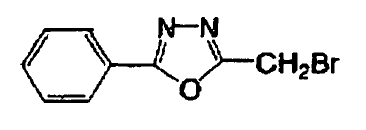

### (k) Azo compound

The azo compound (k) preferably used as the radical initiator in the invention includes, for example, 2,2'-azobisisobutyronitrile, 2,2'-azobisisopropionitrile, 1,1'-azobis(cyclohexane-1-caronitrile), 2,2'-azobis(2-methylbutyronitrile), 2,2'-azobis(2,4-dimethylvaleronitrile), 2,2'-azobis(4-methoxy-2,4-dimethylvaleronitrile), 4,4'-azobis(4-cyanovaleric acid), dimethyl 2,2'-azobisisobutyrate, 2,2'-azobis(2-methylpropionamidoxime), 2,2'-azobis[2-(2-imidazolin-2-yl)propane], 2,2'-azobis{2-methyl-N-[1,1-bis(hydroxymethyl)-2-hydroxyethyl]propionamide}, 2,2'-azobis[2-methyl-N-(2-hydroxyethyl)propionamide], 2,2'-azobis(N-butyl-2-methylpropionamide), 2,2'-azobis(N-cyclohexyl-2-methylpropionamide), 2,2'-azobis(N-(2-propenyl)-2-methylpropionamide) and 2,2'-azobis(2,4,4-trimethylpentane).

More preferable examples of the radical initiator for use in the invention include (a) aromatic ketones, (b) onium salt compounds, (c) organic peroxides, (h) metalocene compounds, and (j) compounds having a carbon-halogen bond. Most preferable examples thereof include aromatic iodonium salts, aromatic sulfonium salts, titanocene compounds, and trihalomethyl-S-triazine compounds represented by formula (6).

The co-initiators (E-2) may be employed individually or in combination of two or more thereof. The co-initiator can be used preferably in an amount from 0.1 to 50% by weight, more preferably from 0.5 to 30% by weight, particularly preferable from 5 to 20% by weight, based on the total solid content of the photosensitive composition according to the invention.

### (E-3) Thermal polymerization inhibitor

It is preferable that a thermal polymerization inhibitor is added to the photosensitive composition according to the invention in order to prevent undesirable thermal polymerization of the compound having a polymerizable ethylenically unsaturated bond included in the photosensitive composition during the production and preservation of the photosensitive composition or an image-recording material to which the photosensitive composition is applied.

As the thermal polymerization inhibitor suitable for use in the invention, a compound selected from the group consisting of a compound containing a phenolic hydroxy group, an N-oxide compound, a piperidine-1-oxyl free radical compound, a pyrrolidine-1-oxyl free radical compound, an N-nitrosophenyl hydroxylamine, a diazonium compound and a cationic dye is preferable.

Among them, it is more preferable that the compound containing a phenolic hydroxy group is selected from the group consisting of hydroquinone, p-methoxyphenol, di-tert-butyl-p-cresol, pyrogallol, tert-butylcatechol, benzoquinone, 4,4-thiobis(3-methyl-6-tert-butylphenol), 2,2'-methylenebis(4-methyl-6-tert-butylphenol), a phenol resin and a cresol resin; the N-oxide compound is selected from the group consisting of 5,5-dimethyl-1-pyrrolin-N-oxide, 4-methylmorpholine-N-oxide, pyridine-N-oxide, 4-nitropyridine-N-oxide, 3-hydroxypyridine-N-oxide, picolinic acid-N-oxide, nicotinic acid-N-oxide and isonicotinic acid-N-oxide; the piperidine-1-oxyl free radical compound is selected from the group consisting of piperidine-1-oxyl free radical, 2,2,6,6-tetramethylpiperidine-1-oxyl free radical, 4-oxo-2,2,6,6-tetramethylpiperidine-1-oxyl free radical, 4-hydroxy-2,2,6,6-tetramethylpiperidine-1-oxyl free radical, 4-acetamido-2,2,6,6-tetramethylpiperidine-1-oxyl free radical, 4-maleimido-2,2,6,6-tetramethylpiperidine-1-oxyl free radical and 4-phophonoxy-2,2,6,6-tetramethylpiperidine-1-oxyl free radical; the pyrrolidine-1-oxyl free radical compound is 3-carboxyproxyl free radical (3-carboxy-2,2,5,5-tetramethyl pyrrolidine-1-oxyl free radical); the N-nitrosophenyl hydroxylamine is a compound selected from the group consisting of N-nitrosophenylhydroxylamine primary cerium salt and N-nitrosophenylhydroxylamine aluminum salt; the diazonium compound is a compound selected from the group consisting of hydrogen sulfate of 4-diazophenyldimethylamine, tetrafluoroborate of 4-diazophenyldimethylamine and hexafluorophsphate of 3-methoxy-4-diazophenyldimethylamine; and the cationic dye is a compound selected from the group consisting of Crystal Violet, Methyl Violet, Ethyl Violet and Victoria Pure Blue BOH.

Further, in view of preventing a side reaction caused by the thermal polymerization inhibitor at the synthesis, it is most preferable to use benzoquinone and its derivatives, more specifically, a 1,4-benzoquinine derivative.

An amount of the thermal polymerization inhibitor (E-3) included in the photosensitive composition according to the invention is preferably from 0.01 to 10,000 ppm, more preferably from 0. 1 to 5,000 ppm, most preferably from 0.5 to 3,000 ppm, based on the total weight of the photosensitive composition.

### (E-4) Coloring agent

Further, when the photosensitive composition according to the invention is used in a lithographic printing plate precursor, a dye or pigment may be added for the purpose of coloring the photosensitive layer thereof. By the addition of coloring agent, a lithographic printing plate can be improved in a so-called plate inspection property, for example, visibility after the plate-making or aptitude for an image density measurement apparatus. The coloring agent used is preferably a pigment because many dyes are apt to cause reduction in sensitivity of the photosensitive layer. Specific examples of the coloring agent include pigments, for example, a phthalocyanine pigment, an azo pigment, carbon black or titanium oxide, and dyes, for example, Ethyl Violet, Crystal Violet, an azo dye, an anthraquinone dye or a cyanine dye. An amount of the coloring agent added is preferably from about 0.5 to about 5% by weight based on the total amount of the photosensitive composition.

### (E-5) Other additives

Moreover, when the photosensitive composition according to the invention is used in a lithographic printing plate precursor, known additives, for example, an inorganic filler or a plasticizer for improving physical properties of the hardened layer or an oil-sensitizing agent capable of improving an ink-receptive property on the surface of photosensitive layer may also be added to the photosensitive composition.

Examples of the plasticizer include dioctyl phthalate, didodecyl phthalate, triethylene glycol dicaprylate, dimethyl glycol phthalate, tricresyl phosphate, dioctyl adipate, dibutyl sebacate and triacetyl glycerin. When a binder is used, the plasticizer may be added in an amount of not more than 10% by weight based on the total amount of the compound having an ethylenically unsaturated double bond and the binder.

Further, an UV initiator, a thermal crosslinking agent or the like may also be added in order to enforce the effect of heating and/or light exposure treatment after development described hereinafter conducting for the purpose of improving the film strength (printing durability).

In addition, in order to improve adhesion between the photosensitive layer and a support or to increase removability of the unexposed area of the photosensitive layer by development, an additive may be added or an interlayer may be provided. For instance, by the addition or undercoating of a compound having relatively strong interaction with the support, for example, a compound having a diazonium structure or a phosphone compound, the adhesion to the support is improved, thereby increasing the printing durability. On the other hand, by the addition or undercoating of a hydrophilic polymer, for example, polyacrylic acid or polysulfonic acid, the developing property of the non-image area is improved, thereby increasing resistance to stain.

When the photosensitive composition according to the invention is used as the photosensitive layer of a lithographic printing plate precursor, from the standpoint of the sensitivity and preservation stability, an initiation system comprising the compound represented by formula (XVIII) as the sensitizing dye, the hexaarylbiimidazole compound as an initiator compound and the compound represented by formula (I) is preferable, and an embodiment comprising such an initiation system and the polymerizable compound (D) having an ethylenically unsaturated double bond is particularly preferable.

### (Formation of image-recording material)

Various image-recording materials to which the photosensitive composition according to the invention is applied can be produced by dissolving the above-described constituting components in an appropriate organic solvent and coating the resulting solution on a support.

Examples of the organic solvent used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate and ethyl lactate. The solvents may be used individually or as a mixture of two or more thereof. The concentration of solid content in the coating solution is suitably from 2 to 50% by weight.

It is desirable that the coating amount of the photosensitive composition on the support be appropriately determined depending on the use taking influences on the sensitivity and developing property of the photosensitive layer, the strength of the exposed layer, the printing durability and the like into consideration. When the coating amount is too small, the printing durability is not sufficient, whereas when it is excessively large, the sensitivity decreases and as a result, not only that it takes a long time to perform the exposure but also the development processing disadvantageously requires longer time. In the case of a lithographic printing plate precursor for scanning exposure, which is one of the preferable embodiments of the photosensitive composition according to the invention, the coating amount of the photosensitive layer thereof is preferably from about 0.1 to about 10 g/m², more preferably from 0.5 to 5 g/m², in terms of the weight after drying.

### (Support)

As the support of the image-recording material to which the photosensitive composition according to the invention is applied, various supports can be utilized without limitation depending on the use, and conventionally known hydrophilic supports used for lithographic printing plate precursors are preferably used.

The support used is preferably a dimensionally stable plate-like material, for example, paper, paper laminated with plastic (e.g., polyethylene, polypropylene or polystyrene), a metal plate (e.g., aluminum, zinc or copper), a plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal) and paper or a plastic film having laminated with or vapor-deposited thereon the above-described metal. If desired, the surface of the support may be subjected to an appropriate known physical or chemical treatment for the purpose of imparting hydrophilicity, increasing strength or the like.

Preferable examples of the support include paper, a polyester film and an aluminum plate. Among them, the aluminum plate is particularly preferred, because it has good dimensional stability, is relatively inexpensive and can provide a surface having excellent hydrophilicity and strength with a surface treatment as needed. Also, a composite sheet comprising a polyethylene terephthalate film having bonded thereon an aluminum sheet described in JP-B-48-18327 is preferred.

The aluminum plate is a dimensionally stable metal plate comprising aluminum as a main component, and is selected from a pure aluminum plate, an alloy plate comprising aluminum as a main component and containing trace of foreign elements and a plastic film or paper laminated with or having vapor-deposited thereon aluminum (or its alloy). In the description below, the support comprising aluminum or aluminum alloy described above is collectively referred to as an aluminum support. Examples of the foreign element contained in the aluminum alloy include silicon, iron, manganese, copper, magnesium, chromium, zinc, bismuth, nickel and titanium. The content of foreign element in the alloy is at most 10% by weight. Although a pure aluminum palate is preferable in the invention, an aluminum plate containing trace of foreign elements may be used, because perfectly pure aluminum is difficult to produce in view of the refining technique. The composition of the aluminum plate for use in the invention is not limited and aluminum plates comprising conventionally known and used materials, for example, JIS A 1050, JIS A 1100, JIS A 3103 or JIS A 3005 can be appropriately used.

The thickness of the aluminum support for use in the invention is approximately from 0.1 to 0.6 mm. The thickness can be appropriately adjusted depending upon the use of the photosensitive composition according to the invention. For instance, when the photosensitive composition according to the invention is applies to the lithographic printing plate precursor, the thickness can be appropriately changed depending upon the size of a printing machine, the size of a printing plate and the demand of user. The aluminum support may be subjected to a surface treatment for the support described hereinafter, if desired. Of course, the aluminum support may not be subjected to the surface treatment.

### <Surface roughening treatment>

The surface roughening treatment method includes a method of mechanically roughening the surface, a method of chemical etching and a method of electrolytic graining, as described in JP-A-56-28893. Further, there may be employed an electrochemically surface roughening method of electrochemically roughening the surface in an electrolytic solution of hydrochloric acid or nitric acid and a mechanically surface roughening method, for example, a wire brush graining method of scratching the aluminum surface with a metal wire, a ball graining method of graining the aluminum surface with graining balls and an abrasive and a brush graining method of roughening the aluminum surface with a nylon brush and an abrasive. The surface roughening methods may be employed individually or in combination thereof. Of the methods, the electrochemical method of chemically roughening the surface in an electrolytic solution of hydrochloric acid or nitric acid is an advantageous surface roughening method, and an appropriate anodic time electricity is in the range of 50 to 400 C/dm². More specifically, it is preferred to conduct alternating current and/or direct current electrolysis in an electrolytic solution containing from 0.1 to 50% by weight hydrochloric acid or nitric acid under the conditions from 20 to 80°C in temperature, 1 second to 30 minutes in time and 100 to 400 C/dm² in electric current density.

The thus surface-roughened aluminum support may be chemically etched with an acid or an alkali. The etching agent preferably used includes, for example, sodium hydroxide, sodium carbonate, sodium aluminate, sodium metasilicate, sodium phosphate, potassium hydroxide and lithium hydroxide. A preferable concentration is in the range of 1 to 50% by weight, and a preferred temperature is in the range of 20 to 100°C. Washing with an acid is conducted for removing stain (smut) remaining on the etched surface. Examples of the acid used include nitric acid, sulfuric acid, phosphoric acid, chromic acid, hydrofluoric acid and borohydrofluoric acid. As a specific method for removing the desmut after the electrochemically surface roughening treatment, there are illustrated a method of contacting the aluminum support with sulfuric acid from 50 to 90°C in temperature and from 15 to 65% by weight in concentration described in JP-A-53-12739 and a method of etching the aluminum support with an alkali described in JP-B-48-28123. The method and conditions are not particularly limited as long as the surface after the treatment has a center-line average roughness, Ra, of preferably from 0.2 to 0.5 µm.

### <Anodizing treatment>

The thus surface-roughened aluminum support is then preferably subjected to an anodizing treatment.

In the anodizing treatment, sulfuric acid, phosphoric acid, oxalic acid and an aqueous solution of boric acid/sodium borate are used individually or in combination of two or more thereof as the major component of an electrolytic bath. In this occasion, ingredients at least ordinarily contained in an aluminum alloy plate, electrodes, city water, ground water and the like may of course be contained in the electrolytic solution. Further, a second or a third component may be added. Examples of the second and third components include a cation, for example, an ion of metal, e.g., Na, K, Mg, Li, Ca, Ti, Al, V, Cr, Mn, Fe, Co, Ni, Cu or Zn or ammonium ion and an anion, for example, nitrate ion, carbonate ion, chloride ion, phosphate ion, fluoride ion, sulfite ion, titanate ion, silicate ion and borate ion. The ion is allowed to be contained in a concentration of approximately from 0 to 10,000 ppm. Although conditions of the anodizing treatment are not particularly limited, the treatment is preferably conducted by direct current or alternating current electrolysis of from 30 to 500 g/liter in concentration, from 10 to 70°C in treatment temperature and from 0.1 to 40 A/m² in electric current density. The thickness of the anodic oxide film formed is in the range of from 0.5 to 1.5 µm, preferably from 0.5 to 1.0 µm. It is preferred to select the treatment conditions so that the anodic oxide film formed on the support has a pore diameter of micropore from 5 to 10 nm and pore density from 8 x 10¹⁵ to 2 x 10¹⁶ per m².

For the hydrophilizing treatment of the surface of the support, well known methods can be applied. As a particularly preferable treatment, the hydrophilizing treatment, for example, with silicate or polyvinylphosphonic acid is conducted. Through the treatment, a hydrophilic film preferably having an element Si or P content from 2 to 40 mg/m², more preferably from 4 to 30 mg/m² is formed. The coating amount can be determined by fluorescent X-ray spectrometry.

The hydrophilizing treatment is carried out by immersing the aluminum support having an anodic oxide film formed thereon in an aqueous solution which contains from 1 to 30% by weight, preferably from 2 to 15% by weight, of an alkali metal silicate or polyvinylphosphonic acid and has pH at 25°C from 10 to 13, for example, at temperature of 15 to 80°C for a period of 0.5 to 120 seconds.

The alkali metal silicate for use in the hydrophilizing treatment includes, for example, sodium silicate, potassium silicate or lithium silicate. A hydroxide which may be used for increasing the pH of the aqueous solution of alkali metal silicate includes, for example, sodium hydroxide, potassium hydroxide or lithium hydroxide. If desired, an alkaline earth metal salt or a metal salt of Group IVB may be added to the treatment solution. Examples of the alkaline earth metal salt include nitrates, for example, calcium nitrate, strontium nitrate, magnesium nitrate or barium nitrate and other water-soluble salts, for example, sulfates, chlorides, phosphates, acetates, oxalates or borates. Examples of the metal salt of Group IVB include titanium tetrachloride, titanium trichloride, potassium titanium fluoride, potassium titanium oxalate, titanium sulfate, titanium tetraiodide, zirconyl chloride, zirconium dioxide, zirconium oxychloride, zirconium tetrachloride.

The alkaline earth metal salt and the metal salt of Group IVB may be used individually or in combination of two or more thereof. An amount of the salt used is preferably in a range from 0.01 to 10% by weight, more preferably in a range from 0.05 to 5.0% by weight. Further, silicate electrodeposition as described in U.S. Patent 3,658,662 is also effective. A surface treatment comprising combination of a support subjected to electrolytic graining as described in JP-B 46-27481, JP-A-52-58602 or JP-A-52-30503 with the above-described anodizing treatment and hydrophilizing treatment is also useful.

### (Intermediate layer)

In the image-recording material to which the photosensitive composition according to the invention is applied, an intermediate layer (also referred to as "undercoat layer") may be provided between the photosensitive layer (image-recording layer) and the support for the purpose of increasing the adhesion property therebetween and improving the stain resistance. Specific examples of the intermediate layer include those described, for example, in JP-B-50-7481, JP-A-54-72104, JP-A-59-101651, JP-A-60-149491, JP-A-60-232998, JP-A-3-56177, JP-A-4-282637, JP-A-5-16558, JP-A-5-246171, JP-A-7-159983, JP-A-7-314937, JP-A-8-202025, JP-A-8-320551, JP-A-9-34104, JP-A-9-236911, JP-A-9-269593, JP-A-10-69092, JP-A-10-115931, JP-A-10-161317, JP-A-10-260536, JP-A-10-282682, JP-A-11-84647 and Japanese Patent Application Nos. 8-225335, 8-270098, 9-195863, 9-195864, 9-89646, 9-106068, 9-183834, 9-264311, 9-127232, 9-245419, 10-127602, 10-170202, 11-36377, 11-165861, 11-284091 and 2000-14697 (JP-A-10-69092, JP-A-10-115931, JP-A-11-38635, JP-A-11-38629, JP-A-10-282645, JP-A-10-301262, JP-A-11-24277, JP-A-11-109641, JP-A-10-319600, JP-A-11-84674, JP-A-11-327152, JP-A-2000-10292, JP-A-2000-235254, JP-A-2000-352824, JP-A-2001-175001 and JP-A-2001-209170).

### (Protective layer)

When image-recording is conducted to the image-recording material to which the photosensitive composition according to the invention is applied, since the exposure is ordinarily performed in the atmosphere, it is preferable to provide a protective layer (also referred to as "overcoat layer") on the photosensitive layer. In particular, in the case of applying the photosensitive composition according to the invention to a lithographic printing plate precursor, it is a preferable embodiment to provide such a protective layer on the photosensitive layer. The protective layer prevents a low molecular weight compound, for example, oxygen or a basic substance present in the atmosphere, which inhibits the image-forming reaction initiated in the photosensitive layer upon the exposure, from permeating into the photosensitive layer, whereby the protective layer makes it possible to perform the exposure in the atmosphere. Accordingly, the characteristics required for the protective layer include to have low permeability of the low molecular weight compound, for example, oxygen, not to substantially impair transmission of light used for the exposure, to exhibit good adhesion to the photosensitive layer and to be easily removed in a developing step after the exposure.

Various investigations on the protective layer have been made and are described in detail, for example, in U.S. Patent 3,458,311 and JP-A-55-49729. The material which can be used in the protective layer is preferably, for example, a water-soluble polymer compound having relatively excellent crystallinity. Specifically, a water-soluble polymer, for example, polyvinyl alcohol, polyvinyl pyrrolidone, an acidic cellulose, gelatin, gum arabic and a polyacrylic acid are known. Among them, when polyvinyl alcohol is used as the main component, most excellent results can be obtained in view of fundamental characteristics, for example, an oxygen blocking property and a removability by development. The polyvinyl alcohol used for the protective layer may be partially substituted with an ester, an ether or an acetal as far as it contains the unsubstituted vinyl alcohol units sufficient for ensuring the necessary oxygen blocking property and water solubility. Similarly, the polyvinyl alcohol may partially have other copolymer component. In particular, a mixture of polyvinyl alcohol and polyvinyl pyrrolidone wherein an amount of the polyvinyl pyrrolidone is from 15 to 50% by weight is preferable in view of preservation stability.

Examples of the polyvinyl alcohol include those having a hydrolysis degree of 71 to 100% and a polymerization degree of 300 to 2,400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, produced by Kuraray Co., Ltd.

The components (selection of PVA, use of additives) and coating amount of the protective layer are determined by taking account of the oxygen blocking property, removability by development, fogging property, adhesion property and scratch resistance. In general, as the hydrolysis degree of PVA used is higher (as the unsubstituted vinyl alcohol unit content in the protective layer is higher) and as the layer thickness is larger, the oxygen blocking property becomes higher, which is advantageous in view of the sensitivity. However, when the oxygen blocking property is excessively increased, there arise problems, for example, in that an undesirable polymerization reaction takes place during the production or preservation of the lithographic printing plate precursor, or in that undesirable fogging or thickening of image lines is caused at the time of image exposure. The adhesion property to the photosensitive layer and scratch resistance are also important factors in view of handling of the lithographic printing plate precursor. More specifically, when a hydrophilic layer comprising a water-soluble polymer is laminated on an oleophilic polymerizable layer, peeling is liable to occur due to insufficient adhesion and the peeled part causes a defect, for example, hardening failure of the layer due to polymerization inhibition by oxygen.

To overcome such a problem, various proposals have been made with an attempt to improve the adhesion between these two layers. For instance, it is described in U.S. Patent Application Nos. 292,501 and 44,563 that the sufficient adhesion can be obtained by mixing from 20 to 60% by weight of an acrylic emulsion, a water-insoluble vinyl pyrrolidone-vinyl acetate copolymer or the like in a hydrophilic polymer mainly comprising a polyvinyl alcohol and laminating the mixture on the photosensitive layer. Every known such technique can be applied to the protective layer according to the invention. A coating method of the protective layer is described in detail, for example, in U.S. Patent 3,458,311 and JP-B-55-49729.

The image-recording material to which the photosensitive composition according to the invention is applied is subjected to at least processes of exposure and development to record an image thereon. In particular, when the photosensitive composition according to the invention is applied to a lithographic printing plate precursor, the lithographic printing plate precursor is subjected to plate-making by performing the processes of exposure and development in the manner described below, and, if desired, by performing other processes.

The plate-making method in the case where the photosensitive composition according to the invention is applied to the lithographic printing plate precursor is described in detail below.

AS a light source for exposing the lithographic printing plate precursor according to the invention, known light sources can be used without limitation. The wavelength of the light source is preferably from 300 nm and 1,200 nm, more preferably from 350 to 450 nm. Specifically, various lasers are preferably used as the light source. Among them, a short wavelength laser having a wavelength of 350 to 430 nm is preferably used.

The exposure mechanism may be any of an internal surface drum system, an external surface drum system and a flat bed system.

Further, other light sources which may also be used for exposure of the lithographic printing plate precursor according to the invention include various mercury lamp of ultrahigh pressure, high pressure, medium pressure or low pressure, chemical lamp, carbon arc lamp, xenon lamp, metal halide lamp, various laser lamp of visible region or ultraviolet region, fluorescent lamp, tungsten lamp and sunlight.

After the exposure to light, the lithographic printing plate precursor according to the invention is subjected to development processing. As a developer for use in the development processing, an aqueous alkali solution having pH of 14 or less is preferably used, and an aqueous alkali solution containing an anionic surfactant and having pH of 8 to 12 is more preferably used. For instance, an inorganic alkali agent, for example, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium hydrogencarbonate, potassium hydrogencarbonate, ammonium hydrogencarbonate, sodium borate, potassium borate, ammonium borate, sodium hydroxide, ammonium hydroxide, potassium hydroxide or lithium hydroxide can be used. Also, an organic alkali agent, for example, monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine or pyridine can be used. The alkali agents may be used individually or in combination of two or more thereof.

The developer for use in the development processing of the lithographic printing plate precursor according to the invention contains preferably from 1 to 20% by weight, more preferably from 3 to 10% by weight of an anionic surfactant. When the amount of the surfactant in the developer is too small, the developing property may be deteriorated. When it is too large, some problems may occur in that the strength, for example, abrasion resistance of the image formed decreases. Examples of the anionic surfactant include sodium salt of lauryl alcohol sulfate, ammonium salt of lauryl alcohol sulfate, sodium salt of octyl alcohol sulfate, salt of alkylarylsulfonic acid, for example, sodium salt of isopropylnaphthalenesulfonate, sodium salt of isobutylnaphthalenesulfonate, sodium salt of polyoxyethylene glycol mononaphthyl ether sulfate, sodium salt of dodecylbenzenesulfonate or sodium salt of metanitrobenzenesulfonate, sulfate of higher alcohol having from 8 to 22 carbon atoms, for example, secondary sodium alkylsulfate, salt of phosphate of aliphatic alcohol, for example, sodium salt of cetyl alcohol phosphate, sulfonate of alkylamide, for example, C₁₇H₃₃CON(CH₃)CH₂CH₂SO₃Na, sulfonate of dibasic aliphatic ester, for example, dioctyl sodium sulfosuccinate or dihexyl sodium sulfosuccinate.

If desired, an organic solvent miscible with water, for example, benzyl alcohol, may be added to the developer. The organic solvent has solubility in water of about 10% by weight or less, preferably 5% by weight or less. For example, such an organic solvent includes 1-phenylethanol, 2-phenylethanol, 3-phenylpropanol, 1,4-phenylbutanol, 2,2-phenylbutanol, 1,2-phenoxyethanol, 2-benzyloxyethanol, o-methoxybenzyl alcohol, m-methoxybenzyl alcohol, p-methoxybenzyl alcohol, benzyl alcohol, cyclohexanol, 2-methylcyclohexanol, 4-methylcyclohexanol and 3-methylcyclohexanol. The content of organic solvent in the developer is preferably from 1 to 5% by weight based on the total weight of the developer in use. The amount of the organic solvent in the developer has close relation to the amount of the surfactant therein. With the increase in the amount of the organic solvent therein, the amount of the anionic surfactant in the developer is preferably increased. This is because, when the amount of the organic solvent in the developer is increased while the amount of the anionic surfactant is small, the organic solvent is not dissolved in the developer and therefore good developing property can not be ensured.

If desired, the developer may contain other additive, for example, a defoaming agent or a water softener. Examples of the water softener include polyphosphate, for example, Na₂P₂O₇, Na₅P₃O₃, Na₃P₃O₉, Na₂O₄P(NaO₃P)PO₃Na₂ or Calgon (sodium polymethaphosphate), aminopolycarboxylic acid (for example, ethylenediaminetetraacetic acid, its potassium salt or its sodium salt, diethylenetriaminepentaacetic acid, its potassium salt or its sodium salt, triethylenetetraminehexaacetic acid, its potassium salt or its sodium salt, hydroxyethylethylenediaminetriacetic acid, its potassium salt or its sodium salt, nitrilotriacetic acid, its potassium salt or its sodium salt, 1,2-diaminocyclohexanetetraacetic acid, its potassium salt or its sodium salt, or 1,3-diamino-2-propanoltetraacetic acid, its potassium salt or its sodium salt), other polycarboxylic acid (for example, 2-phosphonobutanetricarboxylic acid-1,2,4, its potassium salt or its sodium salt, 2-phosphonobutanonetricarboxylic acid-2,3,4, its potassium salt or its sodium salt), organic phosphonic acid (for example, 1-phosphonoethanetricarboxylic acid-1,2,2, its potassium salt or its sodium salt, 1-hydroxyethane-1,1-diphosphonic acid, its potassium salt or its sodium salt, or aminotri(methylenephosphonic acid), its potassium salt or its sodium salt). The optimum amount of the water softener added to the developer varies depending on the hardness and the amount of hard water used, but in general, it is preferably from 0.01 to 5% by weight, more preferably from 0.01 to 0.5% by weight, based on the weight of the developer in use.

In case where the lithographic printing plate precursor is developed in an automatic developing machine, the developer will be fatigued in accordance with the amount of the processing, and a replenisher or a fresh developer may be supplied for restoring the processing ability of the developer. In such a case, the replenishment is preferably effected according to the method described in U.S. Patent 4,882,246. The developers described in JP-A-50-26601, JP-A-58-54341 and JP-B-56-39464, JP-B-56-42860 and JP-B-57-7427 are also preferred.

The lithographic printing plate precursor thus-subjected to development processing may be post-treated with washing water, a rinsing solution containing a surfactant or an oil-desensitizing solution containing gum arabic or a starch derivative, as described, for example, in JP-A-54-8002, JP-A-55-115045 and JP-A-59-58431. These treatments may be combined in any desired manner for the post-treatment of the lithographic printing plate precursor according to the invention.

In the plate-making process of the lithographic printing plate precursor according to the invention, if desired, the precursor is heated on the entire surface thereof before the exposure, during the exposure or between the exposure and the development. The heating produces various advantages in that it promotes the image formation reaction in the photosensitive layer, in that it improves the sensitivity and the printing durability, and in that it stabilizes the sensitivity. Further, for improving the image strength and the printing durability, it may be effective to treat the entire surface of the developed plate with post-heating or post-exposure.

Ordinarily, the heating before the development is effected preferably under a mild condition at 150°C or lower. When the temperature is too high, it may cause a problem of undesirable hardening reaction in the non-image area. On the other hand, the heating after development can be conducted under an extremely severe condition. Ordinarily, the heating temperature after the development is in a range from 200 to 500°C. When the heating temperature after the development is too low, sufficient effect for enhancing the image strength is not achieved. When it is too high, it may cause some problems in that the support is deteriorated and in that the image area is thermally decomposed.

The lithographic printing plate thus obtained through the treatments is mounted on an offset printing machine to perform printing of a large number of prints.

As a plate cleaner which may be used for removing stain on the printing plate at the printing, conventionally known plate cleaners for PS plate may be used. Examples thereof include CL-1, CL-2, CP, CN-4, CN, CG-1, PC-1, SR and IC (produced by Fuji Photo Film Co., Ltd.).

### EXAMPLES

The present invention will be described in more detail with reference to the following examples, but the invention should not be construed as being limited thereto.

### <Examples 1 to 16 Comparative Examples 1 to 5 and Reference Examples 1 and 2>

### (Preparation of support)

A 0.3 mm-thick aluminum plate was etched by immersing the plate in a 10% by weight aqueous sodium hydroxide solution at 60°C for 25 seconds, washed with running water, neutralized and cleaned with a 20% by weight aqueous nitric acid solution and then washed with water. The aluminum plate was then subjected to an electrolytic surface roughening treatment in a 1 % by weight aqueous nitric acid solution using an alternating current with a sinusoidal waveform at an anode time electricity of 300 coulomb/dm². Subsequently, the aluminum plate was immersed in a 1% by weight aqueous sodium hydroxide solution at 40°C for 5 seconds, immersed in a 30% by weight aqueous sulfuric acid solution at 60°C for 40 seconds to effect a desmut treatment, and then subjected to an anodizing treatment in a 20% by weight aqueous sulfuric acid solution for 2 minutes at a current density of 2 A/dm² to form an anodic oxide film having a thickness of 2.7 g/m². The surface roughness of the aluminum plate thus-treated was measured and found to be 0.3 µm (Ra value according to JIS B0601).

On the back surface of the aluminum plate thus-treated, a coating solution for backcoat layer shown below was coated by a bar coater and dried at 100°C for 1 minute, thereby preparing an aluminum support having provided thereon a backcoat layer having a coating amount after drying of 70 mg/m². The coating solution for backcoat layer was prepared using the sol-gel reaction solution shown below and the addition solution shown below in the following manner.

### Sol-Gel Reaction Solution

| | |
|---|---|
| Tetraethyl silicate | 50 parts by weight |
| Water | 20 parts by weight |
| Methanol | 15 parts by weight |
| Phosphoric acid | 0.05 parts by weight |

The above components were mixed and stirred, and heat generation was started within about 5 minutes. After the mixture was reacted for 60 minutes, the addition solution having the composition shown below was added thereto to prepare the coating solution for backcoat layer.

### Addition Solution

| | |
|---|---|
| Pyrogallol formaldehyde condensed resin | 4 parts by weight |
| (molecular weight: 2,000) | |
| Dimethyl phthalate | 5 parts by weight |
| Fluorine-based surfactant | 0.7 parts by weight |
| (N-butylperfluorooctane- sulfonamidoethyl acrylate/polyoxyethylene acrylate copolymer, molecular weight: 20,000) | |
| Methanol silica sol (produced by Nissan | 50 parts by weight |
| Chemical Industries, Ltd., methanol 30% by weight) | |
| Methanol | 800 parts by weight |

### (Formation of photosensitive layer)

On the aluminum support provided with the backcoat layer, a photosensitive composition having the constituents shown below was coated to have a dry coating amount of 1.3 g/m² and dried at 80°C for 2 minutes to form a photosensitive layer.

### Photosensitive Composition

| | |
|---|---|
| Addition-polymerizable compound (M-1) shown below | 2.0 g |
| Polyurethane resin binder (U-1) shown below Photopolymerization initiation system | 2.0 g |
| Sensitizing dye (compound shown in Table 1) | 0.06 g |
| Initiator (2,2'-bis(o-chlorophenyl)-4,4',5,5'-tetraphenylbiimidazole) | 0.15 g |
| Compound represented by formula (I) (compound shown in Table 1) | 0.15 g |

| | |
|---|---|
| Fluorine-based nonionic surfactant (F-780F) | 0.03 g |
| Thermal polymerization inhibitor (N-nitrosophenylhydroxylamine aluminum salt) | 0.01 g |
| Methyl ethyl ketone | 10 g |
| Propylene glycol monomethyl ether | 10 g |
| Pigment dispersion shown below | 1.0 g |

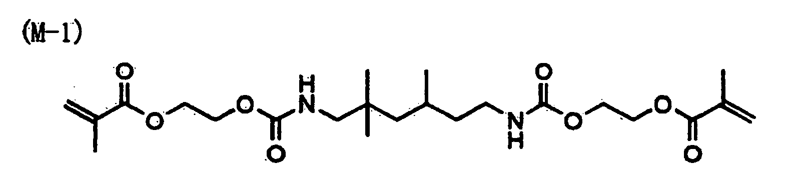

### Polyurethane resin binder (U-1)

Polyurethane resin of a condensation polymerization product of diisocyanates shown below with diols shown below:
4,4'-Diphenylmethanediisocyanate (MDI)
Hexamethylenediisocyanate (HMDI)
Polypropylene glycol (weight average molecular weight: 1,000) (PPG1000)
2,2'-Bis(hydroxymethyl)propionic acid (DMPA)
Glycerol monomethacrylate (Blenmer GLM, produced by NOF Corp.)
[copolymerization molar ratio: (MDI/HMDI/PPG1000/DMPA/Blenmer GLM = 80/20/22/52/26)]
Acid value actually determined by KOH titration: 0.96 meq/g
Weight average molecular weight determined by GPC measurement: 10.0 x 10⁴

### Composition of Pigment Dispersion

| | |
|---|---|
| Pigment Blue 15:6 | 15 parts by weight |
| Allyl methacrylate/methacrylic acid copolymer | 10 parts by weight |
| (copolymerization molar ratio: 83/17) | |
| Cyclohexanone | 15 parts by weight |
| Methoxypropyl acetate | 20 parts by weight |
| Propylene glycol monomethyl ether | 40 parts by weight |

### (Formation of protective layer)

On the photosensitive layer, an aqueous solution containing 3% by weight of polyvinyl alcohol (saponification degree: 98% by mole; polymerization degree: 550) was coated to have a dry coating weight of 2 g/m² and dried at 100°C for 2 minutes to form a protective layer, thereby preparing a lithographic printing plate precursor.

### [Evaluation of Sensitivity]

A Fuji Step Guide (a gray scale discontinuously changing in the transmission optical density at ΔD = 0.15, produced by Fuji Photo Film Co., Ltd.) was brought into close contact with the lithographic printing plate precursor thus-obtained, and exposure was performed using a xenon lamp through an optical filter in a known exposure energy amount. For the purpose of estimating the exposure aptitude for a short wavelength semiconductor laser, KENKO BP-40 was used as the optical filter to perform the exposure with monochromic light of 400 nm.

Thereafter, development was performed by immersing the exposed lithographic printing plate precursor in a developer having the composition shown below at 25°C for 15 seconds, and the sensitivity (unit: µJ/cm²) was calculated from the exposure energy value at the highest step number where the image was completely removed. As the exposure energy value is smaller, the sensitivity is higher. The results are shown in Table 1.

### [Evaluation of Preservation Stability]

A halftone dot area of 50% halftone dot set for drawing in the exposure machine and formed on the printing plate subjected to the evaluation of sensitivity described above was measured by ccDot produced by Centurfax Ltd. to obtain the measurement value X₀. On the other hand, the same lithographic printing plate precursor was preserved under high temperature condition (at 60°C) for 3 days and then subjected to the laser exposure in the same exposure amount and development processing in the same manner as described in the evaluation of sensitivity above. Thereafter, a halftone dot area of 50% halftone dot set for drawing in the exposure machine and formed on the printing plate was measured in the same manner as described above to obtain the measurement value X₃. The difference of these values (X₀ - X₃) was determined. As the value of (X₀ - X₃) is smaller, the preservation stability is better, and when the value is 5 or smaller, the preservation stability is good. The results obtained by the evaluation of preservation stability are also shown in Table 1.

### [Evaluation of Printing Durability]

### (Exposure of lithographic printing plate precursor)

The lithographic printing plate precursor obtained as described above was subjected to solid image exposure and halftone dot image exposure at 175 lines/inch increasing from 1 to 99% in 1% steps, using monochromatic light of 400 nm as a light source by adjusting the exposure power to give an exposure energy density of 100 µJ/cm² on the surface of lithographic printing plate precursor.

### (Development/Plate-making)

A developer having the composition shown below and Finisher FP-2W produced by Fuji Photo Film Co., Ltd. were charged into an automatic developing machine LP-850 produced by Fuji Photo Film Co., Ltd., and then the exposed lithographic printing plate precursor was subjected to development/plate-making under conditions of a developer temperature of 25°C and a development time of 15 seconds to obtain a lithographic printing plate.

### (Test of printing durability)

Printing was conducted using R201 produced by Roland Co. as a printing machine and GEOS-G (N) produced by Dainippon Ink & Chemicals, Inc. as ink. While continuing the printing, the solid image area of the printed material was observed and the printing durability was examined by a number of prints when the image started to become thin. The number of prints in Comparative Example 1 is relatively taken as 100. In comparison with this value, as the numeral is larger, the printing durability is better.

### Developer

Aqueous solution of pH 12.0 having the following composition:

| | |
|---|---|
| Potassium hydroxide | 0.2 g |
| 1K Potassium silicate (SiO₂/K₂O = 1.9) | 2.4 g |
| Compound shown below | 5.0 g |
| 4Na salt of ethylenediaminetetraacetate | 0.1 g |
| Water | 92.3 g |

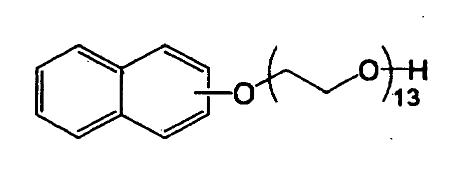

**TABLE 1**

| | Photopolymerization Initiation System | | Evaluation | | |
|---|---|---|---|---|---|
| | Compound of Formula (I) | Sensitizing Dye | Sensitivity (µJ/cm²) | Preservation Stability (X₀ - X₃) | Printing Durability of Image Area (Comparative Example 1 being taken as 100) |
| Reference Example 1 | A-1 | D-1 | 100 | 3.4 | 110 |
| Reference Example 2 | A-5 | D-1 | 105 | 3.8 | 110 |
| Example 1 | A-16 | D-1 | 75 | 3.6 | 120 |
| Example 2 | A-20 | D-1 | 70 | 3.5 | 125 |
| Example 3 | A-31 | D-1 | 65 | 3.4 | 140 |
| Example 4 | A-36 | D-1 | 60 | 3.4 | 150 |
| Example 5 | A-36 | D-2 | 65 | 3.3 | 145 |
| Example 6 | A-36 | D-3 | 65 | 3.3 | 145 |
| Example 7 | A-47 | D-1 | 55 | 4.2 | 150 |
| Example 8 | A-48 | D-1 | 55 | 4.3 | 155 |
| Example 9 | A-55 | D-1 | 50 | 4.5 | 155 |
| Example 10 | A-57 | D-2 | 50 | 4.5 | 150 |
| Example 11 | A-58 | D-3 | 50 | 4.4 | 150 |
| Example 12 | A-59 | D-1 | 80 | 3.5 | 130 |
| Example 13 | A-67 | D-1 | 60 | 3.6 | 140 |
| Example 14 | A-68 | D-1 | 55 | 3.8 | 150 |
| Example 15 | A-79 | D-1 | 60 | 3.7 | 135 |
| Example 16 | A-82 | D-1 | 60 | 3.7 | 130 |
| Comparative Example 1 | R-1 | D-1 | 125 | 3.3 | 100 |
| Comparative Example 2 | R-1 | D-2 | 130 | 3.4 | 95 |
| Comparative Example 3 | R-1 | D-3 | 130 | 3.4 | 95 |
| Comparative Example 4 | R-2 | D-1 | 120 | 3.5 | 100 |
| Comparative Example 5 | R-3 | D-1 | Fogged image | Fogged image | Fogged image |

>

The compounds of formula (I) according to the invention used in the photopolymerization initiation system of Table 1 are those described as the specific examples hereinbefore. The structures of Sensitizing Dyes (D-1) to (D-3) and the hexaarylbiimidazole compound are shown below. Comparative Compounds (R-1) to (R-3) used in the comparative examples having the structure shown below are compounds outside the scope of the invention. Sensitizing Dyes:

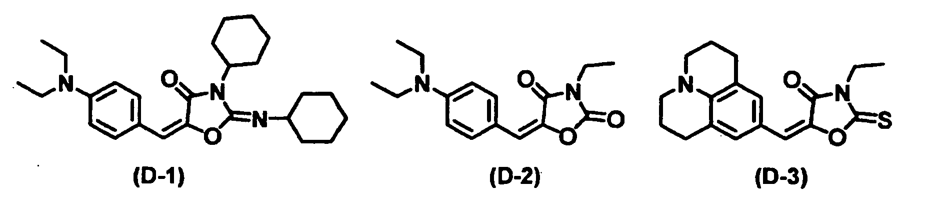

### Hexaarylbiimidazole Compound:

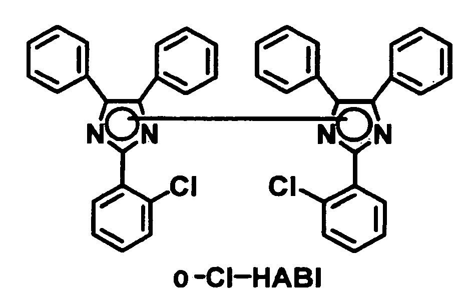

### Comparative Compounds:

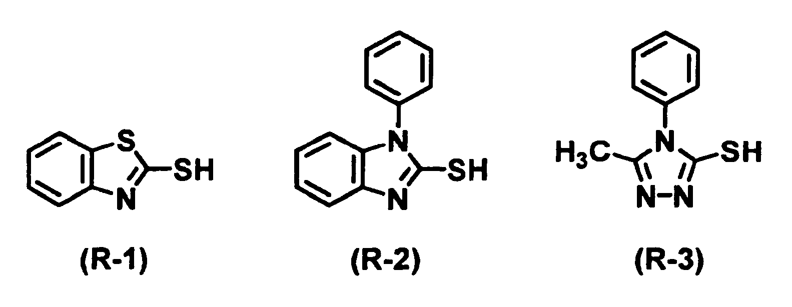

From the results shown in Table 1, it can be seen that each of the lithographic printing plate precursors using the compound having two or more mercapto groups in its molecule according to the invention in the photosensitive layer thereof can achieve the increase in sensitivity in comparison with the cases where the compound having one mercapto group in its molecule, which are outside the scope of the invention, is used as shown in Comparative Examples 1 to 4. On the other hand, in the case where the compound having two or more mercapto groups but not directly connected to a hetero ring in its molecule, which are outside the scope of the invention, was used, the development failure occurred and as a result the image was not formed as shown in Comparative Example 5. As shown in Examples 1 to 16, the improvement in printing durability can also be achieved together with the increase in sensitivity. It is believed that this is achieved not only by the increase in sensitivity but also by the increase in efficiency of gelation and the decrease in penetration of a developer due to the formation of tree-dimensional crosslinkage as described hereinbefore.

### <Examples 17 to 31, Comparative Examples 6 to 12 and Reference Examples 3 to 5 and Reference Examples 1-2>

On the aluminum support used in each of Examples 1 to 18 were successively formed an intermediate layer, a photosensitive layer and a protective layer in the manner shown below to prepare a lithographic printing plate precursor.

### (Coating of intermediate layer)

A coating solution (A) for intermediate layer having the composition shown below was prepared, coated on the surface of the support using a whirler under the condition of 180 rpm so as to have the coating amount of phenylphosphonic acid of 20 mg/m² and dried at 80°C for 30 seconds to prepare an intermediate layer.

### Coating Solution (A) for Intermediate Layer

| | |
|---|---|
| Phenylphosphonic acid | 0.07 to 1.4 g |
| Methanol | 200 g |

### (Formation of photosensitive layer)

A photosensitive composition containing the components shown below was coated on the intermediate layer using a whirler to have a coating amount in a range of 1.2 to 1.4 g/m² and dried at 100°C for 1 minute to form a photosensitive layer.

### Photosensitive Composition

| | |
|---|---|
| Addition-polymerizable compound (compound shown in Table 2) | 2.5 g |
| Binder polymer (compound shown in Table 2) | 2.0 g |
| Sensitizing dye (compound shown in Table 2) | 0.15 g |
| Initiator (compound shown in Table 2) | 0.2 g |
| Compound represented by formula (I) (compound shown in Table 2) | 0.3 g |
| Thermal polymerization inhibitor (N-nitrosophenylhydroxylamine aluminum salt) | 0.01 g |
| Fluorine-based surfactant (Megafac F-780F, produced by Dainippon Ink & Chemicals, Inc.) | 0.02 g |
| Methyl ethyl ketone | 20.0 g |
| Propylene glycol monomethyl ether | 20.0 g |
| Pigment dispersion shown below | 2.0 g |

### Composition of Pigment Dispersion

| | |
|---|---|
| Pigment Blue 15:6 | 15 parts by weight |
| Allyl methacrylate/methacrylic acid copolymer (copolymerization molar ratio: 83/17) | 10 parts by weight |
| Cyclohexanone | 15 parts by weight |
| Methoxypropyl acetate | 20 parts by weight |
| Propylene glycol monomethyl ether | 40 parts by weight |

### (Formation of protective layer)

On the photosensitive layer, an aqueous solution containing 3% by weight of polyvinyl alcohol (saponification degree: 98% by mole; polymerization degree: 550) was coated to have a dry coating weight of 2 g/m² and dried at 100°C for 2 minutes to form a protective layer, thereby preparing a lithographic printing plate precursor. [Evaluation of Sensitivity, Evaluation of Preservation Stability and Evaluation of Printing Durability]

Each of the lithographic printing plate precursors obtained as described above was evaluated in the same manner as described in Example 1. The results obtained are shown in Table 2.

### <Addition-polymerizable compounds shown in Table 2>

(M-1) Addition-polymerizable compound (M-1) containing urethane bonds described above
(M-2) Pentaerythritol tetraacrylate (NK Ester A-TMMT, produced by Shin-Nakamura Chemical Co., Ltd.)
(M-3) Glycerol dimethacrylate hexamethylene diisocyanate urethane prepolymer (UA101H, produced by Kyoeisha Chemical Co., Ltd.)

### <Binder polymers shown in Table 2>

(B-1) Allyl methacrylate/methacrylic acid/N-isopropylacrylamide (copolymerization molar ratio: 68/12/20)
Acid value actually determined by NaOH titration: 1.12 meq/g
Weight average molecular weight determined by GPC measurement: 10 x 10⁴
(U-1) Polyurethane resin of a condensation polymerization product of diisocyanates with diols described above

**TABLE 2**

| | Photosensitive Layer | | | | | Evaluation | | |
|---|---|---|---|---|---|---|---|---|
| | Compound of Formula (I) | Addition-Polymerizable Compound | Binder Polymer | Sensitizing Dye | Initiator | Clear Sensitivity (µJ/cm²) | preservation Stability (X₀ - X₃) | Printing Durability of image Area (Comparative Example 11 being taken as 100) |
| Reference Example 3 | A-2 | M-1 | B-1 | D-1 | o-Cl-HABI | 105 | 3.4 | 110 |
| Reference Example 4 | A-3 | M-2 | B-I | D-I | o-Cl-HABI | 100 | 3.6 | 105 |
| Reference Example 5 | A-13 | M-3 | B-1 | D-1 | O-Cl-HABI | 105 | 3.7 | 105 |
| Example 17 | A-18 | M-1 | B-1 | D-1 | o-Cl-HABI | 75 | 3.5 | 125 |
| Example 18 | A-19 | M-1 | B-1 | D-1 | o-Cl-HABI | 80 | 3.6 | 120 |
| Example 19 | A-26 | M-1 | B-1 | D-1 | o-Cl-HABI | 75 | 3.8 | 125 |
| Example 20 | A-29 | M-1 | B-1 | D-1 | o-Cl-HABI | 60 | 3.6 | 145 |
| Example 21 | A-35 | M-I | U-1 | D-1 | o-Cl-HABI | 60 | 3.7 | 155 |
| Example 22 | A-38 | M-1 | B-1 | D-1 | o-CI-HABI | 60 | 3.7 | 150 |
| Example 23 | A-38 | M-2 | B-1 | D-1 | o-Cl-HABI | 65 | 3.5 | 150 |
| Example 24 | A-38 | M-3 | B-1 | D-1 | o-Cl-HABI | 65 | 3.6 | 145 |
| Example 25 | A-38 | M-1 | U-1 | D-1 | o-Cl-HABI | 60 | 3.6 | 150 |
| Example 26 | A-38 | M-1 | B-1 | D-2 | o-Cl-HABI | 65 | 3.5 | 145 |
| Example 27 | A-38 | M-1 | B-1 | D-3 | o-Cl-HABI | 70 | 3.6 | 140 |
| Example 28 | A-61 | M-1 | B-1 | D-1 | o-Cl-HAHI | 80 | 3.8 | 125 |
| Example 29 | A-69 | M-1 | B-1 | D-1 | o-Cl-HABI | 55 | 3.9 | 150 |
| Example 30 | A-80 | M-1 | B-1 | D-1 | o-Cl-HABI | 85 | 3.7 | 135 |
| Example 31 | A-83 | M-1 | U-1 | D-1 | oCl-HABI | 60 | 3.6 | 130 |
| Comparative Example 6 | - | M-1 | B-1 | D-1 | o-Cl-HABI | 250 | 3.6 | 30 |
| Comparative Example 7 | - | M-1 | B-1 | D-1 | I-1 | 180 | 3.6 | 50 |
| Comparative Example 8 | - | M-1 | B-1 | D-1 | I-2 | 175 | 7.5 | 60 |
| Comparative Example 9 | - | M-1 | B-1 | D-1 | I-3 | 170 | 7.9 | 60 |
| Comparative Example 10 | - | M-1 | B-1 | D-1 | I-4 | Image not formed | Image not formed | Image not formed |
| Comparative Example 11 | R-1 | M-1 | B-1 | D-1 | o-Cl-HABI | 125 | 3.4 | 100 |
| Comparative Example 12 | R-3 | M-1 | B-1 | D-1 | o-Cl-HABI | Fogged image | Fogged image | Fogged image |

The compounds of formula (I) according to the invention used in the photopolymerization initiation system of Table 2 are those described as the specific examples hereinbefore. The structures of the addition-polymerizable compounds, the binder polymers, Sensitizing Dyes (D-1) to (D-3) and the hexaarylbiimidazole compound are same as those shown above, respectively. The structures of Initiators (I-1) to (I-4) used in the comparative examples are shown below. Initiators: 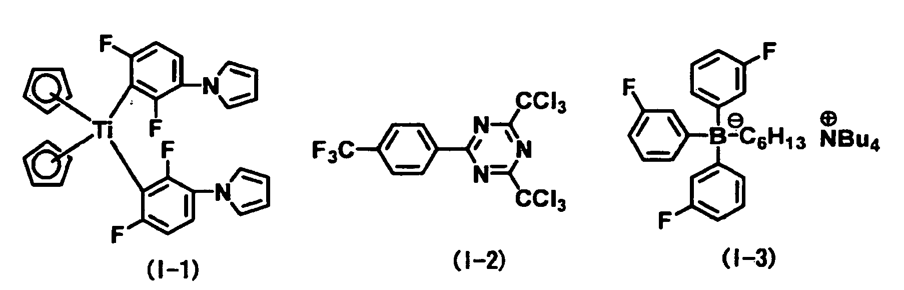 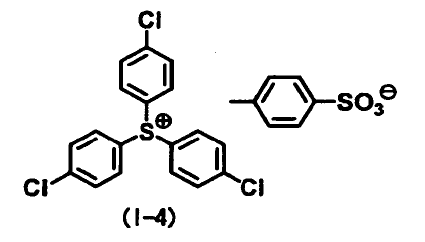 From the results shown in Table 2, it can be seen that each of the lithographic printing plate precursors using the compound having two or more mercapto groups in its molecule according to the invention in the photosensitive layer thereof has high sensitivity and is excellent in the printing durability. On the contrary, in the cases where the comparative compound outside the scope of the invention is used, the image is not formed or the fogged image is formed or the high sensitivity and high printing durability can not be obtained, as shown in Comparative Examples 6 to 12.

### <Examples 32 to 44, Comparative Examples 13 to 15 and Reference Examples 6 to 8>

### (Preparation of support)

A melt of JIS A 1050 alloy containing not less than 99.5% of aluminum, 0.30% of Fe, 0.10% of Si, 0.02% of Ti, and 0.013% of Cu was subjected to a cleaning treatment and casting. The cleaning treatment includes a degassing treatment for removing undesirable gas, for example, hydrogen gas in the melt, and a treatment with a ceramic tube filter. The casting was conducted according to a DC casting method. A surface of the solidified ingot plate having a thickness of 500 mm was ground by 10 mm, and the ingot plate was subjected to a homogenizing treatment at 550°C for 10 hours in order to prevent the formation of coarse intermetallic compound.

Then, the ingot plate was subjected to hot rolling at 400°C, intermediate annealing in a continuous annealing furnace at 500°C for 60 seconds, and cold rolling to produce a rolled aluminum plate having a thickness of 0.30 mm. The center line average surface roughness Ra of the rolled aluminum plate was adjusted to 0.2 µm by means of controlling the roughness of rolling roller. Thereafter, the aluminum plate was subjected to treatment with a tension leveler for improving the flatness thereof.

The aluminum plate was then subjected to surface treatment for preparing a support for lithographic printing plate precursor in the following manner.

First, the aluminum plate was subjected to a degreasing treatment with a 10% aqueous solution of sodium alminate at 50°C for 30 seconds for removing rolling oil on the surface thereof and then neutralization and desmut treatments with a 30% aqueous solution of sulfuric acid at 50°C for 30 seconds.

Then, a so-called graining treatment for roughening a surface of the support was carried out for improving adhesion between the support and the image-recording layer and also imparting a water-retaining property to the non-image area. Specifically, the aluminum web was transported in an aqueous solution containing 1% nitric acid and 0.5% aluminum nitrate, which had been maintained at 45°C, while applying an anode side quantity of electricity of 240C/dm² at a current density of 20 A/dm² and an AC wave-form of a duty ratio of 1 : 1 by means of an indirect electric power supply cell, whereby electrolytic graining was conducted. The aluminum web was then subjected to an etching treatment with a 10% aqueous solution of sodium alminate at 50°C for 30 seconds, and neutralization and desmut treatments with a 30% aqueous solution of sulfuric acid at 50°C for 30 seconds.

For the purpose of further improving abrasion resistance, chemical resistance, and water-retaining property, an oxide film was formed on the surface of support by an anodizing treatment. Specifically, the aluminum web was transported in a 20% aqueous solution of sulfuric acid as an electrolyte at 35°C to carry out an electrolytic treatment with a direct current of 14 A/dm² by means of an indirect electric power supply cell, whereby an anodized film of 2.5 g/m² was formed.

### (Formation of image-recording layer)

A coating solution for image-recording layer having the composition shown below was prepared, coated on the aluminum support prepared above using a wire bar and dried at 115°C for 45 seconds by a hot air drying apparatus to form an image-recording layer. The coverage of the image-recording layer after drying was in a range of 1.2 to 1.3 g/m².

Then, a coating solution for overcoat layer having the composition shown below was coated using a slide hopper and dried at 120°C for 75 seconds by a hot air drying apparatus, whereby each of the lithographic printing plate precursors for the examples and comparative examples was prepared. The coating amount of the overcoat layer was 2.3 g/m².

### (Coating solution for image-recording layer)

| | |
|---|---|
| Compound having at least one addition-polymerizable ethylenically unsaturated bond (A-BPE-4, produced by Shin-Nakamura Chemical Co., Ltd.) | 2.0 g |
| Binder polymer (B-2) shown below | 2.0 g |
| Infrared absorbing agent (IR-1) shown below | 0.15 g |
| Hexaarylbiimidazole compound (o-Cl-HABI) | 0.20 g |
| Compound represented by formula (I) (compound shown in Table 3) | 0.30 g |
| Fluorine-based surfactant (Megafac F-177, produced by Dainippon Ink & Chemicals, Inc.) | 0.01 g |
| Methyl ethyl ketone | 9.0 g |
| Propylene glycol monomethyl ether | 8.0 g |
| Methanol | 10.0 g |

### Binder Polymer (B-2):

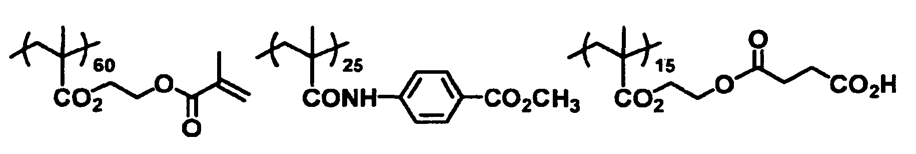

### Infrared absorbing agent (IR-1):

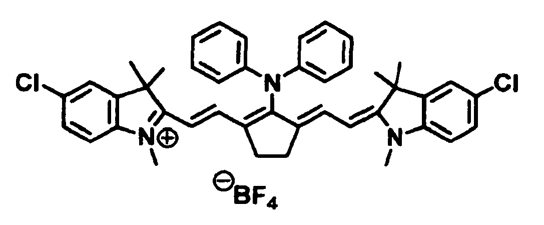

### (Coating solution for overcoat layer)

| | |
|---|---|
| Polyvinyl alcohol (saponification degree: 98.5% by mole; polymerization degree: 500) | 2.5 g |
| Polyvinyl pyrrolidone (K30, produced by Tokyo Chemical Industry Co., Ltd., molecular weight: 4 x 10⁴) | 0.5 g |
| Nonionic surfactant (Emalex NP-10, produced by Nihon-Emulsion Co., Ltd.) | 0.05 g |
| Ion-exchanged water | 96.95 g |

The compounds represented by formula (I) used in each of the examples are those described hereinbefore as the specific examples of the compound according to the invention. Comparative Compounds (R-1) to (R-3) having the structure shown above used in the comparative examples are compounds outside the scope of the invention.

### (Exposure and Development Processing)

Each of the negative-working lithographic printing plate precursors obtained was subjected to exposure and development processing to prepare a lithographic printing plate. The exposure and development processing were conducted in the following manner. (Exposure)

The negative-working lithographic printing plate precursor was exposed using Trendsetter 3244VFS loaded with 40 W water-cooling infrared semiconductor laser under conditions of output of 9 W, external surface drum rotation number of 210 rpm and resolution of 2,400 dpi.

### (Development Processing)

After the exposure, the lithographic printing plate precursor was subjected to development processing (for 12 seconds) using an automatic developing machine (Stablon 900N produced by Fuji Photo Film Co., Ltd.). As the developer, a solution obtained by 1:4 dilution of DV-2 produced by Fuji Photo Film Co., Ltd. with water was used for both a tank solution and replenisher. The temperature of the developer was 30°C. As the finisher, a solution (pH = 10.8) obtained by 1:1 dilution of FN-6 produced by Fuji Photo Film Co., Ltd. with water was used.

### [Evaluation of Sensitivity]

An energy amount necessary for the image-recording was determined based on the line width of the image obtained by the above-described exposure (with infrared laser having a wavelength of approximately from 830 to 850 nm) and development, laser output, loss in the optical system and scanning speed. As the numeral is smaller, the sensitivity is higher. The results obtained are also shown in Table 3.

### [Evaluation of Preservation Stability]

Each of the lithographic printing plate precursors before the laser exposure was allowed to stand under high temperature and high humidity conditions (45°C and 75% relative humidity) for 3 days, and then subjected to the laser exposure and development processing in the same manner as above. The amount of energy necessary for the image-recording was determined and an energy ratio between before and after the preservation under high temperature and high humidity conditions (energy amount after the preservation under high temperature and high humidity conditions /energy amount before the preservation under high temperature and high humidity conditions) was obtained. The energy amount ratio of not more than 1.1 is preferable in the production and denotes excellent preservation stability. The results obtained are also shown in Table 3.

**TABLE 3**

| | Compound of Formula (I) | Sensitivity (mJ/cm²) | Preservation Stability (ratio) |
|---|---|---|---|
| Reference Example 6 | A-9 | 115 | 1.1 |
| Reference Example 7 | A-10 | 110 | 1.1 |
| Reference Example 8 | A-12 | 105 | 1.1 |
| Example 32 | A-15 | 110 | 1.0 |
| Example 33 | A-24 | 90 | 1.0 |
| Example 34 | A-28 | 70 | 1.1 |
| Example 35 | A-37 | 75 | 1.0 |
| Example 36 | A-41 | 70 | 1.1 |
| Example 37 | A-50 | 60 | 1.1 |
| Example 38 | A-56 | 60 | 1.1 |
| Example 39 | A-57 | 55 | 1.0 |
| Example 40 | A-62 | 90 | 1.0 |
| Example 41 | A-72 | 60 | 1.0 |
| Example 42 | A-76 | 90 | 1.0 |
| Example 43 | A-78 | 70 | 1.1 |
| Example 44 | A-84 | 100 | 1.0 |
| Comparative Example 13 | R-1 | 150 | 1.1 |
| Comparative Example 14 | R-2 | 145 | 1.1 |
| Comparative Example 15 | R-3 | 140 | 1.0 |

From the results shown in Table 3, it can be seen that each of the lithographic printing plate precursors using the compound having two or more mercapto groups in its molecule according to the invention in the photosensitive layer thereof has high sensitivity and is excellent in the printing durability. On the contrary, in the cases where the comparative compound outside the scope of the invention is used, the high sensitivity and high printing durability can not be obtained, as shown in Comparative Examples 13 to 15.

## Claims

1. A photosensitive composition comprising:
a compound having two or more mercapto groups directly connected to a hetero ring represented by L-(A-(SH)_{q})ᵣ (formula(I)), wherein A represents a heterocyclic group which may have a substituent, r represents an integer of 2 or more, L represents an r-valent connecting group, and q represents an integer of 1 or more;
a hexaarylbiimidazole compound;
a sensitizing dye; and
a polymerisable compound having an ethylenically unsaturated double bond.

2. A photosensitive composition according to Claim 1, wherein the compound having two or more mercapto groups directly connected to a hetero ring is a compound represented by the following formula (II) or (II'): 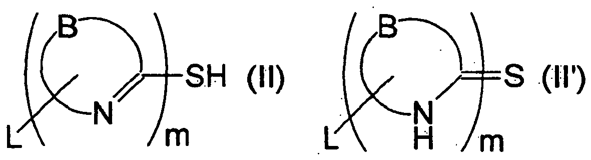 wherein B represents a group necessary for forming a hetero ring together with the nitrogen atom, m represents an integer of 2 or more, and L represents an m-valent connecting group.

3. A photosensitive composition according to Claim 2, wherein the ring formed by B in formulae (II) or (II') is a triazole ring, an oxadiazole ring, a thiadiazole ring, a benzimidazole ring, a benzoxazole ring, a benzthiazole ring or a tetrazole ring.

4. A photosensitive composition according to Claim 1, wherein a content of the compound having two or more mercapto groups directly connected to a hetero ring is 0.01 to 50% by weight, based on a total solid content of the photosensitive composition.

5. A photosensitive composition according to Claim 1, wherein r in the formula (I) represents an integer of 3 to 6.

6. A photosensitive composition according to Claim 1, wherein the compound having two or more mercapto groups directly connected to a hetero ring has 2 to 6 mercapto groups directly connected to a hetero ring.

7. An image-recording method comprising conducting scanning exposure to an image-recording material including a photosensitive layer containing the photosensitive composition according to Claim 1 with a laser light source of 350 to 430 nm.

8. A lithographic printing plate precursor comprising a support and a photosensitive layer containing the photosensitive composition according to Claim 1.

9. A lithographic printing plate precursor according to Claim 8, wherein the sensitizing dye is an infrared absorbing agent.

## Patentansprüche

1. Fotoempfindliche Zusammensetzung, umfassend:
eine Verbindung mit zwei oder mehr Mercaptogruppen, die direkt mit einem durch L-(A-(SH)_{q})ᵣ (Formel (I)) dargestellten Heteroring verbunden sind, worin A eine heterocyclische Gruppe darstellt, die einen Substituenten aufweisen kann, r eine ganze Zahl von 2 oder mehr darstellt, L eine r-wertige Verbindungsgruppe darstellt und q eine ganze Zahl von 1 oder mehr darstellt;
eine Hexaarylbiimidazolverbindung;
einen Sensibilisierungsfarbstoff; und
eine polymerisierbare Verbindung mit einer ethylenisch ungesättigten Doppelbindung.

2. Fotoempfindliche Zusammensetzung gemäss Anspruch 1, wobei die Verbindung mit zwei oder mehr Mercaptogruppen, die direkt mit dem Heteroring verbunden sind, eine Verbindung der nachstehenden Formel (II) oder (II') ist: 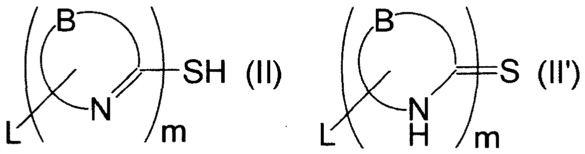 worin B eine Gruppe darstellt, die zur Bildung eines Heterorings zusammen mit dem Stickstoffatom erforderlich ist, m eine ganze Zahl von 2 oder mehr darstellt und L eine m-wertige Verbindungsgruppe darstellt.

3. Fotoempfindliche Zusammensetzung gemäss Anspruch 2, wobei der in Formel (II) oder (II') durch B gebildete Ring ein Triazolring, ein Oxadiazolring, ein Thiadiazolring, ein Benzimidazolring, ein Benzoxazolring, ein Benzthiazolring oder ein Tetrazolring ist.

4. Fotoempfindliche Zusammensetzung gemäss Anspruch 1, wobei der Gehalt der Verbindung mit zwei oder mehr Mercaptogruppen, die direkt mit dem Heteroring verbunden sind, 0,01 bis 50 Gew.%, bezogen auf den Gesamtfeststoffgehalt der fotoempfindlichen Zusammensetzung, beträgt.

5. Fotoempfindliche Zusammensetzung gemäss Anspruch 1, worin r in Formel (I) eine ganze Zahl von 3 bis 6 darstellt.

6. Fotoempfindliche Zusammensetzung gemäss Anspruch 1, wobei die Verbindung mit zwei oder mehr Mercaptogruppen, die direkt mit dem Heteroring verbunden sind, 2 bis 6 direkt mit dem Heteroring verbundene Mercaptogruppen aufweist.

7. Bildaufzeichnungsverfahren, umfassend die Durchführung einer Rasterbelichtung eines Bildaufzeichnungsmaterials, das eine fotoempfindliche Schicht aufweist, die die fotoempfindliche Zusammensetzung gemäss Anspruch 1 umfasst, mit einer Laserlichtquelle von 350 bis 430 nm.

8. Lithografie-Druckplattenvorläufer, umfassend einen Träger und eine fotoempfindliche Schicht, die die fotoempfindliche Zusammensetzung gemäss Anspruch 1 enthält.

9. Lithografie-Druckplattenvorläufer gemäss Anspruch 8, wobei der Sensibilisierungsfarbstoff ein Infrarot-Absorptionsmittel ist.

## Revendications

1. Composition photosensible comprenant :
un composé ayant deux groupes mercapto ou plus directement liés à un hétérocycle représenté par L-(A-(SH)_{q})ᵣ (formule (I)), dans laquelle A représente un groupe hétérocyclique qui peut avoir un substituant, r représente un entier de 2 ou plus, L représente un groupe de liaison r-valent, et q représente un entier de 1 ou plus ;
un composé hexaarylbiimidazole ;
un colorant de sensibilisation ; et
un composé polymérisable ayant une liaison double éthyléniquement insaturée.

2. Composition photosensible selon la revendication 1, dans laquelle le composé ayant deux groupes mercapto ou plus directement liés à un hétérocycle est un composé représenté par la formule (II) ou (II') suivante : 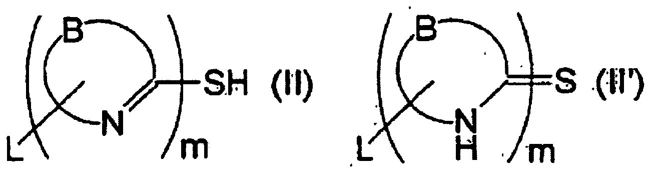 dans lesquelles B représente un groupe nécessaire pour former un hétérocycle avec l'atome d'azote, m représente un entier de 2 ou plus, et L représente un groupe de liaison m-valent.

3. Composition photosensible selon la revendication 2, dans laquelle le cycle formé par B dans les formules (II) ou (II') est un cycle triazole, un cycle oxadiazole, un cycle thiadiazole, un cycle benzimidazole, un cycle benzoxazole, un cycle benzthiazole ou un cycle tétrazole.

4. Composition photosensible selon la revendication 1, dans laquelle une teneur du composé ayant deux groupes mercapto ou plus directement liés à un hétérocycle est 0,01 à 50% en poids, sur la base d'une teneur totale en solides de la composition photosensible.

5. Composition photosensible selon la revendication 1, dans laquelle r dans la formule (I) représente un entier de 3 à 6.

6. Composition photosensible selon la revendication 1, dans laquelle le composé ayant deux groupes mercapto ou plus directement liés à un hétérocycle a 2 à 6 groupes mercapto directement liés à un hétérocycle.

7. Procédé d'enregistrement d'image comprenant la conduite d'une exposition par balayage sur un matériau d'enregistrement d'image incluant une couche photosensible contenant la composition photosensible selon la revendication 1 avec une source de lumière laser de 350 à 430 nm.

8. Précurseur de plaque d'impression lithographique comprenant un support et une couche photosensible contenant la composition photosensible selon la revendication 1.

9. Précurseur de plaque d'impression lithographique selon la revendication 8, dans lequel le colorant de sensibilisation est un agent absorbant les infrarouges.
